(19) Europäisches Patentamt
European Patent Office
Office européen des brevets

(11) EP 4 310 157 A1

(12) **EUROPEAN PATENT APPLICATION**
published in accordance with Art. 153(4) EPC

(43) Date of publication:
**24.01.2024 Bulletin 2024/04**

(21) Application number: **22780455.6**

(22) Date of filing: **24.03.2022**

(51) International Patent Classification (IPC):
***C09K 3/00*** *(2006.01)* ***H01L 21/02*** *(2006.01)*
***H01L 21/304*** *(2006.01)* ***C09J 7/35*** *(2018.01)*
***B32B 7/06*** *(2019.01)*

(52) Cooperative Patent Classification (CPC):
**B32B 7/06; C09J 7/35; C09K 3/00; H01L 21/02; H01L 21/304**

(86) International application number:
**PCT/JP2022/013867**

(87) International publication number:
**WO 2022/210241 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2021 JP 2021061649**

(71) Applicant: **Nissan Chemical Corporation**
**Tokyo 103-6119 (JP)**

(72) Inventors:
- **MORIYA Shunsuke**
  **Toyama-shi, Toyama 939-2792 (JP)**
- **OKUNO Takahisa**
  **Toyama-shi, Toyama 939-2792 (JP)**

(74) Representative: **Hoffmann Eitle**
**Patent- und Rechtsanwälte PartmbB**
**Arabellastraße 30**
**81925 München (DE)**

# (54) LAMINATE, RELEASE AGENT COMPOSITION, AND METHOD FOR MANUFACTURING MACHINED SEMICONDUCTOR SUBSTRATE

(57) A laminate contains: a semiconductor substrate; a light-transmissive support substrate; and an adhesive layer and a release layer that are provided between the semiconductor substrate and the support substrate, in which the release layer absorbs light emitted from a side of the support substrate and then is used for release the semiconductor substrate and the support substrate, the release layer is a layer formed of a release agent composition, and the release agent composition contains a compound having: a first structure that is a structure for absorbing the light, contributes to easy release of the semiconductor substrate and the support substrate by absorbing the light, and has two or more aromatic rings constituting a $\pi$-electron conjugated system; and a siloxane structure as a second structure.

Fig. 1

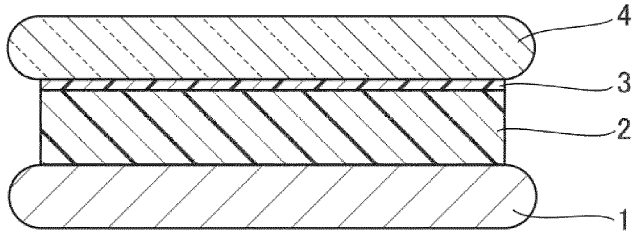




Processed by Luminess, 75001 PARIS (FR)

## Description

### Technical Field

The present invention relates to a laminate, a release agent composition, and a method for manufacturing a processed semiconductor substrate.

### Background Art

For a semiconductor wafer that has been integrated in a two-dimensional planar direction in the related art, there is a demand for a semiconductor integration technique that integrates (laminates) planes in a three-dimensional direction for the purpose of further integration. The three-dimensional lamination is a technique of laminating layers into a multi-layer while connecting the layers by a through-silicon via (TSV). At the time of multi-layer lamination, each of wafers to be integrated is thinned by polishing on a side opposite to the formed circuit surface (that is, a rear surface), and the thinned semiconductor wafers are laminated.

In order to polish a semiconductor wafer before thinning (also simply referred to herein as a "wafer") with a polishing device, the semiconductor wafer adheres to a support. The adhesion at that time is referred to as temporary adhesion because it should be easily released after polishing. This temporary adhesion should be easily removed from the support, and the thinned semiconductor wafer may be cut or deformed when a large force is applied for removal. Therefore, the semiconductor wafer is easily removed so that such a situation does not occur. However, at the time of polishing the rear surface of the semiconductor wafer, it is not preferable that the semiconductor wafer is detached or displaced due to a polishing stress. Therefore, the performance required for the temporary adhesion is to withstand the stress during polishing and to be easily removed after polishing.

For example, there is a demand for performance having a high stress (strong adhesive force) in a planar direction at the time of polishing and a low stress (weak adhesive force) in a longitudinal direction at the time of removal.

Although methods by laser irradiation have been disclosed for such adhesion and separation processes (see, for example, Patent Literatures 1 and 2), in accordance with recent further progress in the semiconductor field, a new technique related to release by irradiation with light such as a laser is always required.

### Citation List

### Patent Literature

Patent Literature 1: JP 2004-64040 A
Patent Literature 2: JP 2012-106486 A

### Summary of Invention

### Technical Problem

In addition, in the technique described in Patent Literature 2, it is not easy to dissolve a separation layer after light irradiation with a cleaning agent composition when the semiconductor substrate is cleaned.

The present invention has been made in view of the circumstances described above, and an object of the present invention is to provide a laminate that can implement easy separation when a support substrate and a semiconductor substrate are separated and can dissolve a release layer after light irradiation with a cleaning agent composition when the semiconductor substrate is cleaned, a release agent composition that provides a preferred film as such a release layer, and a method for manufacturing a processed semiconductor substrate using such a laminate.

### Solution to Problem

As a result of intensive studies to solve the above problems, the present inventors have found that the above problems can be solved, thereby completing the present invention having the following gist.

That is, the present invention encompasses the following.

[1] A laminate including:

a semiconductor substrate;

a light-transmissive support substrate; and

an adhesive layer and a release layer that are provided between the semiconductor substrate and the support substrate,

in which the release layer absorbs light emitted from a side of the support substrate and then is used for release the semiconductor substrate and the support substrate,

the release layer is a layer formed of a release agent composition, and

the release agent composition contains a compound having: a first structure that is a structure for absorbing the light, contributes to easy release of the semiconductor substrate and the support substrate by absorbing the light, and has two or more aromatic rings constituting a $\pi$-electron conjugated system; and a siloxane structure as a second structure.

[2] The laminate according to [1], in which the first structure has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure.
[3] The laminate according to [1] or [2], in which the first structure is a structure represented by any one of the following Formulas (1) to (7).

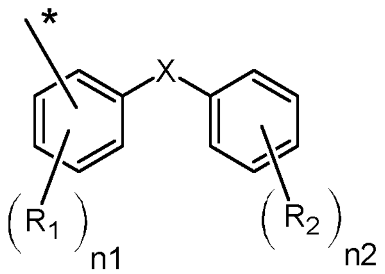

(1)

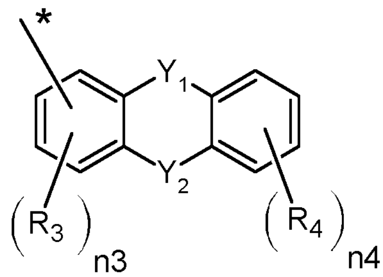

(2)

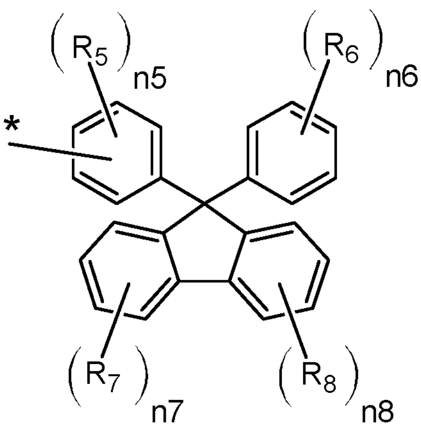

(3)

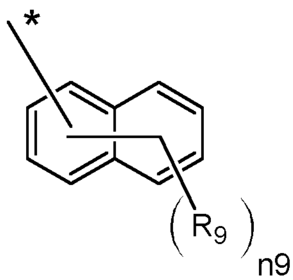

(4)

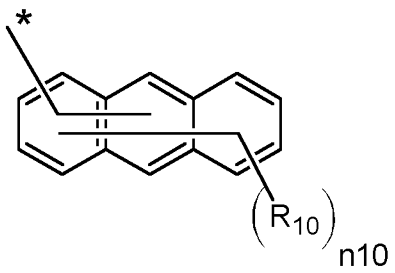

(5)

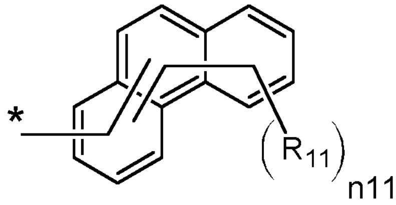

(6)

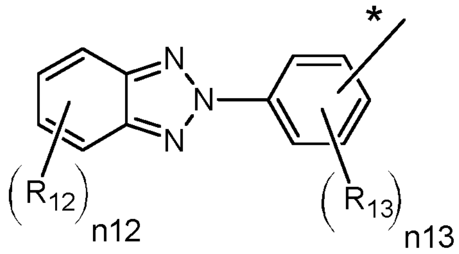

(7)

(In Formulas (1) to (7), $R_1$ to $R_{13}$ each independently represent a halogen atom or a monovalent group.

X represents a single bond, -O-, -CO-, $-NR_{31}-$ ($R_{31}$ represents a hydrogen atom, an alkyl group which may be substituted, or an aryl group which may be substituted), - SO-, $-SO_2-$, or -N=N-.
$Y_1$ represents a single bond or -CO-, and when $Y_1$ is a single bond, $Y_2$ represents -O-, -CO-, or $-NR_{32}-$ ($R_{32}$ represents a hydrogen atom, an alkyl group which may be substituted, or an aryl group which may be substituted.)
When $Y_1$ is -CO-, $Y_2$ represents -CO-.
n1 is an integer of 0 to 4.
n2 is an integer of 0 to 5.
n3 is an integer of 0 to 3.
n4 is an integer of 0 to 4.
n5 is an integer of 0 to 4.
n6 is an integer of 0 to 5.
n7 is an integer of 0 to 4.
n8 is an integer of 0 to 4.
n9 is an integer of 0 to 7.
n10 is an integer of 0 to 9.
n11 is an integer of 0 to 9.
n12 is an integer of 0 to 4.
n13 is an integer of 0 to 4.
* represents a bond.
When there are a plurality of $R_1$s to $R_{13}$s, the plurality of $R_1$s to $R_{13}$s may be the same as or different from each other.)

[4] The laminate according to any one of [1] to [3], in which the first structure contains at least one hydroxy group.
[5] The laminate according to any one of [1] to [4], in which the second structure contains at least one selected from the group consisting of a siloxane unit (Q unit) represented by $SiO_2$, a siloxane unit (M unit) represented by $R_{101}R_{102}R_{103}SiO_{1/2}$, a siloxane unit (D unit) represented by $R_{104}R_{105}SiO_{2/2}$, and a siloxane unit (T unit) represented by $R_{106}SiO_{3/2}$ ($R_{101}$ to $R_{106}$ each independently represent a hydrogen atom or monovalent group bonded to Si, or a single bond or linking group that binds Si and the first structure).
[6] The laminate according to [5], in which the first structure is bonded to Si of any one of the M unit, the D unit, and the T unit via a single bond or a linking group.
[7] The laminate according to [6], in which the first structure is bonded to Si of any one of the M unit, the D unit, and the T unit via a linking group, and

the linking group is selected from the group consisting of an alkylene group having 1 to 10 carbon atoms, an ester bond, an ether bond, an amide bond, a urethane bond, a urea bond, and a combination of two or more thereof.
[8] The laminate according to any one of [1] to [7], in which the adhesive layer is a layer formed of an adhesive composition containing a compound having a siloxane structure.
[9] The laminate according to [8], in which the adhesive composition contains a component (A) which is cured.
[10] The laminate according to [9], in which the component (A) is a component which is cured by a hydrosilylation reaction.
[11] The laminate according to [9] or [10], in which the component (A) contains:

a polyorganosiloxane (a1) containing an alkenyl group having 2 to 40 carbon atoms bonded to silicon atoms;
a polyorganosiloxane (a2) containing a Si-H group; and
a platinum group metal-based catalyst (A2).

[12] A release agent composition for forming a release layer of a laminate including a semiconductor substrate, a support substrate, and an adhesive layer and a release layer that are provided between the semiconductor substrate and the support substrate, the release agent composition being used for release the semiconductor substrate and the support substrate after the release layer absorbs light emitted from a side of the support substrate,
the release agent composition containing a compound having: a first structure that is a structure that absorbs the light, contributes to easy release of the semiconductor substrate and the support substrate by absorbing the light, and has two or more aromatic rings constituting a $\pi$-electron conjugated system; and a siloxane structure as a second structure.
[13] The release agent composition according to [12], in which the first structure has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure.
[14] A release agent composition containing a compound having a first structure including a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure, and a siloxane structure as a second structure.
[15] The release agent composition according to any one of [12] to [14], in which the first structure is a structure represented by any one of the following Formulas (1) to (7).

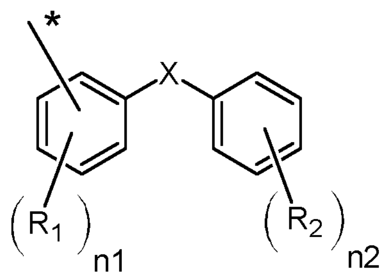

(1)

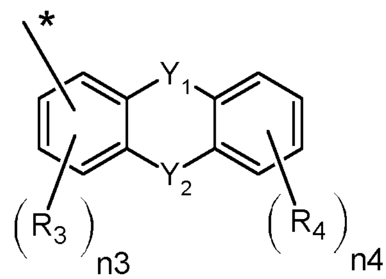

(2)

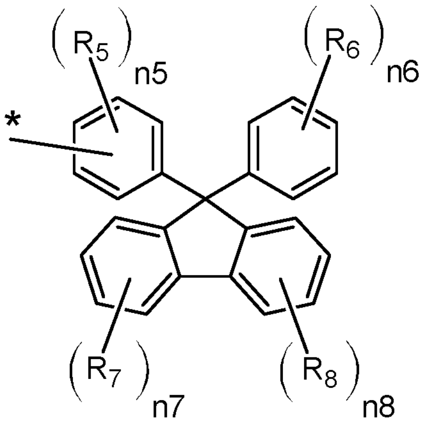

(3)

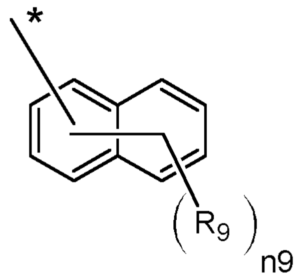

(4)

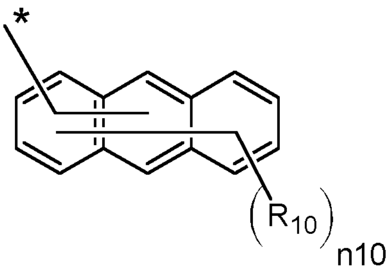

(5)

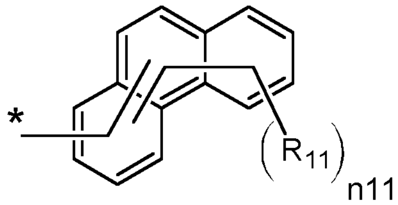

(6)

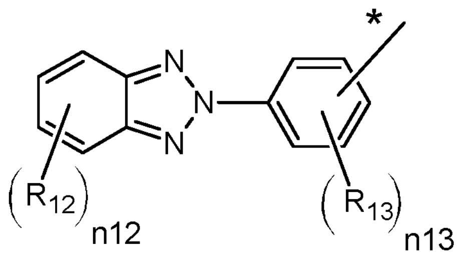

(7)

(In Formulas (1) to (7), $R_1$ to $R_{13}$ each independently represent a halogen atom or a monovalent group.

X represents a single bond, -O-, -CO-, -$NR_{31}$- ($R_{31}$ represents a hydrogen atom, an alkyl group which may be substituted, or an aryl group which may be substituted), - SO-, -$SO_2$-, or -N=N-.
$Y_1$ represents a single bond or -CO-, and when $Y_1$ is a single bond, $Y_2$ represents -O-, -CO-, or -$NR_{32}$- ($R_{32}$ represents a hydrogen atom, an alkyl group which may be substituted, or an aryl group which may be substituted.)
When $Y_1$ is -CO-, $Y_2$ represents -CO-.
n1 is an integer of 0 to 4.
n2 is an integer of 0 to 5.
n3 is an integer of 0 to 3.
n4 is an integer of 0 to 4.
n5 is an integer of 0 to 4.
n6 is an integer of 0 to 5.
n7 is an integer of 0 to 4.
n8 is an integer of 0 to 4.
n9 is an integer of 0 to 7.
n10 is an integer of 0 to 9.

n11 is an integer of 0 to 9.
n12 is an integer of 0 to 4.
n13 is an integer of 0 to 4.
* represents a bond.
When there are a plurality of $R_1$s to $R_{13}$s, the plurality of $R_1$s to $R_{13}$s may be the same as or different from each other.)

[16] The release agent composition according to any one of [12] to [15], in which the first structure contains at least one hydroxy group.
[17] The release agent composition according to any one of [12] to [16], in which the second structure contains at least one selected from the group consisting of a siloxane unit (Q unit) represented by $SiO_2$, a siloxane unit (M unit) represented by $R_{101}R_{102}R_{103}SiO_{1/2}$, a siloxane unit (D unit) represented by $R_{104}R_{105}SiO_{2/2}$, and a siloxane unit (T unit) represented by $R_{106}SiO_{3/2}$ ($R_{101}$ to $R_{106}$ each independently represent a hydrogen atom or monovalent group bonded to Si, or a single bond or linking group that binds Si and the first structure).
[18] The release agent composition according to [17], in which the second structure is bonded to Si of any one of the M unit, the D unit, and the T unit via a single bond or a linking group.
[19] The release agent composition according to [18], in which the second structure is bonded to Si of any one of the M unit, the D unit, and the T unit via a linking group, and
the linking group is selected from the group consisting of an alkylene group having 1 to 10 carbon atoms, an ester bond, an ether bond, an amide bond, a urethane bond, a urea bond, and a combination of two or more thereof.
[20] A method for manufacturing a processed semiconductor substrate, the method including:

a first step of processing the semiconductor substrate of the laminate according to any one of [1] to [11];
a second step of separating the semiconductor substrate processed in the first step and the support substrate; and
a third step of cleaning the separated semiconductor substrate with a cleaning agent composition.

[21] The method for manufacturing a processed semiconductor substrate according to [20], in which the second step includes a step of irradiating the release layer with light.
[22] The method for manufacturing a processed semiconductor substrate according to [20] or [21], in which the cleaning agent composition is a cleaning agent composition containing a quaternary ammonium salt and a solvent.
[23] The method for manufacturing a processed semiconductor substrate according to [22], in which the quaternary ammonium salt is a halogen-containing quaternary ammonium salt.
[24] The method for manufacturing a processed semiconductor substrate according to [23], in which the halogen-containing quaternary ammonium salt is a fluorine-containing quaternary ammonium salt.

Advantageous Effects of Invention

According to the present invention, it is possible to provide a laminate that can implement easy separation when a support substrate and a semiconductor substrate are separated and can dissolve a release layer after light irradiation with a cleaning agent composition when the semiconductor substrate is cleaned, a release agent composition that provides a preferred film as such a release layer, and a method for manufacturing a processed semiconductor substrate using such a laminate.

Brief Description of Drawings

Fig. 1 is a schematic cross-sectional view of an example of a laminate.

Mode for Carrying Out the Invention

(Laminate)

A laminate of the present invention includes a semiconductor substrate, a support substrate, an adhesive layer, and a release layer.
The support substrate has light transmitability.
The adhesive layer and the release layer are provided between the semiconductor substrate and the support substrate.
In the laminate, the release layer absorbs light emitted from a side of the support substrate and then is used

for release the semiconductor substrate and the support substrate.

The release layer is a layer formed of a release agent composition.

The release agent composition contains a compound having a first structure and a second structure. The first structure is a structure for absorbing light and contributes to easy release of the semiconductor substrate and the support substrate by absorbing light. The second structure is a siloxane structure.

The laminate of the present invention can be preferably used for processing such as thinning of a semiconductor substrate.

In the laminate of the present invention, the semiconductor substrate is supported on the support substrate via the adhesive layer and the release layer while the semiconductor substrate is subjected to processing such as thinning.

On the other hand, since the compound contained in the release agent composition for forming the release layer has the first structure, in the release layer formed of the release agent composition, the first structure absorbs light (for example, laser light) to alter (for example, separate or decompose) the release layer. As a result, after the release layer is irradiated with light, the semiconductor substrate and the support substrate are easily released. Furthermore, the compound contained in the release agent composition for forming the release layer has the second structure, such that the release layer after light irradiation becomes soluble in a cleaning agent composition described below. When the release layer after light irradiation is soluble in the cleaning agent composition, for example, even when a residue of the release layer remains on the semiconductor substrate when the support substrate and the semiconductor substrate are separated, the residue can be easily removed by cleaning with the cleaning agent composition.

A wavelength of the light used for release is not particularly limited as long as light is absorbed by the first structure, but light having a wavelength of 100 to 600 nm is usually used, and a preferred wavelength is, for example, 308 nm, 343 nm, 355 nm, or 365 nm. An irradiation dose of light required for release is an irradiation dose that can cause preferred alternation of the first structure, for example, decomposition.

The light used for release may be laser light or non-laser light emitted from a light source such as a lamp.

<Semiconductor Substrate>

A main material constituting the entire semiconductor substrate is not particularly limited as long as it is used for this type of application, and examples thereof include silicon, silicon carbide, and a compound semiconductor.

A shape of the semiconductor substrate is not particularly limited, and examples thereof include a disk shape. Note that the disk-shaped semiconductor substrate does not need to have a completely circular surface shape, and for example, an outer periphery of the semiconductor substrate may have a straight portion called an orientation flat or may have a cut called a notch.

A thickness of the disk-shaped semiconductor substrate may be appropriately determined according to a purpose of use of the semiconductor substrate and the like, and is not particularly limited, but is, for example, 500 to 1,000 um.

A diameter of the disk-shaped semiconductor substrate may be appropriately determined according to a purpose of use of the semiconductor substrate and the like, and is not particularly limited, but is, for example, 100 to 1,000 mm.

The semiconductor substrate may have bumps. The bump is a protruding terminal.

In the laminate, in a case where the semiconductor substrate has bumps, the semiconductor substrate has bumps on the support substrate.

In the semiconductor substrate, the bump is usually formed on a surface on which a circuit is formed. The circuit may be a single layer or may be a multi-layer. A shape of the circuit is not particularly limited.

In the semiconductor substrate, a surface opposite to a surface having the bump (rear surface) is a surface to be processed.

The material, size, shape, structure, and density of the bumps of the semiconductor substrate are not particularly limited.

Examples of the bump include a ball bump, a print bump, a stud bump, and a plating bump.

Usually, a height, radius, and pitch of the bump are appropriately determined from conditions of a bump height of about 1 to 200 $\mu$m, a bump radius of 1 to 200 um, and a bump pitch of 1 to 500 um.

Examples of the material of the bump include a solder having a low melting point, a solder having a high melting point, tin, indium, gold, silver, and copper. The bump may be formed of only a single component or may be formed of a plurality of components. More specific examples thereof include alloy plating mainly containing Sn, such as SnAg bumps, SnBi bumps, Sn bumps, or AuSn bumps.

In addition, the bump may have a laminated structure including a metal layer containing at least one of these components.

An example of the semiconductor substrate is a silicon wafer having a diameter of 300 mm and a thickness of about 770 $\mu$m.

<Support Substrate>

The support substrate is not particularly limited as long as it is a member that is transparent to light irradiated to the release layer and can support the semiconductor substrate when the semiconductor substrate is processed, and examples thereof include a glass support substrate.
A shape of the support substrate is not particularly limited, and examples thereof include a disk shape.
A thickness of the disk-shaped support substrate may be appropriately determined according to a size of the semiconductor substrate and the like, and is not particularly limited, but is, for example, 500 to 1,000 um.
A diameter of the disk-shaped support substrate may be appropriately determined according to the size of the semiconductor substrate and the like, and is not particularly limited, but is, for example, 100 to 1,000 mm.
An example of the support substrate is a glass wafer having a diameter of 300 mm and a thickness of about 700 μm.

<Release Layer>

The release layer is a layer formed of a release agent composition.
The release layer is provided between the semiconductor substrate and the support substrate.
The release layer may be in contact with the support substrate or may be in contact with the semiconductor substrate.
A method for forming the release layer using the release agent composition is not particularly limited, and examples thereof include a formation method described below.

<<Release Agent Compositions

The release agent composition contains at least compound having a first structure and a second structure (hereinafter, may be referred to as a "specific compound"), and further contains other components such as a crosslinking agent, an acid generator, an acid, a surfactant, and a solvent as necessary.

<<<Compound Having First Structure and Second Structure>>>

The specific compound contained in the release agent composition has a first structure and a second structure.
The first structure is a structure for absorbing light and contributes to easy release of the semiconductor substrate and the support substrate by absorbing light.
The second structure is a siloxane structure.

-First Structure-

The first structure is a structure for absorbing light and contributes to easy release of the semiconductor substrate and the support substrate by absorbing light.
The first structure absorbs light and then is altered to alter the release layer. As a result, after the release layer is irradiated with light, the semiconductor substrate and the support substrate are easily released.
The first structure contains, for example, two or more aromatic rings constituting a n-electron conjugated system. Two or more aromatic rings may constitute a condensed ring. The condensed ring refers to a ring in which two or more rings are integrated in a form in which two (sometimes two or more) atoms are shared. Each aromatic ring contained in the condensed ring may be an aromatic hydrocarbon ring or a heteroaromatic ring. Examples of the aromatic hydrocarbon ring include a benzene ring. Examples of the heteroaromatic ring include a furan ring, a thiophene ring, a pyrrole ring, a pyrazole ring, an imidazole ring, a pyridine ring, a pyridazine ring, a pyrimidine ring, and a pyrazine ring.
The first structure preferably has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure from the viewpoint of realizing excellent releasability between the semiconductor substrate and the support substrate due to excellent light absorption.
The first structure may have a substituent. Examples of the substituent in the first structure include an alkyl group, an alkoxy group, an aryl group, a halogen atom, a hydroxy group, a nitro group, a cyano group, an amide group, a sulfonamide group, an imide group, a carboxy group, a carboxylic acid ester group, a sulfo group, a sulfonic acid ester group, an alkylamino group, and an arylamino group.
The first structure is preferably a structure represented by any one of the following Formulas (1) to (7) from the

viewpoint of realizing excellent releasability between the semiconductor substrate and the support substrate due to excellent light absorption.

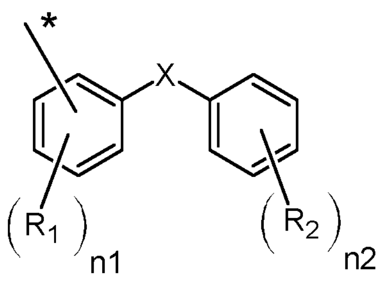

(1)

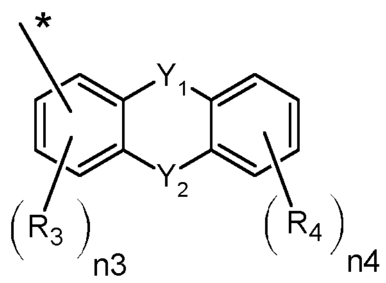

(2)

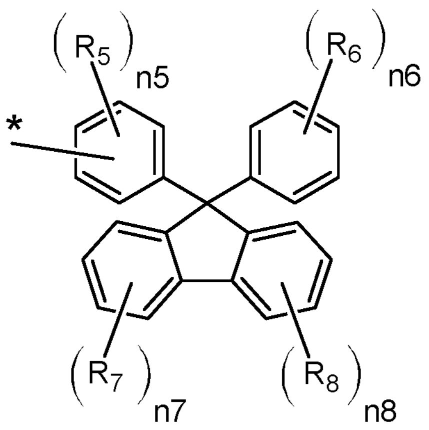

(3)

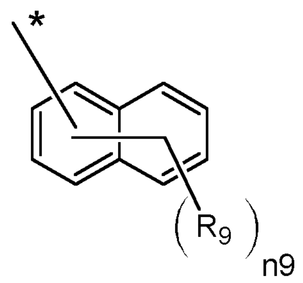

(4)

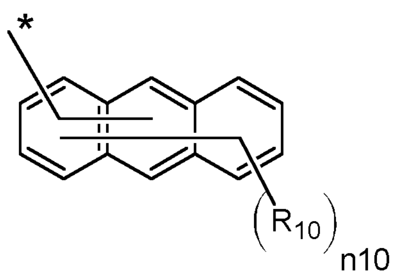

(5)

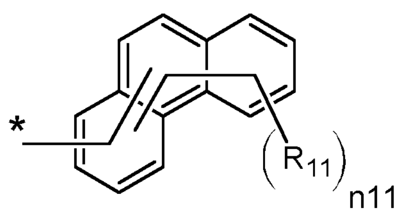

(6)

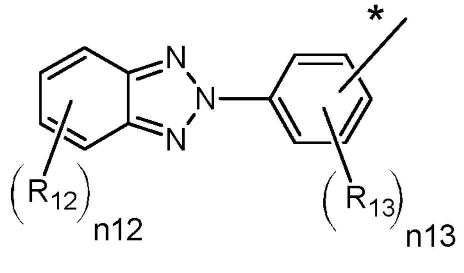

(7)

(In Formulas (1) to (7), $R_1$ to $R_{13}$ each independently represent a halogen atom or a monovalent group.

X represents a single bond, -O-, -CO-, $-NR_{31}-$ ($R_{31}$ represents a hydrogen atom, an alkyl group which may be substituted, or an aryl group which may be substituted), - SO-, $-SO_2-$, or -N=N-.

$Y_1$ represents a single bond or -CO-, and when $Y_1$ is a single bond, $Y_2$ represents -O-, -CO-, or $-NR_{32}-$ ($R_{32}$ represents a hydrogen atom, an alkyl group which may be substituted, or an aryl group which may be substituted.) When $Y_1$ is -CO-, $Y_2$ represents -CO-.

n1 is an integer of 0 to 4.
n2 is an integer of 0 to 5.
n3 is an integer of 0 to 3.
n4 is an integer of 0 to 4.
n5 is an integer of 0 to 4.
n6 is an integer of 0 to 5.
n7 is an integer of 0 to 4.
n8 is an integer of 0 to 4.
n9 is an integer of 0 to 7.
n10 is an integer of 0 to 9.
n11 is an integer of 0 to 9.
n12 is an integer of 0 to 4.
n13 is an integer of 0 to 4.
* represents a bond.

When there are a plurality of $R_1$s to $R_{13}$s, the plurality of $R_1$s to $R_{13}$s may be the same as or different from each other.)

Examples of the halogen atom in $R_1$ to $R_{13}$ include a fluorine atom, a chlorine atom, a bromine atom, and an iodine atom.

Examples of the monovalent group in $R_1$ to $R_{13}$ include an atomic group composed of two or more atoms, and specific examples thereof include an alkyl group which may be substituted, an alkoxy group which may be substituted, an aryl group which may be substituted, a hydroxy group, a nitro group, a cyano group, a carboxy group, a sulfo group, and $N(R_{21})(R_{22})$ ($R_{21}$ and $R_{22}$ each independently represent a hydrogen atom, an alkyl group which may be substituted, or an aryl group which may be substituted).

Examples of the alkyl group which may be substituted in the specific examples of $R_1$ to $R_{13}$ include an alkyl group having 1 to 20 carbon atoms which may be substituted. Examples of the substituent include a halogen atom, a hydroxy group, a carboxy group, and an alkoxy group.

Examples of the alkoxy group which may be substituted in the specific examples of $R_1$ to $R_{13}$ include an alkoxy group having 1 to 20 carbon atoms which may be substituted. Examples of the substituent include a halogen atom, a hydroxy group, a carboxy group, and an alkyl group.

Examples of the aryl group which may be substituted in the specific examples of $R_1$ to $R_{13}$ include an aryl group having 6 to 20 carbon atoms which may be substituted. Examples of the substituent include a halogen atom, a hydroxy group, a carboxy group, an alkyl group, and an alkoxy group.

Specific examples of an alkyl group which may be substituted in $R_{21}$, $R_{22}$, $R_{31}$, and $R_{32}$ include the specific examples of the alkyl group which may be substituted in the specific examples of $R_1$ to $R_{13}$.

Specific examples of an aryl group which may be substituted in $R_{21}$, $R_{22}$, $R_{31}$, and $R_{32}$ include the specific examples of the aryl group which may be substituted in the specific examples of $R_1$ to $R_{13}$.

Examples of the alkyl group as a substituent include an alkyl group having 1 to 6 carbon atoms.

Examples of the alkoxy group as a substituent include an alkoxy group having 1 to 6 carbon atoms.

Note that, "1 to 20 carbon atoms" in the "alkyl group having 1 to 20 carbon atoms which may be substituted" represents the number of carbon atoms excluding the number of carbon atoms in the substituent. The same applies to the "aryl group having 6 to 20 carbon atoms which may be substituted" and the "alkoxy group having 1 to 20 carbon atoms which may be substituted".

The first structure preferably contains at least one hydroxy group from the following viewpoints (A) to (C).

(A): Excellent light absorbability (for example, light in a high wavelength region such as 308 to 355 nm is easily absorbed).
(B): The semiconductor substrate and the support substrate are easily released by absorbing light.
(C): Crosslinking reactivity is imparted.

In a case where the first structure is a structure represented by any one of Formulas (1) to (7), each of Formulas (1) to (7) preferably contains at least one hydroxy group as any of $R_1$ to $R_{13}$ from the viewpoints (A) to (C) described above.

Examples of a structure in which X is -CO- in Formula (1) include a structure obtained by removing one hydrogen atom of an aromatic ring from the following compound and converting the compound into a monovalent group.

- 2-Hydroxybenzophenone
- 2,4-Dihydroxybenzophenone
- 2,3,4-Trihydroxybenzophenone
- 2,2',4,4'-Tetrahydroxybenzophenone
- 2,2',5,6'-Tetrahydroxybenzophenone
- 2-Hydroxy-4-methoxybenzophenone
- 2-Hydroxy-4-octoxybenzophenone
- 2-Hydroxy-4-dodecyloxybenzophenone
- 2,2'-Dihydroxy-4-methoxybenzophenone
- 2,6-Dihydroxy-4-methoxybenzophenone
- 2,2'-Dihydroxy-4,4'-dimethoxybenzophenone
- 4-Amino-2'-hydroxybenzophenone
- 4-Dimethylamino-2'-hydroxybenzophenone
- 4-Diethylamino-2'-hydroxybenzophenone
- 4-Dimethylamino-4'-methoxy-2'-hydroxybenzophenone
- 4-Dimethylamino-2',4'-dihydroxybenzophenone
- 4-Dimethylamino-3',4'-dihydroxybenzophenone

Examples of a structure in which X is -SO- in Formula (1) include a structure obtained by removing one hydrogen atom of an aromatic ring from the following compound and converting the compound into a monovalent group.

- Bis(2,3-dihydroxyphenyl)sulfoxide
- Bis(5-chloro-2,3-dihydroxyphenyl)sulfoxide
- Bis(2,4-dihydroxyphenyl)sulfoxide
- Bis(2,4-dihydroxy-6-methylphenyl)sulfoxide
- Bis(5-chloro-2,4-dihydroxyphenyl)sulfoxide
- Bis(2,5-dihydroxyphenyl)sulfoxide
- Bis(3,4-dihydroxyphenyl)sulfoxide
- Bis(3,5-dihydroxyphenyl)sulfoxide
- Bis(2,3,4-trihydroxyphenyl)sulfoxide
- Bis(2,3,4-trihydroxy-6-methylphenyl)sulfoxide
- Bis(5-chloro-2,3,4-trihydroxyphenyl)sulfoxide
- Bis(2,4,6-trihydroxyphenyl)sulfoxide
- Bis(5-chloro-2,4,6-trihydroxyphenyl)sulfoxide

Examples of a structure in which X is $-SO_2-$ in Formula (1) include a structure obtained by removing one hydrogen atom of an aromatic ring from the following compound and converting the compound into a monovalent group.

- Bis(2,4-dihydroxyphenyl)sulfone
- Bis(3,4-dihydroxyphenyl)sulfone
- Bis(3,5-dihydroxyphenyl)sulfone
- Bis(3,6-dihydroxyphenyl)sulfone
- Bis(4-hydroxyphenyl)sulfone
- Bis(3-hydroxyphenyl)sulfone
- Bis(2-hydroxyphenyl)sulfone
- Bis(3,5-dimethyl-4-hydroxyphenyl)sulfone

Examples of a structure in which $Y_1$ is a single bond and $Y_2$ is -CO- in Formula (2) include a structure obtained by removing one hydrogen atom of an aromatic ring from the following compound and converting the compound into a monovalent group.

- 2,7-Dihydroxy-9H-fluoren-9-one

Examples of the structure represented by Formula (3) include a structure obtained by removing one hydrogen atom of an aromatic ring from the following compound and converting the compound into a monovalent group.

- 9,9-Bis(4-hydroxyphenyl)fluorene
- 9,9-Bis(4-hydroxy-3-methylphenyl)fluorene

- 9,9-Bis(4-hydroxy-3-ethylphenyl)fluorene
- 9,9-Bis(4-hydroxy-3-n-propylphenyl)fluorene
- 9,9-Bis(4-hydroxy-3-isopropylphenyl)fluorene
- 9,9-Bis(4-hydroxy-3-n-butylphenyl)fluorene
- 9,9-Bis(4-hydroxy-3-sec-butylphenyl)fluorene
- 9,9-Bis(4-hydroxy-3-tert-butylphenyl)fluorene
- 9,9-Bis(4-hydroxy-3-cyclohexylphenyl)fluorene
- 9,9-Bis(4-hydroxy-3-phenylphenyl)fluorene

The first structure is bonded to, for example, Si in the siloxane structure as the second structure directly or via a linking group. The linking group is selected from the group consisting of, for example, an alkylene group having 1 to 10 carbon atoms, an ester bond, an ether bond, an amide bond, a urethane bond, a urea bond, and a combination of two or more thereof. Note that, in the "combination of two or more thereof", two or more groups or bonds of the same type, such as $-O-CH_2-O-$ and $-CH_2-O-CH_2-$, may be used.

-Second Structure-

The second structure is not particularly limited as long as it is a siloxane structure.

The second structure contains, for example, at least one selected from the group consisting of a siloxane unit (Q unit) represented by $SiO_2$, a siloxane unit (M unit) represented by $R_{101}R_{102}R_{103}SiO_{1/2}$, a siloxane unit (D unit) represented by $R_{104}R_{105}SiO_{2/2}$, and a siloxane unit (T unit) represented by $R_{106}SiO_{3/2}$ ($R_{101}$ to $R_{106}$ each independently represent a hydrogen atom or monovalent group bonded to Si, or a single bond or linking group that binds Si and the first structure).

Specific examples of the monovalent group in $R_{101}$ to $R_{106}$ include the specific examples exemplified in the description of the monovalent group in $R_1$ to $R_{13}$.

The monovalent group in $R_{101}$ to $R_{106}$ is preferably an alkyl group which may have a substituent or an aryl group which may have a substituent, and more preferably an alkyl group having 1 to 6 carbon atoms or a phenyl group.

The first structure is bonded to, for example, Si of any one of the M unit, the D unit, and the T unit via a single bond or a linking group.

The linking group is selected from the group consisting of, for example, an alkylene group having 1 to 10 carbon atoms, an ester bond, an ether bond, an amide bond, a urethane bond, a urea bond, and a combination of two or more thereof. Note that, in the "combination of two or more thereof", two or more groups or bonds of the same type, such as $-O-CH_2-O-$ and $-CH_2-O-CH_2-$, may be used.

The specific compound described above is an organosiloxane polymer because the first structure has a predetermined structure that absorbs light and a siloxane structure, a weight average molecular weight of such a specific compound is not particularly limited, but is usually 400 to 100,000, an upper limit thereof is preferably 50,000, more preferably, 30,000, still more preferably 20,000, still more preferably 10,000, and further still more preferably 5,000, from the viewpoint of preparing a release agent composition that suppresses precipitation of a polymer and has excellent storage stability with excellent reproducibility, and a lower limit thereof is preferably 500 and more preferably 1,000 from the viewpoint of preparing a release agent composition that provides a release layer having excellent heat resistance with excellent reproducibility.

The weight average molecular weight of the specific compound is measured, for example, by the following method.

The weight average molecular weight of the specific compound is measured using a GPC apparatus (HLC-8320GPC manufactured by Tosoh Corporation) and a GPC column (Shodex [registered trademark] KF-801, KF-802, and KF-803L manufactured by Showa Denko K.K.) at a column temperature of 40°C, using tetrahydrofuran (THF) as an eluent (elution solvent), and using polystyrene (Shodex manufactured by Showa Denko K.K.) as a standard sample at a flow rate of 1.0 mL/min.

The amount of the specific compound contained in the release agent composition varies depending on a coating method to be employed, a desired film thickness, and the like, and thus cannot be generally defined, but is usually 1 to 100 mass% with respect to the film constituent components, preferably 20 mass% or more, more preferably 30 mass% or more, still more preferably 40 mass% or more, further still more preferably 50 mass% or more, and particularly preferably 60 mass% or more, from the viewpoint of obtaining a laminate in which a semiconductor substrate and a support substrate can be preferably separated with excellent reproducibility. Not that, in the present invention, the film constituent components mean components other than the solvent contained in the composition.

A method for obtaining the specific compound is not particularly limited, and examples thereof include the following method (i) or (ii).

(i): Method for obtaining a specific compound by hydrolysis condensation of a hydrolyzable silane compound having a first structure alone or hydrolysis condensation of a hydrolyzable silane compound having a first structure with another hydrolyzable silane compound

(ii): Method for obtaining a specific compound by obtaining a compound having a second structure by hydrolysis condensation of a hydrolyzable silane compound and then reacting the compound having the second structure with a compound having a first structure

A method of hydrolysis condensation is not particularly limited, and a general method of synthesizing a polysiloxane from a hydrolyzable silane compound can be used.

The hydrolyzable silane compound having the first structure used in (i) may be a synthesized product or a commercially available product. Examples of the commercially available product include 2-hydroxy-4-(3-triethoxysilylpropoxy)diphenylketone (manufactured by Gelest Inc.).

Examples of the other hydrolyzable silane compounds used in (i) and the hydrolyzable silane compound used in (ii) include a compound represented by the following Formula (11) and a compound represented by the following Formula (12).

$$R^1_aSi(R^2)_{4-a} \cdots \qquad \text{Formula (11)}$$

(In the formula, $R^1$ is an alkyl group, an aryl group, a halogenated alkyl group, a halogenated aryl group, an alkenyl group, or an organic group having an acryloyl group, a methacryloyl group, a mercapto group, or a cyano group, and is bonded to a silicon atom by a Si-C bond, $R^2$ represents an alkoxy group, an acyloxy group, or a halogen atom, and a represents an integer of 0 to 3.)

$$[R^3_cSi(R^4)_{3-c}]Z_b \cdots \qquad \text{Formula (12)}$$

(In the formula, $R^3$ represents an alkyl group, $R^4$ represents an alkoxy group, an acyloxy group, or a halogen atom, Z represents an alkylene group or an arylene group, b represents an integer of 0 or 1, and c represents an integer of 0 or 1.)

Examples of the compound represented by Formula (11) include tetramethoxysilane, tetrachlorosilane, tetraacetoxysilane, tetraethoxysilane, tetra-n-propoxysilane, tetraisopropoxysilane, tetra-n-butoxysilane, tetraacetoxysilane, methyltrimethoxysilane, methyltriethoxysilane, methyltrichlorosilane, methyltriacetoxysilane, methyltripropoxysilane, methyltriacetoxysilane, methyltributoxysilane, methyltripropoxysilane, methyltriamyloxysilane, methyltriphenoxysilane, methyltribenzyloxysilane, methyltriphenethyloxysilane, ethyltrimethoxysilane, ethyltriethoxysilane, vinyltrimethoxysilane, vinyltrichlorosilane, vinyltriacetoxysilane, vinyltriethoxysilane, vinyltriacetoxysilane, phenyltrimethoxysilane, phenyltrichlorosilane, phenyltriacetoxysilane, phenyltriethoxysilane, phenyltriacetoxysilane, γ-methacryloxypropyltrimethoxysilane, γ-mercaptopropyltrimethoxysilane, γ-mercaptopropyltriethoxysilane, β-cyanoethyltriethoxysilane, dimethyldimethoxysilane, phenylmethyldimethoxysilane, dimethyldiethoxysilane, phenylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptomethyldiethoxysilane, methylvinyldimethoxysilane, and methylvinyldiethoxysilane.

Examples of the compound represented by Formula (12) include methylenebistrimethoxysilane, methylenebistrichlorosilane, methylenebistriacetoxysilane, ethylenebistriethoxysilane, ethylenebistrichlorosilane, ethylenebistriacetoxysilane, propylenebistriethoxysilane, butylenebistrimethoxysilane, phenylenebistrimethoxysilane, phenylenebistriethoxysilane, phenylenebismethyldiethoxysilane, phenylenebismethyldimethoxysilane, naphthylenebistrimethoxysilane, bistrimethoxydisilane, bistriethoxydisilane, bisethyldiethoxydisilane, and bismethyldimethoxydisilane.

Examples of a hydrolysis catalyst used for the hydrolysis condensation in (i) and (ii) include a metal chelate compound, an organic acid, an inorganic acid, an organic base, and an inorganic base.

Examples of the metal chelate compound as the hydrolysis catalyst include titanium chelate compounds such as triethoxy·mono(acetylacetonate)titanium, tri-n-propoxy-mono(acetylacetonate)titanium, tri-i-propoxy-mono(acetylacetonate)titanium, tri-n-butoxy·mono(acetylacetonate)titanium, tri-sec-butoxy·mono(acetylacetonate)titanium, tri-t-butoxy·mono(acetylacetonate)titanium, diethoxy·bis(acetylacetonate)titanium, di-n-propoxy·bis(acetylacetonate)titanium, di-i-propoxy·bis(acetylacetonate)titanium, di-n-butoxy·bis(acetylacetonate)titanium, di-sec-butoxy·bis(acetylacetonate)titanium, di-t-butoxy·bis(acetylacetonate)titanium, monoethoxy·tris(acetylacetonate)titanium, mono-n-propoxy·tris(acetylacetonate)titanium, mono-i-propoxy·tris(acetylacetonate)titanium, mono-n-butoxy·tris(acetylacetonate)titanium, mono-sec-butoxy·tris(acetylacetonate)titanium, mono-t-butoxy·tris(acetylacetonate)titanium, tetrakis(acetylacetonate)titanium, triethoxy·mono(ethylacetoacetate)titanium, tri-n-propoxy·mono(ethylacetoacetate)titanium, tri-i-propoxy·mono(ethylacetoacetate)titanium, tri-n-butoxy·mono(ethylacetoacetate)titanium, tri-sec-butoxy·mono(ethylacetoacetate)titanium, tri-t-butoxy·mono(ethylacetoacetate)titanium, diethoxy·bis(ethylacetoacetate)titanium, di-n-propoxy·bis(ethylacetoacetate)titanium, di-i-propoxy·bis(ethylacetoacetate)titanium, di-n-butoxy·bis(ethylacetoacetate)titanium, di-sec-butoxy·bis(ethylacetoacetate)titanium, di-t-butoxy·bis(ethylacetoacetate)titanium, monoethoxy·tris(ethylacetoacetate)titanium, mono-n-propoxy·tris(ethylacetoacetate)titanium, mono-i-propoxy·tris(ethylacetoacetate)titanium, mono-n-butoxy·tris(ethylacetoacetate)titanium, mono-sec-butoxy·tris(ethylacetoacetate)titanium, mono-t-butoxy·tris(ethylacetoacetate)titanium, tetrakis(ethylacetoacetate)titanium, mono(acetylacetonate)tris(ethylacetoacetate)titanium, bis(acetylacetonate)bis(ethylacetoacetate)titanium, and tris(acetylacetonate)mono(ethylacetoacetate)titanium; zirconium chelate compounds such as triethoxy-mono(acetylacetonate)zirconium, tri-n-propoxy·mono(acetylacetonate)zirconium, tri-i-propoxy·mono(acetylacetonate)zirconium, tri-n-butoxy·mono(acetylacetonate)zirconium, tri-sec-butoxy·mono(acetylacetonate)zirconium, tri-t-butoxy·mono(acetylacetonate)zirconium, diethoxy·bis(acetylacetonate)zirconium, di-n-propoxy·bis(acetylacetonate)zirconium, di-i-propoxy·bis(acetylacetonate)zirconium, di-n-butoxy·bis(acetylacetonate)zirconium, di-sec-butoxy·bis(acetylacetonate)zirconium, di-t-butoxy·bis(acetylacetonate) zirconium, monoethoxy·tris(acetylacetonate)zirconium, mono-n-propoxy·tris(acetylacetonate)zirconium, mono-i-propoxy·tris(acetylacetonate)zirconium, mono-n-butoxy·tris(acetylacetonate)zirconium, mono-sec-butoxy·tris(acetylacetonate)zirconium, mono-t-butoxy·tris(acetylacetonate)zirconium, tetrakis(acetylacetonate)zirconium, triethoxy·mono(ethylacetoacetate)zirconium, tri-n-propoxy·mono(ethylacetoacetate)zirconium, tri-i-propoxy·mono(ethylacetoacetate)zirconium, tri-n-butoxy·mono(ethylacetoacetate)zirconium, tri-sec-butoxy·mono(ethylacetoacetate)zirconium, tri-t-butoxy·mono(ethylacetoacetate)zirconium, diethoxy·bis(ethylacetoacetate)zirconium, di-n-propoxy·bis(ethylacetoacetate)zirconium, di-i-propoxy·bis(ethylacetoacetate)zirconium, di-n-butoxy·bis(ethylacetoacetate)zirconium, di-sec-butoxy·bis(ethylacetoacetate)zirconium, di-t-butoxy·bis(ethylacetoacetate)zirconium, monoethoxy·tris(ethylacetoacetate)zirconium, mono-n-propoxy·tris(ethylacetoacetate)zirconium, mono-i-propoxy·tris(ethylacetoacetate)zirconium, mono-n-butoxy·tris(ethylacetoacetate)zirconium, mono-sec-butoxy·tris(ethylacetoacetate)zirconium, mono-t-butoxy·tris(ethylacetoacetate)zirconium, tetrakis(ethylacetoacetate)zirconium, mono(acetylacetonate)tris(ethylacetoacetate)zirconium, bis(acetylacetonate)bis(ethylacetoacetate)zirconium, and tris(acetylacetonate)mono(ethylacetoacetate)zirconium; and aluminum chelate compounds such as tris(acetylacetonate)aluminum and tris(ethylacetoacetate)aluminum.

Examples of the organic acid as the hydrolysis catalyst include acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, mikimic acid, 2-ethylhexanoic acid, oleic acid, stearic acid, linoleic acid, linoleic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, and trifluoromethanesulfonic acid.

Examples of the inorganic acid as the hydrolysis catalyst include hydrochloric acid, nitric acid, sulfuric acid, hydrofluoric acid, and phosphoric acid.

Examples of the organic base as the hydrolysis catalyst include pyridine, pyrrole, piperazine, pyrrolidine, piperidine, picoline, trimethylamine, triethylamine, monoethanolamine, diethanolamine, dimethylmonoethanolamine, monomethyldiethanolamine, triethanolamine, diazabicyclooctane, diazabicyclononane, diazabicycloundecene, tetramethylammonium hydroxide, tetraethylammonium hydroxide, and tetrabutylammonium hydroxide.

Examples of the inorganic base as the hydrolysis catalyst include ammonia, sodium hydroxide, potassium hydroxide, barium hydroxide, and calcium hydroxide.

Examples of the organic solvent used for the hydrolysis condensation include aliphatic hydrocarbon-based solvents such as n-pentane, i-pentane, n-hexane, i-hexane, n-heptane, i-heptane, 2,2,4-trimethylpentane, n-octane, i-octane, cyclohexane, and methylcyclohexane; aromatic hydrocarbon-based solvents such as benzene, toluene, xylene, ethylbenzene, trimethylbenzene, methylethylbenzene, n-propylbenzene, i-propylbenzene, diethylbenzene, i-butylbenzene, triethylbenzene, di-i-propylbenzene, n-amylnaphthalene, and trimethylbenzene; mono-alcoholic solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, sec-heptanol, heptanol-3, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; polyhydric alcohol solvents such as ethylene glycol, propylene glycol, 1,3-butylene glycol, pentanediol-2,4,2-methylpentanediol-2,4, hexanediol-2,5, heptanediol-2,4,2-ethylhexanediol-1,3, diethylene glycol, dipropylene glycol, triethylene glycol, tripropylene glycol, and glycerin; ketone-based solvents such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethylnonanone, cyclohexanone, methylcyclohexanone, 2,4-pentanedione, acetonylacetone, diacetone alcohol, acetophenone, and fenchone; ether-based solvents such as ethyl ether, i-propyl ether, n-butyl ether, n-hexyl ether, 2-ethylhexyl ether, ethylene oxide, 1,2-propylene oxide, dioxolane, 4-methyldioxolane, dioxane, dimethyldioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol monophenyl ether, ethylene

glycol mono-2-ethylbutyl ether, ethylene glycol dibutyl ether, diethylene glycol monomethyl ether, diethylene glycol monoethyl ether, diethylene glycol diethyl ether, diethylene glycol mono-n-butyl ether, diethylene glycol din-butyl ether, diethylene glycol mono-n-hexyl ether, ethoxytriglycol, tetraethylene glycol di-n-butyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tetrahydrofuran, and 2-methyltetrahydrofuran; ester-based solvents such as diethyl carbonate, methyl acetate, ethyl acetate, γ-butyrolactone, γ-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, Propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxytriglycol acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; nitrogen-containing solvents such as N-methylformamide, N,N-dimethylformamide, N,N-diethylformamide, acetamide, N-methylacetamide, N,N-dimethylacetamide, N-methylpropionamide, and N-methylpyrrolidone; and sulfur-containing solvents such as dimethyl sulfide, diethyl sulfide, thiophene, tetrahydrothiophene, dimethyl sulfoxide, sulfolane, and 1,3-propane sultone. These organic solvents can be used alone or in combination of two or more thereof.

<<<Crosslinking Agent>>>

The release agent composition may contain a crosslinking agent. When the crosslinking agent is contained, crosslinking between the specific compounds preferably proceeds, and preferred curing can be realized. As a result, a film that cannot be preferably removed by an organic solvent, an acid, and a chemical solution (alkaline developer, hydrogen peroxide solution, or the like) used in manufacture of a semiconductor element but can be preferably removed by a cleaning agent composition can be obtained with excellent reproducibility.

Specific examples of such a crosslinking agent include, but are not particularly limited to, typically, a phenolic crosslinking agent, a melamine-based crosslinking agent, a urea-based crosslinking agent, and a thiourea-based crosslinking agent that have a crosslink forming group such as an alkoxymethyl group such as a hydroxymethyl group, a methoxymethyl group, or a butoxymethyl group in the molecule, and these crosslinking agents may be a low molecular weight compound or a high molecular weight compound.

The crosslinking agent contained in the release agent composition usually has two or more crosslink forming groups, and from the viewpoint of realizing more preferred curing with excellent reproducibility, the number of crosslink forming groups contained in the compound as a crosslinking agent is preferably 2 to 10 and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, a phenolic crosslinking agent.

The phenolic crosslinking agent having a crosslink forming group is a compound having a crosslinking group bonded to an aromatic ring and having at least one of a phenolic hydroxy group and an alkoxy group derived from a phenolic hydroxy group, and examples of the alkoxy group derived from such a phenolic hydroxy group include a methoxy group and a butoxy group, but are not limited thereto.

Each of the aromatic ring to which the crosslink forming group is bonded, the phenolic hydroxy group, and/or the aromatic ring to which the alkoxy group derived from the phenolic hydroxy group is bonded is not limited to a non-condensed ring type aromatic ring such as a benzene ring, and may be a condensed ring type aromatic ring such as a naphthalene ring or anthracene.

In a case where a plurality of aromatic rings are present in the molecule of the phenolic crosslinking agent, the crosslink forming group, the phenolic hydroxy group, and the alkoxy group derived from the phenolic hydroxy group may be bonded to the same aromatic ring in the molecule or may be bonded to different aromatic rings.

The aromatic ring to which the crosslink forming group, the phenolic hydroxy group, or the alkoxy group derived from the phenolic hydroxy group is bonded may be further substituted with an alkyl group such as a methyl group, an ethyl group, or a butyl group, a hydrocarbon group such as an aryl group such as a phenyl group, a halogen atom such as a fluorine atom, or the like.

Specific examples of the phenolic crosslinking agent having a crosslink forming group include compounds represented by any one of Formulas (L1) to (L4).

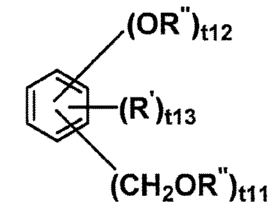

(L1)

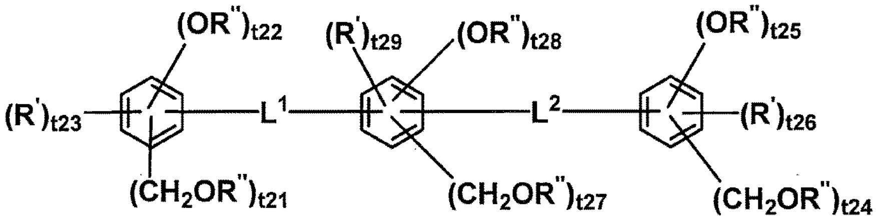

(L2)

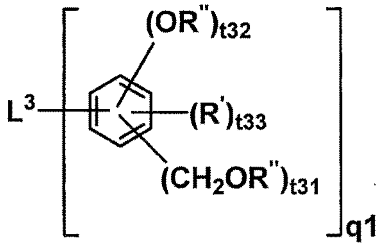

(L3)

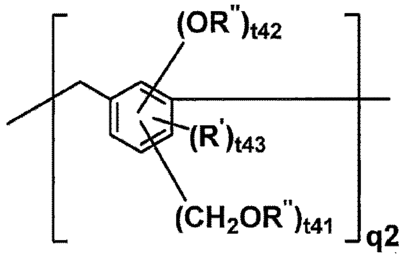

(L4)

In each formula, R's each independently represent a fluorine atom, an aryl group, or an alkyl group, R"s each independently represent a hydrogen atom or an alkyl group, $L^1$ and $L^2$ each independently represent a single bond, a methylene group, or a propane-2,2-diyl group, $L^3$ is determined according to q1 and represents a single bond, a methylene group, a propane-2,2-diyl group, a methanetriyl group, or an ethane-1,1,1-triyl group, t11, t12, and t13 are integers satisfying $2 \leq t11 \leq 5$, $1 \leq t12 \leq 4$, $0 \leq t13 \leq 3$, and $t11 + t12 + t13 \leq 6$, t21, t22, and t23 are integers satisfying $2 \leq t21 \leq 4$, $1 \leq t22 \leq 3$, $0 \leq t23 \leq 2$, and $t21 + t22 + t23 \leq 5$, t24, t25, and t26 are integers satisfying $2 \leq t24 \leq 4$, $1 \leq t25 \leq 3$, $0 \leq t26 \leq 2$, and $t24 + t25 + t26 \leq 5$, t27, t28, and t29 are integers satisfying $0 \leq t27 \leq 4$, $0 \leq t28 \leq 4$, $0 \leq t29 \leq 4$, and $t27 + t28 + t29 \leq 4$, t31, t32, and t33 are integers satisfying $2 \leq t31 \leq 4$, $1 \leq t32 \leq 3$, $0 \leq t33 \leq 2$, and $t31 + t32 + t33 \leq 5$, t41, t42, and t43 are integers satisfying $2 \leq t41 \leq 3$, $1 \leq t42 \leq 2$, $0 \leq t43 \leq 1$, and $t41 + t42 + t43 \leq 4$, q1 is 2 or 3, q2 represents the number of repetitions and is an integer of 0 or more, specific examples of the aryl group and the alkyl group include those same as the following specific examples, the aryl group is preferably a phenyl group, and the alkyl group is preferably a methyl group or a t-butyl group.

Hereinafter, specific examples of the compounds represented by Formulas (L1) to (L4) are described below, but are limited thereto. Note that these compounds may be synthesized by a known method, and can also be obtained, for example, as a product of Asahi Organic Chemical Industry Co., Ltd., or Honshu Chemical Industry Co., Ltd.

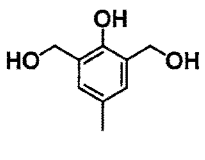

(L1)

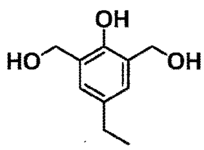

(L2)

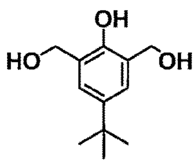

(L3)

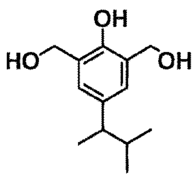

(L4)

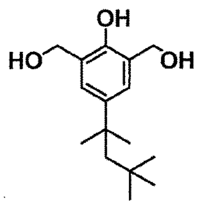

(L5)

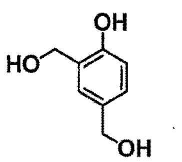

(L6)

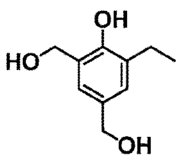

(L7)

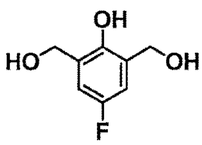

(L8)

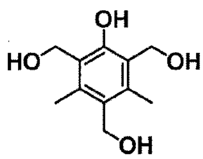

(L9)

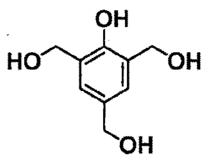

(L10)

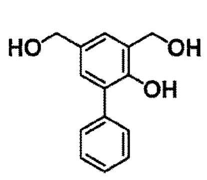
(L11)

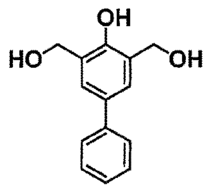
(L12)

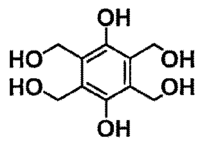
(L13)

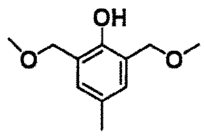
(L1M)

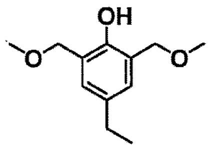
(L2M)

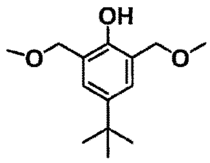
(L3M)

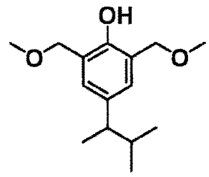
(L4M)

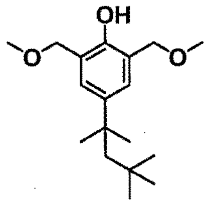
(L5M)

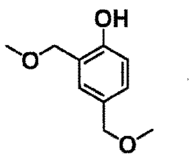
(L6M)

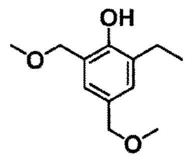
(L7M)

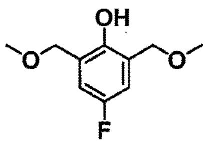
(L8M)

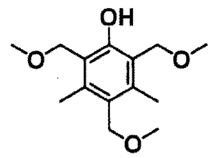
(L9M)

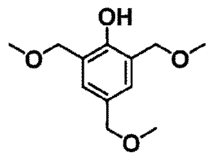
(L10M)

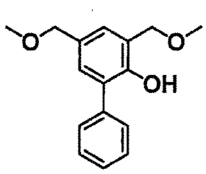
(L11M)

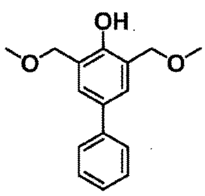
(L12M)

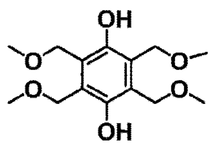
(L13M)

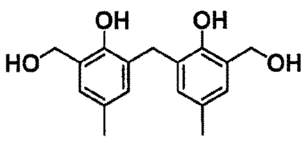
(L14)

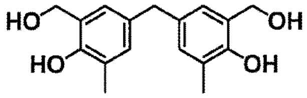
(L15)

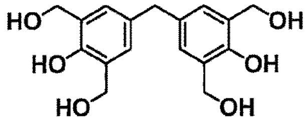
(L16)

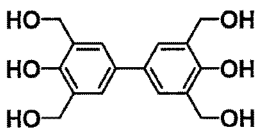
(L17)

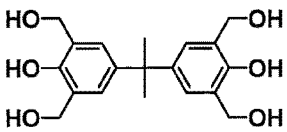
(L18)

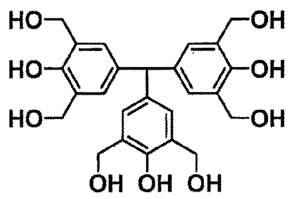
(L19)

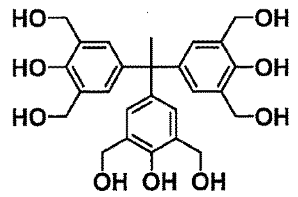
(L20)

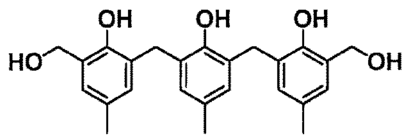
(L21)

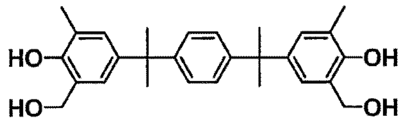
(L22)

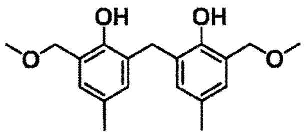
(L14M)

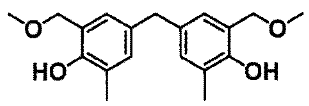
(L15M)

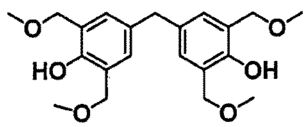
(L16M)

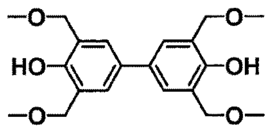
(L17M)

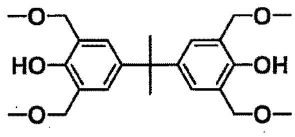
(L18M)

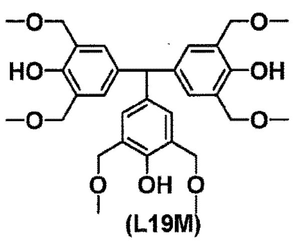
(L19M)

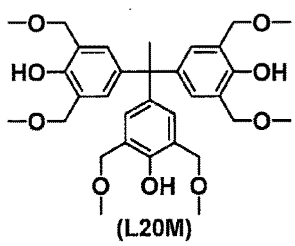
(L20M)

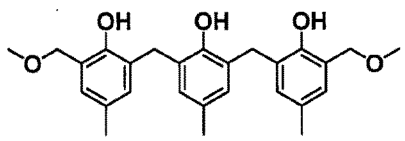
(L21M)

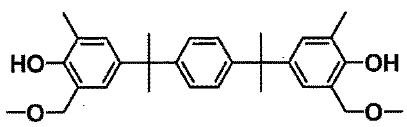
(L22M)

The melamine-based crosslinking agent having a crosslink forming group is a melamine derivative, a 2,4-diamino-1,3,5-triazine derivative, or a 2-amino-1,3,5-triazine derivative in which at least one of hydrogen atoms of an amino group bonded to a triazine ring thereof is substituted with a crosslink forming group, and the triazine ring may further have a substituent such as an aryl group such as a phenyl group.

Specific examples of the melamine-based crosslinking agent having a crosslink forming group include, but are not limited to, mono-, bis-, tris-, tetrakis-, pentakis-, or hexakisalkoxymethylmelamine such as N,N,N',N',N",N"-hexakis(methoxymethyl)melamine or N,N,N',N',N",N"-hexakis(butoxymethyl)melamine, and mono-, bis-, tris-, or tetrakisalkoxymethylbenzoguanamine such as N,N,N',N'-tetrakis(methoxymethyl)benzoguanamine or N,N,N',N'-tetrakis(butoxymethyl)benzoguanamine.

The urea-based crosslinking agent having a crosslink forming group is a derivative of a urea bond-containing

compound, and has a structure in which at least one of hydrogen atoms of an NH group constituting a urea bond is substituted with a crosslink forming group.

Specific examples of the urea-based crosslinking agent having a crosslink forming group include, but are not limited to, mono-, bis-, tris-, or tetrakisalkoxymethylglycoluril such as 1,3,4,6-tetrakis(methoxymethyl)glycoluril or 1,3,4,6-tetrakis(butoxymethyl)glycoluril, and mono-, bis-, tris-, or tetrakisalkoxymethylurea such as 1,3-bis(methoxymethyl)urea or 1,1,3,3-tetrakismethoxymethylurea.

The thiourea-based crosslinking agent having a crosslink forming group is a derivative of a thiourea bond-containing compound, and has a structure in which at least one of hydrogen atoms of an NH group constituting a thiourea bond is substituted with a crosslink forming group.

Specific examples of the thiourea-based crosslinking agent having a crosslink forming group include, but are not limited to, mono-, bis-, tris-, or tetrakisalkoxymethylthiourea such as 1,3-bis(methoxymethyl)thiourea or 1,1,3,3-tetrakismethoxymethylthiourea.

The amount of the crosslinking agent contained in the release agent composition varies depending on a coating method to be employed, a desired film thickness, and the like, and thus cannot be generally defined, but is usually 0.01 to 50 mass% with respect to the specific compound, preferably 0.1 mass% or more, more preferably 1 mass% or more, still more preferably 3 mass% or more, and further still more preferably 5 mass% or more, but is preferably 45 mass% or less, more preferably 40 mass% or less, still more preferably 35 mass% or less, and further still more preferably 30 mass% or less, from the viewpoint of realizing preferred curing and obtaining a laminate in which a semiconductor substrate and a support substrate can be preferably separated with excellent reproducibility.

<<<Acid Generator and Acid>>>

For the purpose of, for example, promoting the crosslinking reaction, the release agent composition may contain an acid generator or an acid.

Examples of the acid generator include a thermal acid generator and a photoacid generator.

The thermal acid generator is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (manufactured by King Industries Inc.), SI-45, SI-60, SI-80, SI-100, SI-110, and SI-150 (manufactured by SANSHIN CHEMICAL INDUSTRY CO., LTD.), and other organic sulfonic acid alkyl esters.

Examples of the photoacid generator include an onium salt compound, a sulfonimide compound, and a disulfonyl diazomethane compound.

Specific examples of the onium salt compound include, but are not limited to, iodonium salt compounds such as diphenyliodonium hexafluorophosphate, diphenyliodonium trifluoromethanesulfonate, diphenyliodonium nonafluoro-n-butanesulfonate, diphenyliodonium perfluoro-n-octanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium nitrate, triphenylsulfonium hexafluoroantimonate, triphenylsulfonium nonafluoron-butanesulfonate, triphenylsulfonium camphorsulfonate, and triphenylsulfonium trifluoromethanesulfonate.

Specific examples of the sulfonimide compound include, but are not limited to, N-(trifluoromethanesulfonyloxy)succinimide, N-(nonafluoro-n-butanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyldiazomethane.

Specific examples of the acid include, but are not limited to, an arylsulfonic acid such as p-toluenesulfonic acid, pyridinium p-toluenesulfonic acid (pyridinium p-toluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfone acid, or 1-naphthalenesulfonic acid, and a salt thereof such as a pyridinium salt, an arylcarboxylic acid such as salicylic acid, benzoic acid, hydroxybenzoic acid, or naphthalenecarboxylic acid, and a salt thereof, a chain or cyclic alkylsulfonic acid such as trifluoromethanesulfonic acid or camphorsulfonic acid, and a salt thereof, and a chain or cyclic alkylcarboxylic acid such as citric acid and a salt thereof.

The amount of the acid generator and the acid contained in the release agent composition cannot be generally specified because the amount varies depending on the type of the crosslinking agent to be used together, the heating temperature at the time of forming the film, and the like, but is usually 0.01 to 5 mass% with respect to the film constituent components.

<<<Surfactant>>>

The release agent composition may contain a surfactant for the purpose of, for example, adjusting the liquid physical properties of the composition itself or the film physical properties of the obtained film, or preparing a highly uniform release agent composition with excellent reproducibility.

Examples of the surfactant include nonionic surfactants such as polyoxyethylene alkyl ethers such as polyoxyethylene lauryl ether, polyoxyethylene stearyl ether, polyoxyethylene cetyl ether, and polyoxyethylene oleyl ether, polyoxyethylene alkylallyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by Tochem Products Co. Ltd., trade name), Megafac F171, F173, R-30, and R-30N (manufactured by DIC Corporation, trade name), Fluorad FC430 and FC431 (manufactured by Sumitomo 3M Limited, trade name), and AsahiGuard AG710 and Surflon S-382, SC101, SC102, SC103, SC104, SC105, and SC106 (manufactured by AGC Inc., trade name), and Organosiloxane polymer KP341 (manufactured by Shin-Etsu Chemical Co., Ltd.).

The surfactants can be used alone or in combination of two or more kinds thereof.

The amount of the surfactant is usually 2 mass% or less with respect to the film constituent components of the release agent composition.

<<<Solvent>>>

The release agent composition preferably contains a solvent.

As such a solvent, for example, a high polar solvent capable of preferably dissolving the film constituent components such as the specific compound and the crosslinking agent can be used, and as necessary, a low polar solvent may be used for the purpose of adjusting a viscosity, a surface tension, and the like. Note that, in the present invention, a solvent having a relative permittivity of less than 7 at a frequency of 100 kHz is defined as a low polar solvent, and a solvent having a relative permittivity of 7 or more at a frequency of 100 kHz is defined as a high polar solvent. The solvents can be used alone or in combination of two or more kinds thereof.

In addition, examples of the high polar solvent include amide-based solvents such as N,N-dimethylformamide, N,N-dimethylacetamide, N,N-dimethylisobutyramide, N-methylpyrrolidone, and 1,3-dimethyl-2-imidazolidinone; ketone-based solvents such as ethyl methyl ketone, isophorone, and cyclohexanone; cyano-based solvents such as acetonitrile and 3-methoxypropionitrile; polyhydric alcohol solvents such as ethylene glycol, diethylene glycol, triethylene glycol, dipropylene glycol, 1,3-butanediol, and 2,3-butanediol;
monohydric alcohol solvents other than aliphatic alcohols, such as propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and sulfoxide-based solvents such as dimethylsulfoxide.

Examples of the low polar solvent include chlorine-based solvents such as chloroform and chlorobenzene; aromatic hydrocarbon-based solvents such as alkylbenzenes, for example, toluene, xylene, tetralin, cyclohexylbenzene, and decylbenzene; aliphatic alcoholic solvents such as 1-octanol, 1-nonanol, and 1-decanol; ether-based solvents such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, and triethylene glycol butyl methyl ether; and ester-based solvents such as methyl benzoate, ethyl benzoate, butyl benzoate, isoamyl benzoate, bis(2-ethylhexyl) phthalate, dibutyl maleate, dibutyl oxalate, hexyl acetate, propylene glycol monomethyl ether acetate, diethylene glycol monoethyl ether acetate, and diethylene glycol monobutyl ether acetate.

A content of the solvent is appropriately determined in consideration of the viscosity of the desired composition, the coating method to be employed, the thickness of the film to be prepared, and the like, but is 99 mass% or less with respect to the entire composition, and preferably 70 to 99 mass% with respect to the entire composition, that is, the amount of the film constituent components in that case is 1 to 30 mass% with respect to the entire composition.

The viscosity and surface tension of the release agent composition can be appropriately adjusted by changing a type and a ratio of a solvent to be used, a concentration of the film constituent components, and the like in consideration of various factors such as the coating method to be used and the desired film thickness.

In an aspect of the present invention, the release agent composition contains a glycol-based solvent, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like. Note that the "glycol-based solvent" as used herein is a

generic term for glycols, glycol monoethers, glycol diethers, glycol monoesters, glycol diesters, and glycol ester ethers.

As a preferred example, the glycol-based solvent is represented by Formula (G).

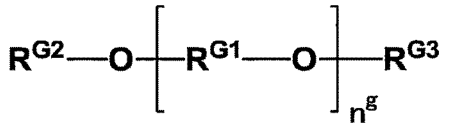 (G)

In Formula (G), $R^{G1}$s each independently represent a linear or branched alkylene group having 2 to 4 carbon atoms, $R^{G2}$ and $R^{G3}$ each independently represent a hydrogen atom, a linear or branched alkyl group having 1 to 8 carbon atoms, or an alkylacyl group in which an alkyl moiety is a linear or branched alkyl group having 1 to 8 carbon atoms, and $n^g$ is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 or 3 carbon atoms is preferable, and a linear or branched alkylene group having 3 carbon atoms is more preferable, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

Specific examples of the linear or branched alkyl group having 1 to 8 carbon atoms include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n- butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Among them, a methyl group and an ethyl group are preferable, and a methyl group is more preferable, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

Specific examples of the linear or branched alkyl group having 1 to 8 carbon atoms in the alkylacyl group in which an alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

$n^g$ is preferably 4 or less, more preferably 3 or less, still more preferably 2 or less, and most preferably 1, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

In Formula (G), preferably, at least one of $R^{G2}$ and $R^{G3}$ is a linear or branched alkyl group having 1 to 8 carbon atoms, more preferably, one of $R^{G2}$ and $R^{G3}$ is a linear or branched alkyl group having 1 to 8 carbon atoms, and the other one is an alkylacyl group in which a hydrogen atom or an alkyl moiety is a linear or branched alkyl group having 1 to 8 carbon atoms, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

A content of the glycol-based solvent is preferably 50 mass% or more, more preferably 70 mass% or more, still more preferably 80 mass% or more, still more preferably 90 mass% or more, and further still more preferably 95 mass% or more, with respect to the solvent contained in the release agent composition, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

In the release agent composition, the film constituent components are uniformly dispersed or dissolved, and

preferably dissolved in the solvent, from the viewpoint of obtaining a highly uniform composition with excellent reproducibility, from the viewpoint of obtaining a highly storage stable composition with excellent reproducibility, from the viewpoint of obtaining a composition that provides a highly uniform film with excellent reproducibility, and the like.

The release agent composition can be prepared, for example, by mixing the specific compound, a solvent, and as necessary, a crosslinking agent.

The mixing order is not particularly limited, and examples of a method by which a release agent composition can be easily and prepared with excellent reproducibility include, but are not limited to, a method of dissolving the specific compound and a crosslinking agent in a solvent at once, and a method of partially dissolving the specific compound and a crosslinking agent in a solvent, separately dissolving the rest in the solvent, and mixing the obtained solutions. Note that, at this time, as the solution of the specific compound, a reaction solution obtained by synthesis of the specific compound can be used as it is or in a concentrated or diluted state. In addition, when the release agent composition is prepared, the release agent composition may be appropriately heated within a range in which the components are not decomposed or altered.

In the present invention, for the purpose of removing foreign substances, a solvent, a solution, or the like to be used may be filtered using a filter or the like during the preparation of the release agent composition or after mixing all the components.

A thickness of the release layer included in the laminate of the present invention is not particularly limited, but is usually 5 nm to 100 um, is 10 nm to 10 um in an aspect, is 50 nm to 1 um in another aspect, and is 100 nm to 700 nm in still another aspect.

The release agent composition described above is also a target of the present invention, and the associated conditions (preferred conditions, preparation conditions, and the like) are as described above. By using the release agent composition of the present invention, for example, a film preferred as a release layer that can be used for manufacturing a semiconductor element can be manufactured with excellent reproducibility.

The release agent composition of the present invention can be preferably used for forming a release layer of a laminate including a semiconductor substrate, a support substrate, and an adhesive layer and a release layer that are provided between the semiconductor substrate and the support substrate. In the laminate, the release layer absorbs light emitted from a side of the support substrate and then is used for release the semiconductor substrate and the support substrate.

One of the characteristics of the release layer obtained using the release agent composition of the present invention is that the release layer cannot be preferably removed by an organic solvent, an acid, or a chemical solution (alkaline developer, hydrogen peroxide solution, or the like) used in manufacture of a semiconductor element, but can be preferably removed by a cleaning agent composition. Such specific and selective removability is contributed by the specific compound contained in the release agent composition of the present invention, and the specific compound can function as a solubility improver or a removability improver for the release layer in the cleaning agent composition, and can function as a solubility lowering agent or a removability lowering agent for an organic solvent and an acid of the release layer and a chemical solution (alkaline developer, hydrogen peroxide solution, or the like) used in manufacture of a semiconductor element.

As described above, it is preferable that the release agent layer obtained using the release agent composition of the present invention cannot be preferably removed by an organic solvent, an acid, or a chemical solution (alkaline developer, hydrogen peroxide solution, or the like) used in manufacture of a semiconductor element.

Specific examples of such an organic solvent typically include linear or branched aliphatic hydrocarbons such as linear or branched aliphatic saturated hydrocarbons such as hexane, heptane, octane, nonane, decane, undecane, dodecane, and isododecane; cycloaliphatic hydrocarbons such as cycloaliphatic saturated hydrocarbons such as cyclohexane, cycloheptane, cyclooctane, isopropylcyclohexane, and p-menthane, and cycloaliphatic unsaturated hydrocarbons such as limonene; aromatic hydrocarbons such as benzene, toluene, o-xylene, m-xylene, p-xylene, mesitylene, 1,2,4-trimethylbenzene, cumene, 1,4-diisopropylbenzene, and p-cymene; aliphatic hydrocarbon ketones such as aliphatic saturated hydrocarbon ketones such as dialkyl ketones such as methyl isobutyl ketone (MIBK), ethyl methyl ketone, acetone, diisobutyl ketone, 2-octanone, 2-nonanone, and 5-nonanone, and cycloalkyl ketones such as cyclohexanone, and aliphatic unsaturated hydrocarbon ketones such as alkenyl ketones such as isophorone; aliphatic hydrocarbon ethers such as dialkyl ethers such as diethyl ether, di(n-propyl) ether, di(n-butyl) ether, and di(n-pentyl) ether, and cyclic alkyl ethers such as tetrahydrofuran and dioxane; aliphatic hydrocarbon sulfides such as dialkyl sulfides such as diethyl sulfide, di(n-propyl) sulfide, and di(n-butyl) sulfide; amides such as N,N-dimethylformamide, N,N-dimethylacetamide, N,N-dimethylisobutyramide, N-methylpyrrolidone, and 1,3-dimethyl-2-imidazolidinone; nitriles such as acetonitrile and 3-methoxypropionitrile; monoalcohols other than alkyl monoalcohols such as linear or branched alkyl monoalcohols such as methanol, ethanol, and propanol, alkyl monoalcohols such as cyclic alkyl monoalcohols such as cyclohexanol, diacetone alcohol, benzyl alcohol, 2-phenoxyethanol, 2-benzyloxyethanol, 3-phenoxybenzyl alcohol, and tetrahydrofurfuryl alcohol; glycols such as ethylene glycol, propylene glycol, diethylene glycol, dipropylene glycol, tripropylene glycol, hexylene glycol, triethylene glycol, 1,2-butanediol, 2,3-butanediol, 1,3-butanediol, 1,4-butane diol, and 1,5-pentanediol;

glycol monohydrocarbon ethers such as glycol monoalkyl ethers such as ethylene glycol monohexyl ether, propylene glycol monobutyl ether, diethylene glycol monoethyl ether, dipropylene glycol monobutyl ether, ethylene glycol monobutyl ether, diethylene glycol monobutyl ether, diethylene glycol monoisobutyl ether, triethylene glycol monomethyl ether, dipropylene glycol monomethyl ether, diethylene glycol monopropyl ether (propyl carbitol), diethylene glycol monohexyl ether, 2-ethylhexyl carbitol, dipropylene glycol monopropyl ether, tripropylene glycol monomethyl ether, diethylene glycol monomethyl ether, and tripropylene glycol monobutyl ether, and glycol monoaryl ethers such as diethylene glycol monophenyl ether; glycol monoethers such as glycol monoaryl ethers such as 2-phenoxyethanol; glycol diethers such as glycol dialkyl ethers such as ethylene glycol dibutyl ether, diethylene glycol dimethyl ether, diethylene glycol diethyl ether, propylene glycol dibutyl ether, dipropylene glycol methyl-n-propyl ether, dipropylene glycol dimethyl ether, dipropylene glycol diethyl ether, dipropylene glycol dibutyl ether, triethylene glycol dimethyl ether, triethylene glycol butyl methyl ether, and tetraethylene glycol dimethyl ether; glycol ether acetates such as glycol monoalkyl ether acetates such as dipropylene glycol monomethyl ether acetate, diethylene glycol monoethyl ether acetate, diethylene glycol monobutyl ether acetate, and propylene glycol monomethyl ether acetate; cyclic carbonates such as ethylene carbonate, propylene carbonate, and vinylene carbonate; and esters such as butyl acetate and pentyl acetate.

Examples of such an acid include, but are not limited to, a mineral acid such as phosphoric acid, hydrochloric acid, perchloric acid, nitric acid, or sulfuric acid, and a salt thereof, an arylsulfonic acid such as p-toluenesulfonic acid, pyridinium p-toluenesulfonic acid (pyridinium p-toluenesulfonate), pyridinium phenolsulfonic acid, pyridinium phenolsulfonic acid, 5-sulfosalicylic acid, 4-phenolsulfonic acid, 4-chlorobenzenesulfonic acid, benzenedisulfone acid, or 1-naphthalenesulfonic acid, and a salt thereof such as a pyridinium salt, an arylcarboxylic acid such as salicylic acid, benzoic acid, hydroxybenzoic acid, or naphthalenecarboxylic acid, and a salt thereof, a chain or cyclic alkylsulfonic acid such as trifluoromethanesulfonic acid or camphorsulfonic acid, and a salt thereof, and a chain or cyclic alkylcarboxylic acid such as citric acid and a salt thereof.

Examples of such an alkaline developer include, but are not limited to, alkaline aqueous solutions such as aqueous solutions of alkali metal hydroxides such as potassium hydroxide and sodium hydroxide, aqueous solutions of quaternary ammonium hydroxides such as tetramethylammonium hydroxide tetraethylammonium hydroxide, and choline, and amine aqueous solutions such as ethanolamine, propylamine, and ethylenediamine.

The characteristic that the release layer obtained using the release agent composition of the present invention is not preferably removed by an organic solvent, an acid, or a chemical solution (alkaline developer, hydrogen peroxide solution, or the like) used in manufacture of a semiconductor element can be evaluated by the following method.

That is, a film having a thickness of 200 nm formed on a silicon wafer of 4 cm square can be immersed in 7 mL of an evaluation liquid for each silicon wafer, and evaluated by a film reduction rate (%) of the film thickness after immersion with respect to the film thickness before immersion in a case where the film thicknesses before and after immersion are compared.

The release layer obtained using the release agent composition of the present invention exhibits a low film reduction rate of usually 10% or less, 6% or less in a preferred aspect, 5% or less in a more preferred aspect, 4% or less in a still more preferred aspect, 3% or less in a still more preferred aspect, 2% or less in a still more preferred aspect, 1% or less in a further more preferred aspect, and 0% in the most preferred aspect, even after being immersed in an organic solvent, an acid, or a chemical solution (alkaline developer, hydrogen peroxide solution, or the like) used in manufacture of a semiconductor element according to such a method. Note that the film reduction rate can be calculated by the following formula.

Film reduction rate (%) = [1 - [film thickness (nm) after immersion/film thickness (nm) before immersion]] $\times$ 100

Note that, according to the above formula, in a case where the film swells and the film thickness increases, the film thickness after immersion increases more than the film thickness before immersion, and thus the film reduction rate becomes a negative value. However, the above formula does not exclude such a case and does not exclude the case from the present invention.

<<<Cleaning Agent Composition>>>

The release layer obtained using the release agent composition of the present invention can be preferably removed by a cleaning agent composition, and such a cleaning agent composition usually contains a salt and a solvent.

Preferred examples of the cleaning agent composition include cleaning agent compositions containing a quaternary ammonium salt and a solvent.

The quaternary ammonium salt is composed of a quaternary ammonium cation and an anion, and is not particularly limited as long as it is used for this type of application.

Examples of such a quaternary ammonium cation typically include tetra(hydrocarbon)ammonium cations. On the other hand, examples of an anion paired therewith include, but are not limited to, a hydroxide ion ($OH^-$); halogen ions such as a fluorine ion ($F^-$), a chlorine ion ($Cl^-$), a bromine ion ($Br^-$), and an iodine ion ($I^-$); a tetrafluoroborate ion ($BF_4^-$); and a hexafluorophosphate ion ($PF_6^-$).

In the present invention, the quaternary ammonium salt is preferably a halogen-containing quaternary ammonium salt, and more preferably a fluorine-containing quaternary ammonium salt.
In the quaternary ammonium salt, the halogen atom may be contained in the cation or the anion, but is preferably contained in the anion.
In a preferred aspect, the fluorine-containing quaternary ammonium salt is tetra(hydrocarbon)ammonium fluoride.
Specific examples of the hydrocarbon group in the tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.
In a more preferred aspect, the tetra(hydrocarbon)ammonium fluoride includes tetraalkylammonium fluoride.
Specific examples of the tetraalkylammonium fluoride include, but are not limited to, tetramethylammonium fluoride, tetraethylammonium fluoride, tetrapropylammonium fluoride, and tetrabutylammonium fluoride (also referred to as tetrabutylammonium fluoride). Among them, tetrabutylammonium fluoride is preferable.
A quaternary ammonium salt such as tetra(hydrocarbon)ammonium fluoride may be used as a hydrate. In addition, quaternary ammonium salts such as tetra(hydrocarbon)ammonium fluoride may be used alone or in combination of two or more kinds thereof.
The amount of the quaternary ammonium salt is not particularly limited as long as it dissolves in the solvent contained in the cleaning agent composition, but is usually 0.1 to 30 mass% with respect to the cleaning agent composition.
The solvent contained in the cleaning agent composition used in the present invention is not particularly limited as long as it is used for this type of application and dissolves a salt such as the quaternary ammonium salt, but from the viewpoint of obtaining a cleaning agent composition having an excellent cleaning property with excellent reproducibility, the viewpoint of obtaining a cleaning agent composition having excellent uniformity by preferably dissolving a salt such as a quaternary ammonium salt, and the like, the cleaning agent composition used in the present invention preferably contains one or two or more amide-based solvents.
Preferred examples of the amide-based solvent include an acid amide derivative represented by Formula (Z).

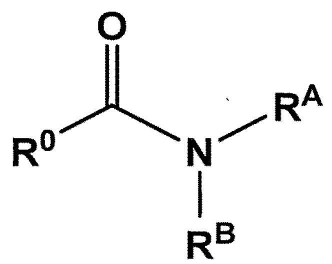

(Z)

In the formula, $R^0$ represents an ethyl group, a propyl group, or an isopropyl group, an ethyl group and an isopropyl group are preferable, and an ethyl group is more preferable. $R^A$ and $R^B$ each independently represent an alkyl group having 1 to 4 carbon atoms. The alkyl group having 1 to 4 carbon atoms may be a linear, branched, or cyclic alkyl group, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, $R^A$ and $R^B$ are preferably a methyl group or an ethyl group, and both $R^A$ and $R^B$ are more preferably methyl groups or ethyl groups, and still more preferably methyl groups.
Examples of the acid amide derivative represented by Formula (Z) include N,N-dimethylpropionamide, N,N-diethylpropionamide, N-ethyl-N-methylpropionamide, N,N-dimethyl butyric acid amide, N,N-diethyl butyric acid amide, N-ethyl-N-methyl butyric acid amide, N,N-dimethyl isobutyric acid amide, N,N-diethyl isobutyric acid amide, and N-ethyl-N-methyl isobutyric acid amide. Among them, in particular, N,N-dimethylpropionamide and N,N-dimethylisobutylamide are preferable, and N,N-dimethylpropionamide is more preferable.
The acid amide derivative represented by Formula (Z) may be synthesized by a substitution reaction between a corresponding carboxylic acid ester and an amine, or a commercially available product may be used.
Another preferred example of the amide-based solvent includes a lactam compound represented by Formula (Y).

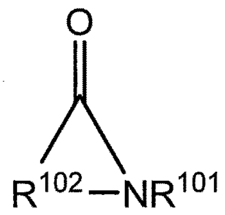

(Y)

In Formula (Y), $R^{101}$ represents a hydrogen atom or an alkyl group having 1 to 6 carbon atoms, and $R^{102}$ represents an alkylene group having 1 to 6 carbon atoms. Specific examples of the alkyl group having 1 to 6 carbon atoms include, but are not limited to, a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

Specific examples of the lactam compound represented by Formula (Y) include an α-lactam compound, a β-lactam compound, a γ-lactam compound, and a δ-lactam compound, and these compounds can be used alone or in combination of two or more thereof.

In a preferred aspect of the present invention, the lactam compound represented by Formula (Y) contains 1-alkyl-2-pyrrolidone (N-alkyl-γ-butyrolactam), in a more preferred aspect, N-methylpyrrolidone (NMP) or N-ethylpyrrolidone (NEP) is contained, and in a still more preferred aspect, N-methylpyrrolidone (NMP) is contained.

The cleaning agent composition used in the present invention may contain one or two or more other organic solvents different from the amide compound described above.

Such other organic solvents are used for this type of application, and are not particularly limited as long as they are organic solvents compatible with the amide compound described above.

Examples of preferred other solvents include, but are not limited to, alkylene glycol dialkyl ether, an aromatic hydrocarbon compound, and a cyclic structure-containing ether compound.

The amount of the other organic solvents different from the amide compound described above is usually appropriately determined to be 95 mass% or less in the solvent contained in the cleaning agent composition as long as the quaternary ammonium salt contained in the cleaning agent composition is not precipitated or separated, and is uniformly mixed with the amide compound described above.

Note that the cleaning agent composition used in the present invention may contain water as a solvent, but usually, only an organic solvent is intentionally used as a solvent from the viewpoint of avoiding corrosion of the substrate and the like. Note that, in this case, it is not denied that hydrated water of a salt or water contained in a trace amount in the organic solvent is contained in the cleaning agent composition. A water content of the cleaning agent composition used in the present invention is usually 5 mass% or less.

The characteristic that the release layer obtained using the release agent composition of the present invention is preferably removed by the cleaning agent composition can be similarly evaluated by the film reduction rate (%) according to the method described above.

The release layer obtained using the release agent composition of the present invention exhibits a high film reduction rate of usually 90% or more, 94% or more in a preferred aspect, 95% or more in a more preferred aspect, 96% or more in a still more preferred aspect, 97% or more in a still more preferred aspect, 98% or more in a still more preferred aspect, 99% or more in a further more preferred aspect, and 100% in the most preferred aspect, even after being immersed in a cleaning agent composition according to the method described above.

<Adhesive Layer>

The adhesive layer is interposed between the support substrate and the semiconductor substrate.

The adhesive layer is, for example, in contact with the semiconductor substrate. The adhesive layer is, for example, in contact with the support substrate.

The adhesive layer is not particularly limited, and is preferably a layer formed of an adhesive composition.

<<Adhesive Composition>>

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, a polysiloxane-based adhesive is preferable as the adhesive composition because it exhibits preferred adhesive ability during processing of the semiconductor substrate or the like, can be preferably released after processing, further has excellent heat resistance, and can be preferably removed by the cleaning agent composition.

In addition, the adhesive composition may be a thermosetting adhesive composition or a thermoplastic adhesive composition.

In a preferred aspect, the adhesive composition contains a polyorganosiloxane.

In addition, in another preferred aspect, the adhesive composition contains a component which is cured by a hydrosilylation reaction.

More specific embodiments of the thermosetting adhesive composition used in the present invention include the following <<First Embodiment>> to <<Third Embodiment>>.

In addition, more specific embodiments of the thermoplastic adhesive composition used in the present invention include the following <<Fourth Embodiment>>.

<<First Embodiment>>

In a preferred embodiment, the adhesive composition used in the present invention contains a polyorganosiloxane.

For example, the adhesive composition used in the present invention contains a component (A) which is cured to be an adhesive component. The adhesive composition used in the present invention may contain a component (A) which is cured to be an adhesive component and a component (B) which does not cause a curing reaction. Here, examples of the component (B) which does not cause a curing reaction include a polyorganosiloxane. Note that, in the present invention, "which does not cause a curing reaction" does not mean that all curing reactions are not caused, but means that a curing reaction occurring in the component (A) which is cured is not caused.

In still another preferred aspect, the component (A) may be a component which is cured by a hydrosilylation reaction or a polyorganosiloxane component (A') which is cured by a hydrosilylation reaction.

In another preferred aspect, as an example of the component (A'), the component (A) contains, for example, a polyorganosiloxane (a1) having an alkenyl group having 2 to 40 carbon atoms bonded to silicon atoms, a polyorganosiloxane (a2) having a Si-H group, and a platinum group metal-based catalyst (A2). Here, the alkenyl group having 2 to 40 carbon atoms may be substituted. Examples of a substituent include a halogen atom, a nitro group, a cyano group, an amino group, a hydroxy group, a carboxyl group, an aryl group, and a heteroaryl group.

In still another preferred aspect, the polyorganosiloxane component (A') which is cured by a hydrosilylation reaction contains a polysiloxane (A1) containing one or two or more units selected from the group consisting of a siloxane unit (Q unit) represented by $SiO_2$, a siloxane unit (M unit) represented by $R^1R^2R^3SiO_{1/2}$, a siloxane unit (D unit) represented by $R^4R^5SiO_{2/2}$, and a siloxane unit (T unit) represented by $R^6SiO_{3/2}$, and a platinum group metal-based catalyst (A2), and the polysiloxane (A1) contains one or two or more units selected from the group consisting of a siloxane unit (Q' unit) represented by $SiO_2$, a siloxane unit (M' unit) represented by $R^{1'}R^{2'}R^{3'}SiO_{1/2}$, a siloxane unit (D' unit) represented by $R^{4'}R^{5'}SiO_{2/2}$, and a siloxane unit (T' unit) represented by $R^{6'}SiO_{3/2}$, contains a polyorganosiloxane (a1') containing at least one selected from the group consisting of an M' unit, a D' unit, and a T' unit, and one or two or more units selected from the group consisting of a siloxane unit (Q" unit) represented by $SiO_2$, a siloxane unit (M" unit) represented by $R^{1''}R^{2''}R^{3''}SiO_{1/2}$, a siloxane unit (D" unit) represented by $R^{4''}R^{5''}SiO_{2/2}$, and a siloxane unit (T" unit) represented by $R^{6''}SiO_{3/2}$, and contains a polyorganosiloxane (a2') containing at least one selected from the group consisting of an M" unit, a D" unit, and a T" unit.

Note that (a1') is an example of (a1) and (a2') is an example of (a2).

$R^1$ to $R^6$ are groups or atoms bonded to silicon atoms, and each independently represent an alkyl group which may be substituted, an alkenyl group which may be substituted, or a hydrogen atom. Examples of a substituent include a halogen atom, a nitro group, a cyano group, an amino group, a hydroxy group, a carboxyl group, an aryl group, and a heteroaryl group.

$R^{1'}$ to $R^{6'}$ are groups bonded to silicon atoms, and each independently represent an alkyl group which may be substituted or an alkenyl group which may be substituted, but at least one of $R^{1'}$ to $R^{6'}$ is an alkenyl group which may be substituted. Examples of a substituent include a halogen atom, a nitro group, a cyano group, an amino group, a hydroxy group, a carboxyl group, an aryl group, and a heteroaryl group.

$R^{1''}$ to $R^{6''}$ are groups or atoms bonded to silicon atoms, and each independently represent an alkyl group which may be substituted or a hydrogen atom, but at least one of $R^{1''}$ to $R^{6''}$ is a hydrogen atom. Examples of a substituent include a halogen atom, a nitro group, a cyano group, an amino group, a hydroxy group, a carboxyl group, an aryl group, and a heteroaryl group.

The alkyl group may be a linear, branched, or cyclic alkyl group, but is preferably a linear or branched alkyl group, and the number of carbon atoms thereof is not particularly limited, but is usually 1 to 40, preferably 30 or less, more preferably 20 or less, and still more preferably 10 or less.

Specific examples of the linear or branched alkyl group which may be substituted include, but are not limited to, a methyl group, an ethyl group, an n-propyl group, an i-propyl group, an n-butyl group, an i-butyl group, an s-butyl group, a tert-butyl group, an n-pentyl group, a 1-methyl-n-butyl group, a 2-methyl-n-butyl group, a 3-methyl-n-butyl group,

a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n- butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the cyclic alkyl group which may be substituted include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, and bicycloalkyl groups such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 or 6.

The alkenyl group may be a linear, branched, or cyclic alkenyl group, and the number of carbon atoms thereof is not particularly limited, but is usually 2 to 40, preferably 30 or less, more preferably 20 or less, and still more preferably 10 or less.

Specific examples of the linear or branched alkenyl group which may be substituted include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the cyclic alkenyl group which may be substituted include, but are not limited to, cyclopentenyl and cyclohexenyl, and the number of carbon atoms thereof is usually 4 to 14, preferably 5 to 10, and more preferably 5 or 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A2) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more kinds of polyorganosiloxanes satisfying such conditions may be used in combination.

Examples of preferred combinations of two or more selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, in a case where two or more kinds of polyorganosiloxanes contained in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more kinds of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms thereof, and a ratio of alkenyl groups in all substituents represented by $R^{1'}$ to $R^{6'}$ is preferably 0.1 to 50.0 mol%, and more preferably 0.5 to 30.0 mol%, and the remaining $R^{1'}$ to $R^{6'}$ can be alkyl groups.

The polyorganosiloxane (a2') is composed of siloxane units in which alkyl groups and/or hydrogen atoms are bonded to silicon atoms thereof, and a ratio of hydrogen atoms in all substituents and substituent atoms represented by $R^{1''}$ to $R^{6''}$ is preferably 0.1 to 50.0 mol%, and more preferably 10.0 to 40.0 mol%, and the remaining $R^{1''}$ to $R^{6''}$ can be

alkyl groups.

In a case where the component (A) contains (a1) and (a2), in a preferred aspect of the present invention, a molar ratio of the alkenyl group contained in the polyorganosiloxane (a1) and the hydrogen atom constituting the Si-H bond contained in the polyorganosiloxane (a2) is in a range of 1.0:0.5 to 1.0:0.66.

A weight average molecular weight of the polysiloxane such as the polyorganosiloxane (a1) or the polyorganosiloxane (a2) is not particularly limited, but is usually 500 to 1,000,000, and is preferably 5,000 to 50,000 from the viewpoint of realizing the effects of the present invention with excellent reproducibility.

Note that, in the present invention, a weight average molecular weight, a number average molecular weight, and a dispersity of the polyorganosiloxane (excluding the specific compound) can be measured, for example, using a GPC apparatus (manufactured by Tosoh Corporation, EcoSEC or HLC-8320GPC) and a GPC column (manufactured by Tosoh Corporation, TSKgel SuperMultiporeHZ-N or TSKgel SuperMultiporeHZ-H) at a column temperature of 40°C, using tetrahydrofuran as an eluent (elution solvent), and using polystyrene (manufactured by Showa Denko K.K., Shodex) as a standard sample at a flow rate of 0.35 mL/min.

A viscosity of each of the polyorganosiloxane (a1) and the polyorganosiloxane (a2) is not particularly limited, but is usually 10 to 1,000,000 (mPa·s), and is preferably 50 to 10,000 (mPa·s) from the viewpoint of realizing the effects of the present invention with excellent reproducibility. Note that the viscosity of each of the polyorganosiloxane (a1) and the polyorganosiloxane (a2) is a value measured at 25°C with an E-type rotational viscometer.

The polyorganosiloxane (a1) and the polyorganosiloxane (a2) react with each other by a hydrosilylation reaction to form a film. Accordingly, a curing mechanism is different from that via, for example, a silanol group, and therefore, any siloxane does not need to have a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, platinum(II) chloride, chloroplatinic acid, a reaction product of chloroplatinic acid and monohydric alcohol, a complex of chloroplatinic acid and olefins, and platinum bisacetoacetate.

Examples of a complex of platinum and olefins include, but are not limited to, a complex of divinyltetramethyldisiloxane and platinum.

The amount of the platinum group metal-based catalyst (A2) is not particularly limited, but is usually in a range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as it can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

As an example, the adhesive composition used in the present invention may contain a component (B) which does not cause a curing reaction and serves as a release agent component together with the component (A) which is cured. Such a component (B) is contained in the adhesive composition, such that the obtained adhesive layer can be preferably released with excellent reproducibility.

Typical examples of such a component (B) include a non-curable polyorganosiloxane, and specific examples thereof include, but are not limited to, an epoxy group-containing polyorganosiloxane, a methyl group-containing polyorganosiloxane, and a phenyl group-containing polyorganosiloxane.

In addition, examples of the component (B) include a polydimethylsiloxane. The polydimethylsiloxane may be modified. Examples of the polydimethylsiloxane which may be modified include, but are not limited to, an epoxy group-containing polydimethylsiloxane, an unmodified polydimethylsiloxane, and a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

A weight average molecular weight of the polyorganosiloxane as the component (B) is not particularly limited, but is usually 100,000 to 2,000,000, and is preferably 200,000 to 1,200,000 and more preferably 300,000 to 900,000 from the viewpoint of realizing the effects of the present invention with excellent reproducibility. In addition, a dispersity

thereof is not particularly limited, but is usually 1.0 to 10.0, and is preferably 1.5 to 5.0 and more preferably 2.0 to 3.0 from the viewpoint of realizing preferred release with excellent reproducibility. Note that the weight average molecular weight and the dispersity can be measured by the above methods related to the polyorganosiloxane of the component (A).

A viscosity of the polyorganosiloxane as the component (B) is not particularly limited, but is usually 1,000 to 2,000,000 $mm^2/s$. Note that a value of the viscosity of the polyorganosiloxane as the component (B) is expressed by a kinematic viscosity, and is a centistoke (cSt) = $mm^2/s$. The value can also be determined by dividing the viscosity (mPa·s) by the density ($g/cm^3$). That is, the value can be determined from the viscosity and the density measured with an E-type rotational viscometer measured at 25°C, and can be calculated from the equation of kinematic viscosity ($mm^2/s$) = viscosity (mPa·s)/density ($g/cm^3$).

Examples of the epoxy group-containing polyorganosiloxane include an epoxy group-containing polyorganosiloxane containing a siloxane unit ($D^{10}$ unit) represented by $R^{11}R^{12}SiO_{2/2}$.

$R^{11}$ is a group bonded to a silicon atom and represents an alkyl group, $R^{12}$ is a group bonded to a silicon atom and represents an epoxy group or an organic group containing an epoxy group, and specific examples of the alkyl group include the examples described above.

The epoxy group in the organic group containing an epoxy group may be an independent epoxy group without being condensed with other rings, or may be an epoxy group forming a condensed ring with other rings, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the siloxane unit ($D^{10}$ unit) described above, but may contain a Q unit, an M unit, and/or a T unit in addition to the $D^{10}$ unit.

In a preferred aspect of the present invention, specific examples of the epoxy group-containing polyorganosiloxane include a polyorganosiloxane containing only a $D^{10}$ unit, a polyorganosiloxane containing a $D^{10}$ unit and a Q unit, a polyorganosiloxane containing a $D^{10}$ unit and an M unit, a polyorganosiloxane containing a $D^{10}$ unit and a T unit, a polyorganosiloxane containing a $D^{10}$ unit, a Q unit, and an M unit, a polyorganosiloxane containing a $D^{10}$ unit, an M unit, and a T unit, and a polyorganosiloxane containing a $D^{10}$ unit, a Q unit, an M unit, and a T unit.

The epoxy group-containing polyorganosiloxane is preferably an epoxy group-containing polydimethylsiloxane having an epoxy value of 0.1 to 5. In addition, a weight average molecular weight thereof is not particularly limited, but is usually 1,500 to 500,000, and is preferably 100,000 or less from the viewpoint of suppressing precipitation in the composition.

Specific examples of the epoxy group-containing polyorganosiloxane include, but are not limited to, an epoxy group-containing polyorganosiloxane represented by each of Formulas (E1) to (E3).

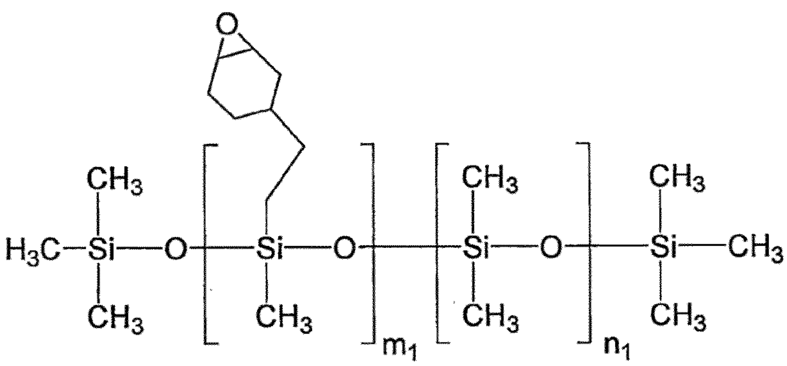

(E1)

($m_1$ and $n_1$ represent the numbers of repeating units and are positive integers.)

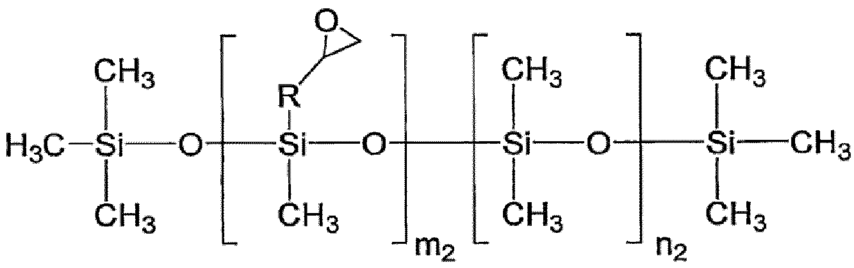

(E2)

($m_2$ and $n_2$ represent the numbers of repeating units and are positive integers, and R is an alkylene group having 1 to 10 carbon atoms.)

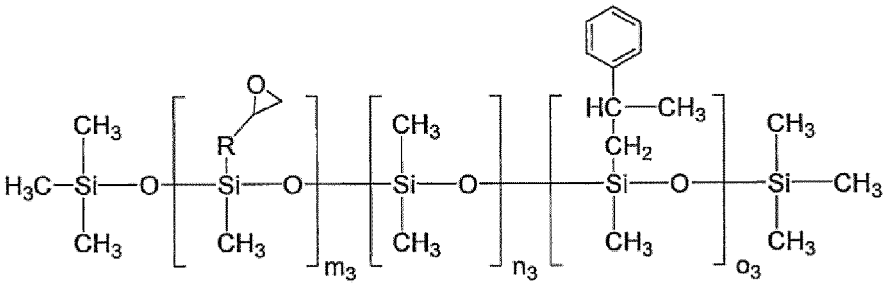

(E3)

($m_3$, $n_3$, and $o_3$ represent the numbers of repeating units and are positive integers, and R is an alkylene group having 1 to 10 carbon atoms.)

Examples of the methyl group-containing polyorganosiloxane include a methyl group-containing polyorganosiloxane containing a siloxane unit ($D^{200}$ unit) represented by $R^{210}R^{220}SiO_{2/2}$, and preferably a methyl group-containing polyorganosiloxane containing a siloxane unit ($D^{20}$ unit) represented by $R^{21}R^{21}SiO_{2/2}$.

$R^{210}$ and $R^{220}$ are groups bonded to silicon atoms, each independently represent an alkyl group, at least one of them is a methyl group, and specific examples of the alkyl group are the examples described above.

$R^{21}$ is a group bonded to a silicon atom and represents an alkyl group, and specific examples of the alkyl group include the examples described above. Among them, $R^{21}$ is preferably a methyl group.

In the present invention, preferred examples of the methyl group-containing polyorganosiloxane include, but are not limited to, a polydimethylsiloxane.

The methyl group-containing polyorganosiloxane contains the siloxane unit ($D^{200}$ unit or $D^{20}$ unit) described above, but may contain a Q unit, an M unit, and/or a T unit in addition to the $D^{200}$ unit and the $D^{20}$ unit.

In an aspect of the present invention, specific examples of the methyl group-containing polyorganosiloxane include a polyorganosiloxane containing only a $D^{200}$ unit, a polyorganosiloxane containing a $D^{200}$ unit and a Q unit, a polyorganosiloxane containing a $D^{200}$ unit and an M unit, a polyorganosiloxane containing a $D^{200}$ unit and a T unit, a polyorganosiloxane containing a $D^{200}$ unit, a Q unit, and an M unit, a polyorganosiloxane containing a $D^{200}$ unit, an M unit, and a T unit, and a polyorganosiloxane containing a $D^{200}$ unit, a Q unit, an M unit, and a T unit.

In a preferred aspect of the present invention, specific examples of the methyl group-containing polyorganosiloxane include a polyorganosiloxane containing only a $D^{20}$ unit, a polyorganosiloxane containing a $D^{20}$ unit and a Q unit, a polyorganosiloxane containing a $D^{20}$ unit and an M unit, a polyorganosiloxane containing a $D^{20}$ unit and a T unit, a polyorganosiloxane containing a $D^{20}$ unit, a Q unit, and an M unit, a polyorganosiloxane containing a $D^{20}$ unit, an M unit, and a T unit, and a polyorganosiloxane containing a $D^{20}$ unit, a Q unit, an M unit, and a T unit.

Specific examples of the methyl group-containing polyorganosiloxane include, but are not limited to, a methyl group-containing polyorganosiloxane represented by of Formula (M1).

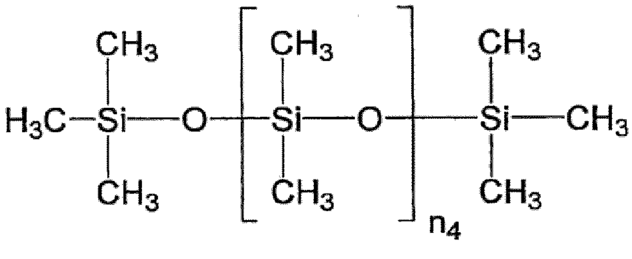

(M1)

($n_4$ represents the number of repeating units and is a positive integer.)

Examples of the phenyl group-containing polyorganosiloxane include a phenyl group-containing polyorganosiloxane containing a siloxane unit ($D^{30}$ unit) represented by $R^{31}R^{32}SiO_{2/2}$.

$R^{31}$ is a group bonded to a silicon atom and represents a phenyl group or an alkyl group, and $R^{32}$ is a group bonded to a silicon atom and represents a phenyl group. Specific examples of the alkyl group include the examples described above, and a methyl group is preferable.

The phenyl group-containing polyorganosiloxane contains the siloxane unit ($D^{30}$ unit) described above, but may contain a Q unit, an M unit, and/or a T unit in addition to the $D^{30}$ unit.

In a preferred aspect of the present invention, specific examples of the phenyl group-containing polyorganosiloxane include a polyorganosiloxane containing only a $D^{30}$ unit, a polyorganosiloxane containing a $D^{30}$ unit and a Q unit, a polyorganosiloxane containing a $D^{30}$ unit and an M unit, a polyorganosiloxane containing a $D^{30}$ unit and a T unit, a polyorganosiloxane containing a $D^{30}$ unit, a Q unit, and an M unit, a polyorganosiloxane containing a $D^{30}$ unit, an M unit, and a T unit, and a polyorganosiloxane containing a $D^{30}$ unit, a Q unit, an M unit, and a T unit.

Specific examples of the phenyl group-containing polyorganosiloxane include, but are not limited to, a methyl group-containing polyorganosiloxane represented by of Formula (P1) or (P2).

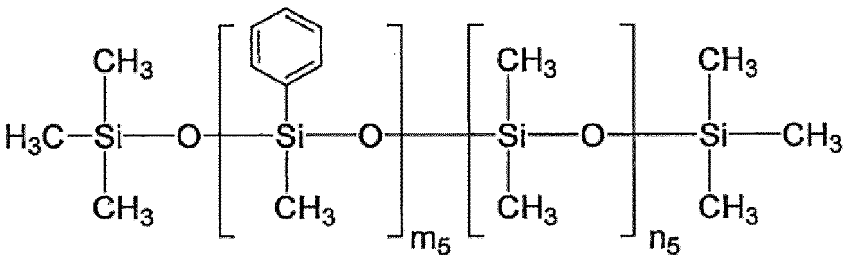

(P1)

($m_5$ and $n_5$ represent the numbers of repeating units and are positive integers.)

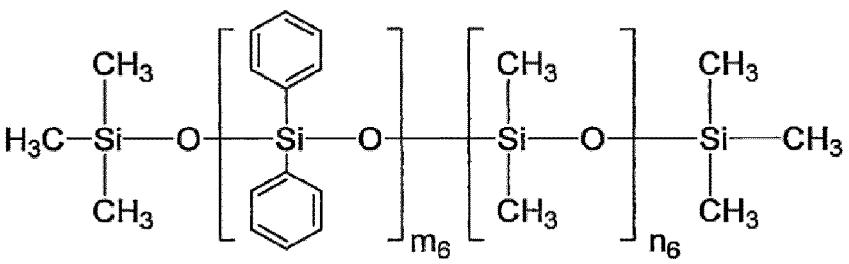

(P2)

($m_6$ and $n_6$ represent the numbers of repeating units and are positive integers.)

The polyorganosiloxane as the release agent component (B) may be a commercially available product or a synthetic product.

Examples of the commercially available product of the polyorganosiloxane include, but are not limited to, WACKERSILICONE FLUID AK series (AK50, AK 350, AK 1000, AK 10000, and AK 1000000) and GENIOPLAST GUM, which are products manufactured by Wacker Chemie AG, dimethyl silicone oils (KF-96L, KF-96A, KF-96, KF-96H, KF-69, KF-965, and KF-968) and a cyclic dimethyl silicone oil (KF-995) manufactured by Shin-Etsu Chemical Co., Ltd.; epoxy group-containing polyorganosiloxanes (trade names: CMS-227 and ECMS-327) manufactured by Gelest Inc., epoxy group-containing polyorganosiloxanes (KF-101, KF-1001, KF-1005, and X-22-343) manufactured by Shin-Etsu Chemical Co., Ltd., and an epoxy group-containing polyorganosiloxane (BY16-839) manufactured by Dow Corning Corporation; and phenyl group-containing polyorganosiloxanes (PMM-1043, PMM-1025, PDM-0421, and PDM-0821) manufactured by Gelest Inc., a phenyl group-containing polyorganosiloxane (KF50-3000CS) manufactured by Shin-Etsu Chemical Co., Ltd., and phenyl group-containing polyorganosiloxanes (TSF431 and TSF433) manufactured by MOMENTIVE.

In one aspect, the adhesive composition used in the present invention contains a component (B) which does not cause a curing reaction together with the component (A) which is cured, and in another aspect, a polyorganosiloxane is contained as the component (B).

As an example, the adhesive composition used in the present invention can contain the component (A) and the component (B) at any ratio, but in consideration of a balance between adhesiveness and releasability, a ratio of the component (A) to the component (B) is preferably 99.995:0.005 to 30:70 and more preferably 99.9:0.1 to 75:25 in terms

of mass ratio [(A):(B)].

That is, in a case where the polyorganosiloxane component (A') which is cured by a hydrosilylation reaction is contained, a ratio of the component (A') to the component (B) is preferably 99.995:0.005 to 30:70 and more preferably 99.9:0.1 to 75:25 in terms of mass ratio [(A'):(B)].

A viscosity of the adhesive composition used in the present invention is not particularly limited, but is usually 500 to 20,000 mPa·s and preferably 1,000 to 10,000 mPa·s at 25°C.

<<Second Embodiment>>

As a preferred embodiment, the adhesive composition used in the present invention contains, for example, a curable adhesive material described below, or the curable adhesive material and a release additive.

The curable adhesive material is selected from, for example, a polyarylene oligomer, a cyclic olefin oligomer, an aryl cyclobutene oligomer, a vinyl aromatic oligomer, and a mixture thereof.

Examples of the release additive include a polyether compound.

The polyether compound preferably contains a terminal group selected from the group consisting of hydroxy, alkoxy, aryloxy, and a mixture thereof.

The polyether compound is preferably selected from polyethylene glycol, polypropylene glycol, poly(1,3-propanediol), polybutylene glycol, poly(tetrahydrofuran), an ethylene glycol-propylene glycol copolymer, and a mixture thereof.

The release additive is preferably selected from the group consisting of a polyalkylene oxide homopolymer and a polyalkylene oxide copolymer.

As the adhesive composition of the second embodiment, for example, a temporary binding composition described in JP 2014-150239 A can be used.

The adhesive composition of the second embodiment will be described in more detail below.

The adhesive composition used in the present invention contains a curable adhesive material and a release additive. Usually, the curable adhesive material has a modulus of > 1 GPa when cured. Examples of the curable adhesive material include, but are not limited to, a polyarylene oligomer, a cyclic olefin oligomer, an aryl cyclobutene oligomer, a vinyl aromatic oligomer, and a mixture thereof. The curable adhesive material may be substituted with any preferred moiety, such as a fluorine-containing group, to provide additional hydrophobicity, but this is limited to only a case where such a moiety does not adversely affect the mechanical properties of the curable adhesive material. Preferably, the curable adhesive material is selected from a polyarylene oligomer, a cyclic olefin oligomer, an aryl cyclobutene oligomer, a vinyl aromatic oligomer, and a mixture thereof, and more preferably from one or more of an aryl cyclobutene oligomer, a vinyl aromatic oligomer, or a mixture thereof. When a mixture of different curable adhesive materials is used in the present invention, such materials are selected to cure the curable adhesive materials with each other during the curing process. In a case where a mixture of different curable materials is used, these curable materials are used at a mass ratio of 99:1 to 1:99, preferably 95:5 to 5:95, more preferably 90:10 to 10:90, and still more preferably 75:25 to 25:75.

A wide variety of polyarylene oligomers may be used in the present invention. As used in the present specification, the term "polyarylene" includes a polyarylene ether. A preferred polyarylene oligomer may be synthesized from a precursor, for example, an ethynyl aromatic compound of the following formula:

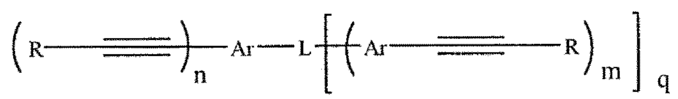

(I)

in the formula, each Ar is an aromatic group or an inert substituted aromatic group; Rs are each independently hydrogen, alkyl, aryl, or an inert substituted alkyl or aryl group; L is a covalent bond or a group linking one Ar to at least one other Ar; n and m are integers of at least 2; and q is an integer of at least 1. As such, the ethynyl aromatic compound usually contains four or more ethynyl groups (for example, a tetraethynyl aromatic compound).

A preferred polyarylene oligomer for use in the temporary binding composition as the adhesive composition of the second embodiment may contain a polymer containing a polymerization unit:

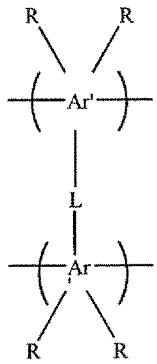

(II)

in the formula, Ar' is a residue of a (C≡C)n-Ar or Ar-(C≡C)m moiety of a reaction product, and R, L, n, and m are as defined above. A polyarylene copolymer useful in the present invention includes monomers having the following formula as polymerization units:

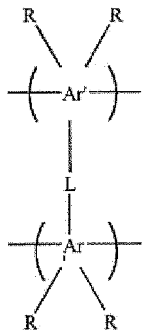

and

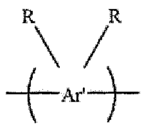

(III)

in the formula, Ar' and R are as defined above.

As an exemplary polyarylene, examples of Ar-L-Ar include, but are not limited to, biphenyl; 2,2-diphenylpropane; 9,9'-diphenylfluorene; 2,2-diphenylhexafluoropropane; diphenyl sulfide; oxydiphenylene; diphenyl ether; bis(phenylene)diphenylsilane; bis(phenylene)phosphine oxide; bis(phenylene)benzene; bis(phenylene)naphthalene; bis(phenylene)anthracene; thiodiphenylene; 1,1,1-triphenyleneethane; 1,3,5-triphenylenebenzene; 1,3,5-(2-phenylene-2-propyl)benzene; 1,1,1-triphenylenemethane; 1,1,2,2-tetraphenylene-1,2-diphenylethane; bis(1,1-diphenyleneethyl)benzene; 2,2'-diphenylene-1,1,1,3,3,3-hexafluoropropane; 1,1-diphenylene-1-phenylethane;naphthalene; anthracene; and bis(phenylene)naphthacene; and more preferably include biphenylene; naphthylene; p,p'-(2,2-diphenylenepropane) (or $C_6H_4$-$C(CH_3)_2$-$C_6H_4$-); p,p'-(2,2-diphenylene-1,1,1,3,3,3 hexafluoropropene); and (-$C_6H_4$-$C(CF_3)_2$-$C_6H_4$-). Examples of the useful bisphenyl derivative include 2,2-diphenylpropane; 9,9'-diphenylfluorene; 2,2-diphenylhexafluoropropane; diphenyl sulfide; diphenyl ether; bis(phenylene)diphenylsilane; bis(phenylene)phosphine oxide; bis(phenylene)benzene; bis(phenylene)naphthalene; bis(phenylene)anthracene; and bis(phenylene)naphthacene.

The polyarylene precursor monomer may be prepared by various methods known in the art, for example, a step (a) of selectively halogenating, and preferably brominating, polyphenols (preferably bisphenols) in a solvent (where each phenolic ring is halogenated with one halogen in one of two ortho positions to a phenolic hydroxy group), a step (b) of converting the phenolic hydroxyl on the obtained poly(ortho-halophenol), preferably in a solvent, into a leaving group (for example, trifluoromethanesulfonate ester prepared from trifluoromethanesulfonyl halide or trifluoromethanesulfonic anhydride) such as a sulfonate ester that is reactive and substituted with a terminal ethynyl compound, and a step of (c) reacting the reaction product of the step (b) with an ethynyl-containing compound or ethynyl synthon in the presence of an arylethynylation catalyst, and preferably a palladium catalyst, and an acid acceptor to simultaneously substitute halogen and trifluoromethylsulfonate with an ethynyl-containing group (for example, acetylene, phenylacetylene, substituted phenylacetylene, or substituted acetylene). A further description of this synthesis is provided in WO 97/10193 A (Babb).

The ethynyl aromatic monomer of Formula (I) is useful for preparing a polymer of either Formula (II) or (III). Polymerization of the ethynyl aromatic monomer is well within the capabilities of those skilled in the art. Specific conditions of the polymerization depend on a variety of factors including a specific ethynyl aromatic monomer (one kind or plural kinds) to be polymerized and desired properties of the obtained polymer, but general conditions of the polymerization are detailed in WO 97/10193 A (Babb).

Polyarylenes particularly preferred for use in the present invention include SiLK (trademark) semiconductor

dielectric (available from Dow Electronic Materials, Marlborough, Massachusetts). Examples of other particularly preferred polyarylenes include polyarylenes disclosed in WO 00/31183 A, WO 98/11149 A, WO 97/10193 A, WO 91/09081 A, EP 755957 A, US 5,115,082, US 5,155,175, US 5,179,188, US 5,874,516, and US 6,093,636.

A preferred cyclic olefin material is poly(cyclic olefin), which may be thermoplastic and may have a weight average molecular weight (Mw) of preferably 2,000 to 200,000 daltons, more preferably 5,000 to 100,000 daltons, and still more preferably 2,000 to 50,000 daltons. The preferred poly(cyclic olefin) has a softening temperature (melt viscosity at 3,000 PaS) of preferably at least 100°C, and more preferably at least 140°C. The preferred poly(cyclic olefin) also has a glass transition temperature (Tg) of preferably at least 60°C, more preferably 60 to 200°C, and most preferably 75 to 160°C.

The preferred poly(cyclic olefin) contains a repeating monomer of a cyclic olefin and an acyclic olefin or a ring-opened polymer based on a cyclic olefin. A preferred cyclic olefin for used in the present invention is selected from a norbornene-based olefin, a tetracyclododecene-based olefin, a dicyclopentadiene-based olefin, Diels-Alder polymer, for example, those derived from furan and maleimide, and a derivative thereof. Examples of the derivative include alkyl (preferably $C_1$-$C_{20}$ alkyl and more preferably $C_1$-$C_{10}$ alkyl), alkylidene (preferably $C_1$-$C_{20}$ alkylidene and more preferably $C_1$-$C_{10}$ alkylidene), aralkyl (preferably $C_6$-$C_{30}$ aralkyl and more preferably $C_6$-$C_{18}$ aralkyl), cycloalkyl (preferably $C_3$-$C_{30}$ cycloalkyl and more preferably $C_3$-$C_{18}$ cycloalkyl), ether, acetyl, aromatic, ester, hydroxy, alkoxy, cyano, amide, imide, and silyl-substituted derivatives. Examples of a particularly preferred cyclic olefin for use in the present invention include those selected from the following and combinations thereof:

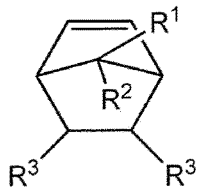 , 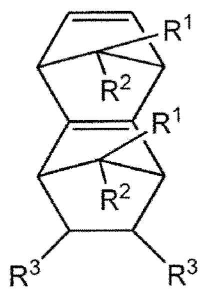 , 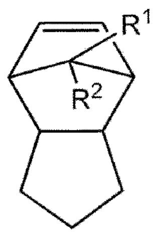 , 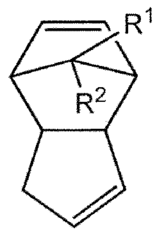 , 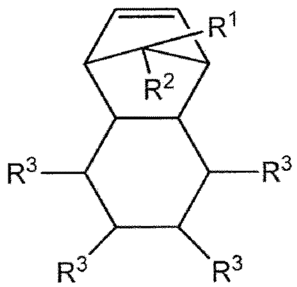 ,

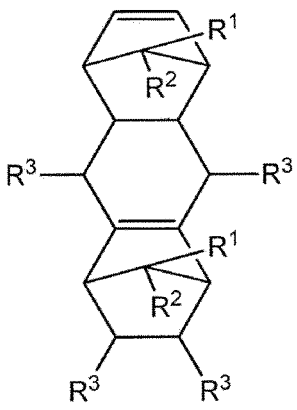 , 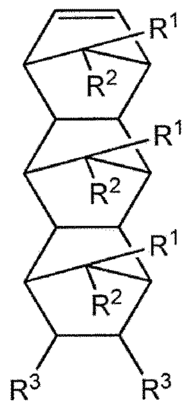 ,

in the formula, each of $R^1$ and $R^2$ is independently selected from H and an alkyl group (preferably $C_1$-$C_{20}$ alkyl and more preferably $C_1$-$C_{10}$ alkyl), and each $R^3$ is independently selected from H, a substituted and unsubstituted aryl group (preferably $C_6$-$C_{18}$ aryl), an alkyl group (preferably $C_1$-$C_{20}$ alkyl and more preferably $C_1$-$C_{10}$ alkyl), a cycloalkyl group (preferably a $C_3$-$C_{30}$ cycloalkyl group and more preferably a $C_3$-$C_{18}$ cycloalkyl group,), an aralkyl group (preferably $C_6$-$C_{30}$ aralkyl and more preferably a $C_6$-$C_{18}$ aralkyl group, for example benzyl, phenethyl, phenylpropyl, or the like), an ester group, an ether group, an acetyl group, an alcohol (preferably $C_1$-$C_{10}$ alcohol), an aldehyde group, a ketone, a nitrile, and a combination thereof.

A preferred acyclic olefin is selected from branched and unbranched $C_2$-$C_{20}$ alkenes, (preferably $C_2$-$C_{10}$ alkenes) . More preferably, the acyclic olefin has a structure $(R^4)_2C=C(R^4)_2$, where each $R^4$ is independently selected from H and an alkyl group (preferably $C_1$-$C_{20}$ alkyl and more preferably $C_1$-$C_{10}$ alkyl). Examples of a particularly preferred acyclic olefin for use in the present invention include those selected from ethene, propene, and butene, and ethene is most preferable.

A method for producing a cyclic olefin copolymer is known in the art. For example, the cyclic olefin copolymer

can be produced by chain polymerization of a cyclic monomer and an acyclic monomer. When norbornene reacts with ethene under these conditions, an ethene-norbornene copolymer containing alternating norbornanediyl and ethylene units is obtained. Examples of the copolymer produced by this method include polymers available under TOPASTM (trademark) (manufactured by Topas Advanced Polymers GmbH) and APELTM (trademark) (manufactured by Mitsui Chemicals, Inc.). A preferred method for producing these copolymers is disclosed in US 6,008,298. A cycloolefin copolymer can also be produced by performing ring-opening metathesis polymerization of various cyclic monomers and then performing hydrogenation. The polymer by this type of polymerization can be conceptually considered as a copolymer of ethene and a cyclic olefin monomer (for example, an alternating unit of ethylene and cyclopentane-1,3-diyl). Examples of the copolymer produced by the ring-opening method include copolymers provided under ZEONORTM (trademark) (manufactured by Zeon Chemicals L.P.) and ARTONTM (trademark) (manufactured by JSR Corporation). A preferred method for producing these copolymers by the ring-opening method is disclosed in US 5,191,026.

The aryl cyclobutene oligomer useful as a curable adhesive material of the present invention is well known in the art. Examples of a preferred aryl cyclobutene oligomer include, but are not limited to, oligomers having the following formula:

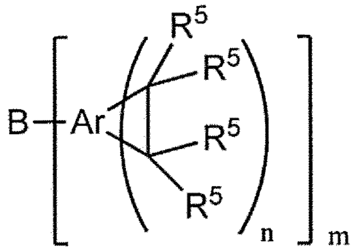

in the formula, B is an n-valent linking group; Ar is a polyvalent aryl group, and a carbon atom of a cyclobutene ring is bonded to an adjacent carbon atom on the same aromatic ring of Ar; m is an integer of 1 or more; n is an integer of 1 or more; and; $R^5$ is a monovalent group. Preferably, the polyvalent aryl group Ar may be composed of 1 to 3 aromatic carbocyclic or heteroaromatic rings. The aryl group preferably contains a single aromatic ring, and more preferably a phenyl ring. The aryl group is optionally substituted with one to three groups selected from ($C_1$-$C_6$) alkyl, tri ($C_1$-$C_6$) alkylsilyl, ($C_1$-$C_6$) alkoxy, and halo, preferably one or more of ($C_1$-$C_6$) alkyl, tri ($C_1$-$C_3$) alkylsilyl, ($C_1$-$C_3$) alkoxy, and chloro, and more preferably one or more of ($C_1$-$C_3$) alkyl, tri ($C_1$-$C_3$) alkylsilyl, and ($C_1$-$C_3$) alkoxy. The aryl group is preferably unsubstituted. n = 1 or 2 is preferable, and n = 1 is more preferable. m = 1 to 4 is preferable, m = 2 to 4 is more preferable, and m = 2 is still more preferable. Preferably, $R^5$ is selected from H and ($C_1$-$C_6$) alkyl, and more preferably H and ($C_1$-$C_3$) alkyl. Preferably, B contains one or more carbon-carbon double bonds (ethylenically unsaturated). A preferred monovalent B group preferably has a formula -[C($R^{10}$)=C$R^{11}$]xZ, where $R^{10}$ and $R^{11}$ are independently selected from hydrogen, ($C_1$-$C_6$) alkyl, and aryl; Z is selected from hydrogen, ($C_1$-$C_6$) alkyl, aryl, siloxanyl, and -$CO_2R^{12}$; each $R^{12}$ is independently selected from H, ($C_1$-$C_6$) alkyl, aryl, aralkyl, and alkaryl; and x = 1 or 2. Preferably, $R^{10}$ and $R^{11}$ are independently selected from H, ($C_1$-$C_3$) alkyl, and aryl, and more preferably selected from H and ($C_1$-$C_3$) alkyl. $R^{12}$ is preferably ($C_1$-$C_3$) alkyl, aryl, or aralkyl. Z is preferably siloxyl. A preferred siloxyl group has a formula -[Si($R^{13}$)$_2$-O]p-Si($R^{13}$)$_2$-, where each $R^{13}$ is independently selected from H, ($C_1$-$C_6$) alkyl, aryl, aralkyl, and alkaryl; and p is an integer of 1 or more. $R^{13}$ is selected from ($C_1$-$C_3$) alkyl, aryl, and aralkyl. Examples of a preferred aralkyl group include benzyl, phenethyl, and phenylpropyl.

Preferably, the aryl cyclobutene oligomer includes one or more oligomers of the following formula:

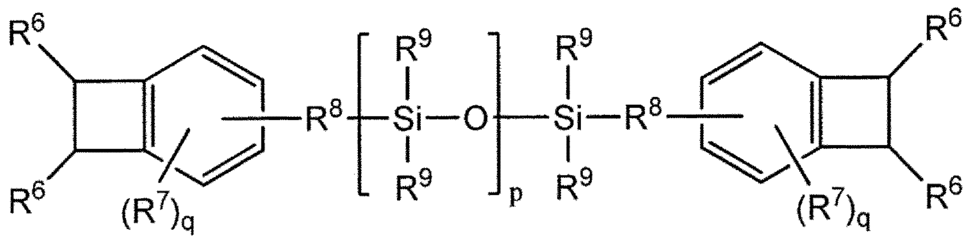

in the formula, each $R^6$ is independently selected from H and ($C_1$-$C_6$) alkyl, and preferably selected from H and ($C_1$-$C_3$) alkyl; each $R^7$ is independently selected from ($C_1$-$C_6$) alkyl, tri ($C_1$-$C_6$) alkylsilyl, ($C_1$-$C_6$) alkoxy, and halo; each $R^8$ is independently a divalent ethylenically unsaturated organic group; each $R^9$ is independently selected from H, ($C_1$-$C_6$) alkyl, aralkyl, and phenyl; p is an integer of 1 or more; and q is an integer of 0 to 3. It is preferable that each $R^6$ is

independently selected from H and ($C_1$-$C_3$) alkyl, and it is more preferable that each $R^6$ is H. Each R7 is independently selected from ($C_1$-$C_6$) alkyl, tri ($C_1$-$C_3$) alkylsilyl, ($C_1$-$C_3$) alkoxy, and chloro, and more preferably selected from ($C_1$-$C_3$) alkyl, tri ($C_1$-$C_3$) alkylsilyl, and ($C_1$-$C_3$) alkoxy. It is preferable that each $R^8$ is independently selected from ($C_2$-$C_6$) alkyl, and it is more preferable that each $R^8$ is -CH=CH-. It is preferable that each $R^9$ is independently selected from ($C_1$-$C_3$) alkyl, and it is more preferable that each $R^9$ is methyl. p = 1 to 5 is preferable, p = 1 to 3 is more preferable, and p = 1 is still more preferable. It is preferable that q = 0. As a particularly preferred aryl cyclobutene oligomer, 1,3-bis(2-bicyclo[4.2.0]octa-1,3,5-trien-3-ylethenyl)-1,1,3,3-tetramethyldisiloxane ("DVS-bisBCB") has the following formula.

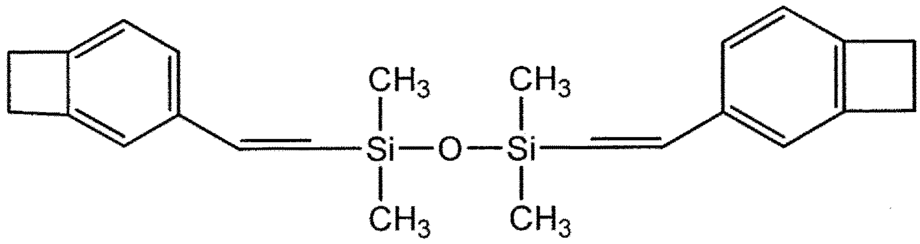

An aryl cyclobutene oligomer can be prepared by any preferred means, for example, any means described in US 4,812,588; US 5,136,069; US 5,138,081, and WO 94/25903 A. A preferred aryl cyclobutene oligomer is also commercially available under CYCLOTENE (trademark) available from Dow Electronic Materials. The aryl cyclobutene oligomer may be used as it is or may be further purified by any preferred means.

A vinyl aromatic oligomer that can be cured may be used as the curable adhesive material in the present invention. Such a vinyl aromatic oligomer is usually an oligomer of one or more reactive ethylenically unsaturated comonomers and vinyl aromatic monomers. Preferably, the vinyl aromatic monomer contains one vinyl group. A preferred vinyl aromatic monomer is an unsubstituted vinyl aromatic monomer and a substituted vinyl aromatic monomer, where one or more hydrogens are substituted with a substituent selected from the group consisting of ($C_1$-$C_6$) alkyl, ($C_1$-$C_6$) alkoxy, halo, and amino. An exemplary vinyl aromatic monomer is not limited, and examples thereof include styrene, vinyltoluene, vinylxylene, vinylanisole, vinyldimethoxybenzene, vinylaniline, halostyrenes such as fluorostyrene, α-methylstyrene, β-methoxystyrene, ethylvinylbenzene, vinylpyridine, vinylimidazole, and vinylpyrrole, and a mixture thereof. A preferred vinyl aromatic monomer is styrene, vinyltoluene, vinylxylene, vinylanisole, ethylvinylbenzene, or a mixture thereof. A preferred reactive comonomer contains, in addition to an olefinic (or ethylenically unsaturated) moiety used to form a vinyl aromatic oligomer, a reactive moiety, that is, a moiety capable of being further polymerized (or crosslinked) after formation of a vinyl aromatic oligomer, such as an allyl moiety or a vinyl group. Such a reactive comonomer may be preferably any asymmetric diene or triene that can be further polymerized by Diels-Alder reaction after oligomerization with a vinyl aromatic monomer. More preferably, the reactive comonomer contains an allyl moiety in addition to the ethylenic unsaturation used to form a vinyl aromatic oligomer, and still more preferably contains an allyl ester moiety in addition to this ethylenic unsaturation. Examples of the reactive comonomer useful for forming a vinyl aromatic oligomer include, but are not limited to, vinylcyclohexene, a vinyl ether, an asymmetric diene or triene, for example, a terpene monomer, dicyclopentadiene, diallyl maleate, allyl acrylate, allyl methacrylate, allyl cinnamate, diallyl fumarate, allyl tiglate, or divinylbenzene, and a mixture thereof. A preferred reactive comonomer is diallyl maleate, allyl acrylate, allyl methacrylate, allyl cinnamate, diallyl fumarate, and a mixture thereof, and more preferably diallyl maleate, allyl methacrylate, and a mixture thereof. Examples of the terpene monomer include, but are not limited to, limonene, dipentene, and myrcene. It will be appreciated by those skilled in the art that one or more second comonomers may also be used to form a vinyl aromatic oligomer. These second comonomers are ethylenically unsaturated but do not contain a reactive moiety. Examples of the second comonomer include, but are not limited to, (meth)acrylic acid, (meth)acrylamide, (C1-C10) alkyl (meth)acrylate, aromatic (meth)acrylate, a substituted ethylene monomer, and a poly(alkylene oxide) monomer.

A molar ratio of the vinyl aromatic monomer:comonomer in such a vinyl aromatic oligomer is preferably 99:1 to 1:99, more preferably 95:5 to 5:95, and still more preferably 90:10 to 10:90. Such a vinyl aromatic oligomer may be prepared by any preferred method, for example, by any of the methods known in the art. Usually, a vinyl aromatic oligomer is prepared by free radical polymerization of a vinyl aromatic monomer and a comonomer. A preferred vinyl aromatic oligomer contains an unreacted allyl moiety capable of further curing such an oligomer.

A wide variety of materials may be used as the release additives in the temporary binding composition, but these materials do not react with the adhesive material under the conditions of storage and use, and are non-curable under the conditions used to cure the adhesive material. In addition, the release additive should be compatible with the temporary binding composition, that is, the release additive should be dispersible, miscible or otherwise substantially compatible with the adhesive material and any other components used in the temporary binding composition, such as an organic solvent. In a case where an organic solvent (or a mixed solvent system) is used in the temporary binding

composition, the release additive and the curable adhesive material should be soluble in such a solvent. The release additive in the present invention is sufficiently non-volatile so that it does not substantially evaporate under the conditions of use, that is, it does not substantially evaporate during a deposition step, for example, spin coating, or any subsequent heating step used to remove the organic solvent or to cure the adhesive material. In a case where a film or layer of the temporary binding composition is cast, for example, by spin coating, much (or all) of the solvent evaporates. The release additive is preferably soluble in any organic solvent used, but is not completely soluble in the curable adhesive material. The release additive is more hydrophilic than a cured adhesive material. Without being bound by theory, it is considered that when the adhesive material is cured, the release additive phase separates and preferentially migrates towards an active surface of a wafer (a surface that is more hydrophilic than a carrier surface). The use of a preferred hydrophilic moiety in the release additive can implement complete dispersion, or preferably dissolution, of the release additive in the temporary binding composition, and can implement phase separation of the release additive during curing of the adhesive material with movement of the release additive towards the more hydrophilic surface. Any material that does not phase-separate from the adhesive material during curing does not function as the release additive according to the present invention.

In general, the release additive may contain one or more relatively hydrophilic moieties, such as one or more oxygen, nitrogen, phosphorus, and sulfur-containing moieties. Examples of a preferred release additive include, but are not limited to, an ether, an ester, a carboxylate, an alcohol, a thioether, a thiol, an amine, an imine, an amide, a phosphate ester, a sulfonate ester, and a mixture thereof. Preferably, the release additive contains one or more polar end groups, which contain one or more of oxygen, nitrogen, and sulfur, and preferably oxygen. Examples of the polar end group include alkoxy, aryloxy, hydroxy, carboxylate, alkoxycarbonyl, mercapto, alkylthio, a primary amine, a secondary amine, and a tertiary amines, and a preferred end group is selected from ($C_1$-$C_6$) alkoxy, ($C_6$-$C_{10}$) aryloxy, hydroxy, carboxylate, ($C_1$-$C_6$) alkoxycarbonyl, mercapto, ($C_1$-$C_6$) alkylthio, amino, ($C_1$-$C_6$) alkylamino, and di ($C_1$-$C_6$) alkylamino, more preferably selected from ($C_1$-$C_6$) alkoxy, ($C_6$-$C_{10}$) aryloxy, hydroxy, carboxylate, and (C1-C6) alkoxycarbonyl, and still more preferably selected from ($C_1$-$C_6$) alkoxy, hydroxy, carboxylate, and ($C_1$-$C_6$) alkoxycarbonyl. A particularly preferred polar end group is selected from hydroxy, methoxy, ethoxy, propoxy, butoxy, carboxyl, and acetoxy. Preferably, the release additive does not contain silicon.

A preferred release additive has a number average molecular weight (Mn) of ≤ 10,000 daltons, preferably ≤ 7,500 daltons, and more preferably ≤ 7,000 daltons. The release additive has a sufficient minimum molecular weight (Mn) in which the release additive is substantially non-volatile (that is, < 5%, prefearbly < 3%, and more preferably ≤ 1% of the release additive volatiles during use) under use conditions. Preferably, the release additive has Mn of ≥ 500 daltons. A preferred range of Mn is 500 to 10,000 daltons, more preferably 500 to 7,500 daltons, and still more preferably 500 to 7,000 daltons. The release additive is a linear polymer; a branched polymer such as a dendritic polymer, a star-like polymer, and a polymer particle, and the release additive is preferably a linear polymer or a polymer particle, and more preferably a linear polymer. Without being bound by theory, it is considered that the linear polymer can migrate better through the curable adhesive material phase towards the hydrophilic wafer surface as compared to the branched polymer.

A polyether is a preferred release additive. Examples of the polyether compound include an alkylene oxide homopolymer and an alkylene oxide copolymer, and such a copolymer may be random or block. A polyalkylene oxide release additive may have a variety of polar end groups, and such polar end groups are preferably hydroxy, ($C_1$-$C_6$) alkoxy, and ($C_1$-$C_6$) alkoxycarbonyl, and more preferably hydroxy, ($C_1$-$C_3$) alkoxy, and acetoxy. A preferred polyether compound is a polyglycol (or a polyalkylene oxide), for example, a poly ($C_1$-$C_4$) alkylene oxide compound, which may have a single type of alkylene oxide repeating unit or two or more different alkylene oxide repeating units. Examples of a preferred polyether compound include polyethylene glycol, polypropylene glycol, poly(1,3-propanediol), poly(tetrahydrofuran), an ethylene oxide-propylene oxide copolymer, an ethylene oxide-butylene oxide copolymer, and a mixture thereof. Preferably, in a case where the release additive contains butylene oxide as a repeating unit, the butylene oxide is a copolymer with one or more different alkylene oxide repeating units. It will be appreciated by those skilled in the art that the a mixture of the release additives may be used in the temporary binding composition of the present invention. Examples of a preferred release additive include polyethers sold under trade name PLURONIC (registered trademark), TETRONIC and POLYTHF (BASF, Ludwigshafen, available from Germany), trade name FORTEGRA (The Dow Chemical Company, Midland, Michigan), and trade name TERATHANE (Invista, Wichita, available from Kansas), and all of these products may be used without further purification.

<<Third Embodiment>>

As a preferred embodiment, the adhesive composition used in the present invention contains, for example, a thermosetting polymer described below.

As the adhesive composition of the third embodiment, for example, a thermosetting polymer described in JP 6528747 B2 can be used.

The thermosetting polymer is not particularly limited, and preferred examples thereof include a siloxane bond-containing polymer (hereinafter, also referred to as silicone A) having a weight average molecular weight of 3,000 to 500,000 and having a repeating unit represented by the following Formula (3) and, as necessary, a repeating unit represented by the following Formula (4).

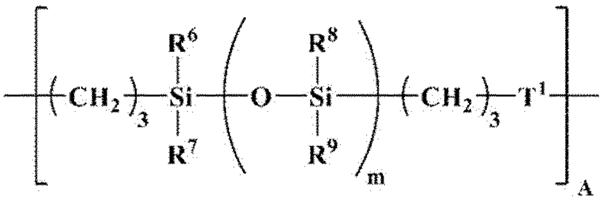

(3)

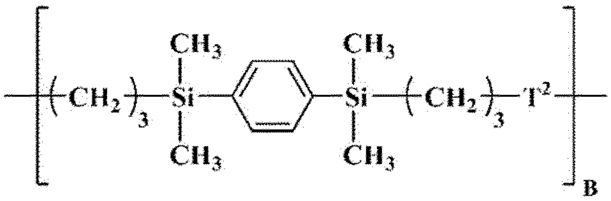

(4)

[In the formula, $R^6$ to $R^9$ each independently represent a monovalent hydrocarbon group having 1 to 8 carbon atoms. In addition, m represents an integer of 1 to 100. A and B are positive numbers satisfying 0 < A < 1, 0 < B < 1, and A + B = 1. $T^1$ and $T^2$ are divalent organic groups represented by the following Formula (5).

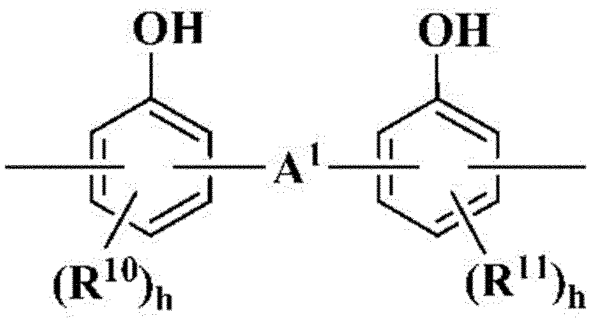

(5)

(In the formula, $A^1$ is a single bond or a divalent organic group selected from the groups represented by the following formula:

$-CH_2-$ , 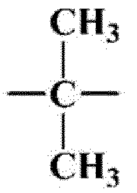 , 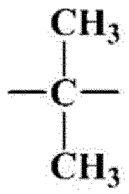 , and 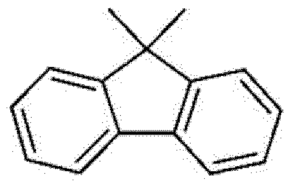

$R^{10}$ and $R^{11}$ are each independently an alkyl group or alkoxy group having 1 to 4 carbon atoms. h is each independently 0, 1, or 2.)].

Examples of the monovalent hydrocarbon group represented by $R^6$ to $R^9$ include alkyl groups such as a methyl group and an ethyl group, and aryl groups such as a phenyl group. m is preferably an integer of 3 to 60 and more preferably 8 to 40. In addition, A is preferably 0.3 to 0.8, B is preferably 0.2 to 0.7, and A/B preferably satisfies 0.1 to 20 and more preferably satisfies 0.5 to 5.

In addition, preferred examples of the thermosetting polymer include a siloxane bond-containing polymer (hereinafter, also referred to as silicone B) having a weight average molecular weight of 3,000 to 500,000 and having a repeating unit represented by the following Formula (6) and, as necessary, a repeating unit represented by the following Formula (7).

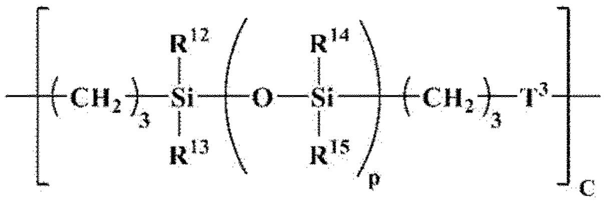

(6)

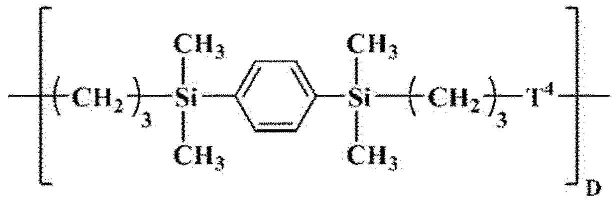

(7)

[In the formula, $R^{12}$ to $R^{15}$ each independently represent a monovalent hydrocarbon group having 1 to 8 carbon atoms. p represents an integer of 1 to 100. C and D are positive numbers satisfying $0 < C \leq 1$, $0 \leq D < 1$, and $C + D = 1$. $T^3$ and $T^4$ are divalent organic groups represented by the following Formula (8).

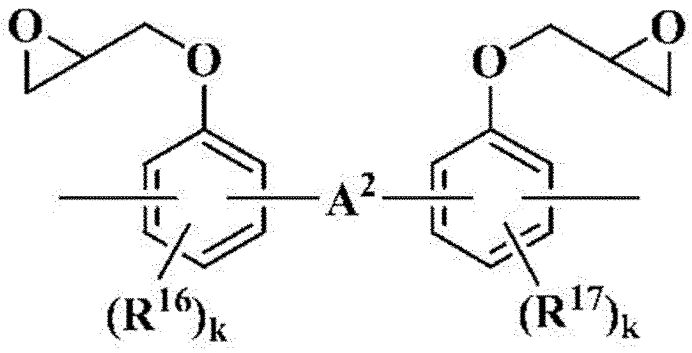

(8)

(In the formula, $A^2$ is a single bond or a divalent organic group selected from the groups represented by the following formula:

$-CH_2-$ , 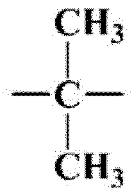 , 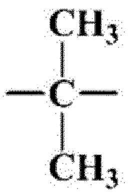 , and 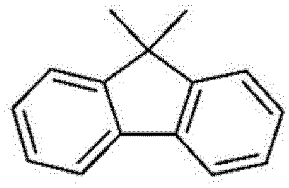

$R^{16}$ and $R^{17}$ are each independently an alkyl group or alkoxy group having 1 to 4 carbon atoms. k is each independently 0, 1, or 2.)].

In this case, examples of the monovalent hydrocarbon group represented by $R^{11}$ to $R^{14}$ include the same groups as those exemplified as those represented by $R^5$ to $R^8$. p is preferably an integer of 3 to 60 and more preferably 8 to 40. In addition, C is preferably 0.3 to 1, D is preferably 0 to 0.7, and C + D = 1.

The adhesive layer formed using the thermosetting polymer as the adhesive composition of the third embodiment is preferably a layer of a cured product of a thermosetting resin composition containing silicone A or silicone B as a main component. The silicone A and the silicone B can be used in combination. In this case, a ratio (polymerization ratio) is preferably silicone A:silicone B = 0.1:99.9 to 99.9:0.1 and more preferably silicone A:silicone B = 20:80 to 80:20.

A thermosetting resin composition containing silicone A as a main component contains, for its thermal curing, one or more crosslinking agents selected from an amino condensate modified with formalin or formalin-alcohol, a phenol compound containing two or more methylol groups or alkoxymethylol groups on average in one molecule, and an epoxy compound containing two or more epoxy groups on average in one molecule.

On the other hand, a thermosetting resin composition containing silicone B as a main component contains, for its thermal curing, one or more crosslinking agents selected from a phenol compound containing two or more phenol groups on average in one molecule and an epoxy compound containing two or more epoxy groups on average in one molecule.

In addition, a thermosetting resin composition containing silicone A and silicone B contains, for its thermal curing, one or more crosslinking agents selected from epoxy compounds having two or more epoxy groups on average in one molecule.

Examples of the amino condensate include a melamine resin and a urea resin. Examples of the melamine resin modified with formalin or formalin-alcohol include those obtained by subjecting a modified melamine monomer (for example, trimethoxymethyl monomethylol melamine) or a multimer thereof (for example, an oligomer such as a dimer or a trimer) to addition condensation polymerization with formaldehyde to a desired molecular weight according to a known method. Note that these can be used alone or in combination of two or more kinds thereof.

Examples of a urea resin modified with formalin or formalin-alcohol include a methoxymethylated urea condensate, an ethoxymethylated urea condensate, and a propoxymethylated urea condensate. Note that these can be used alone or in combination of two or more kinds thereof. The urea resin modified with formalin or formalin-alcohol can be prepared by, for example, modifying a urea condensate having a desired molecular weight by methylol formation with formalin or further modifying the urea condensate by alkoxylation with alcohol according to a known method.

In addition, examples of the phenol compound containing two or more methylol groups or alkoxymethylol groups on average in one molecule include (2-hydroxy-5 methyl)-1,3-benzenedimethanol and 2,2',6,6'-tetramethoxymethylbisphenol A. Note that these phenol compounds can be used alone or in combination of two or more kinds thereof.

The epoxy compound containing two or more epoxy groups on average in one molecule is not particularly limited, and examples thereof include bifunctional, trifunctional, or tetrafunctional or higher polyfunctional epoxy resins such as EOCN-1020 (see the following formula), EOCN-102S, XD-1000, NC-2000-L, EPPN-201, GAN, and NC6000 manufactured by Nippon Kayaku Co., Ltd., and compounds represented by the following formulas.

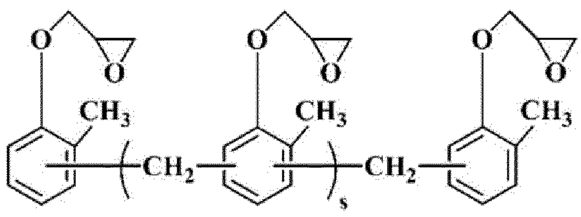

s=3~6

EOCN-1020

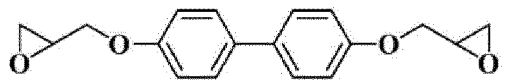

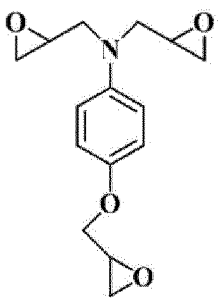

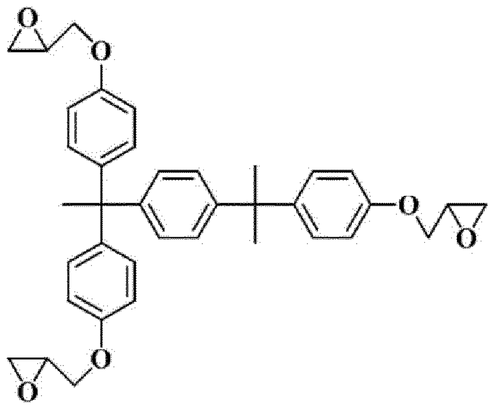

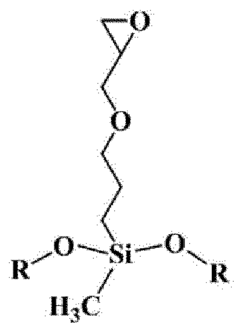

R = methyl group or ethyl group

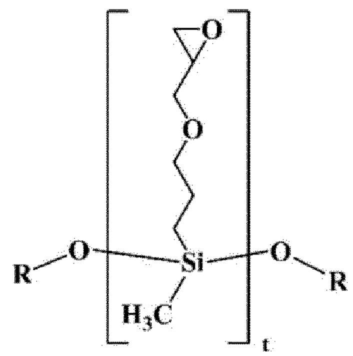

R = methyl group or ethyl group

t=1 20 wt%
t=2 75 wt%
t≧3 5 wt%

Examples of the phenol compound containing two or more phenol groups on average in one molecule include an m- or p-cresol novolac resin (for example, EP-6030G manufactured by ASAHI ORGANIC CHEMICALS INDUSTRY CO., LTD.), a trifunctional phenol compound (for example, Tris-P-PA manufactured by Honshu Chemical Industry Co., Ltd.), and a tetrafunctional phenol compound (for example, TEP-TPA manufactured by ASAHI ORGANIC CHEMICALS INDUSTRY CO., LTD.).

A blending amount of the crosslinking agent in the thermosetting resin composition is preferably 0.1 to 50 parts by mass, more preferably 0.2 to 30 parts by mass, and still more preferably 1 to 20 parts by mass, with respect to 100 parts by mass of the thermosetting polymer. The crosslinking agents can be used alone or in combination of two or more kinds thereof.

In addition, in the thermosetting resin composition, a curing catalyst such as an acid anhydride may be blended in an amount of 10 parts by mass or less with respect to 100 parts by mass of the thermosetting polymer.

<<Fourth Embodiment>>

As a preferred embodiment, the adhesive composition used in the present invention contains, for example, a compound selected from the group consisting of polymers and oligomers of imide, amideimide, and amideimide-siloxane contained in the thermoplastic composition for forming the binding composition layer described in JP 5788173 B2.

The compound is, for example, selected from the group consisting of a polymer and an oligomer having a repeating unit of at least one of the following Formula (I) and the following Formula (II).

Formula (I):

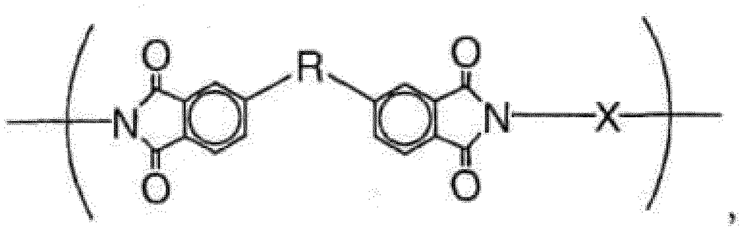,

[in the formula, R is selected from the group consisting of

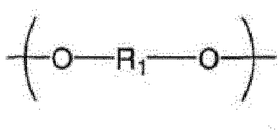, 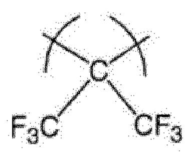, and 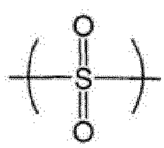,

(in the formula, $R_1$ is selected from the group consisting of an alkyl-substituted phenyl,

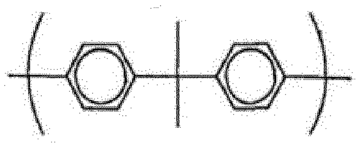, and 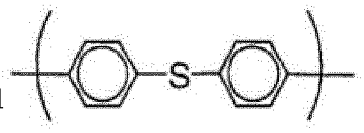 ;

).]

Formula (II):

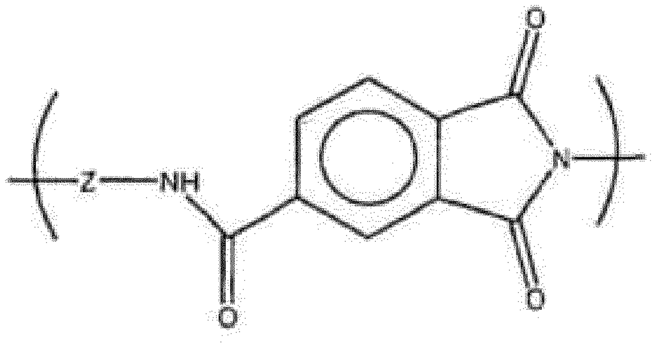

(in the formula, Z is selected from the group consisting of siloxanes and moieties having ether bridges.)

A preferred alkyl-substituted phenyl is a $C_1$-$C_6$ alkyl-substituted phenyl. Particularly preferred examples of the alkyl-substituted phenyl are selected from the group consisting of:

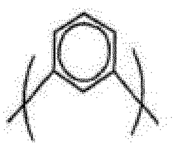, 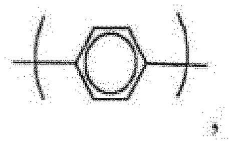, and 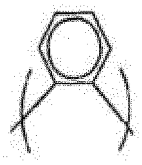.

In Formula (I), X is selected from the group consisting of a phenyl sulfone, a (preferably $C_6$-$C_{60}$, more preferably $C_6$-$C_{30}$, and still more preferably $C_6$-$C_{24}$) aromatic compound, a (preferably $C_2$-$C_{15}$, more preferably from $C_2$-$C_{10}$, and still more preferably $C_2$-$C_6$) aliphatic compound, and a (preferably $C_4$-$C_{60}$, more preferably $C_4$-$C_{20}$, and still more preferably $C_4$-$C_{12}$) alicyclic compound.

In one embodiment, X may be an aromatic group, an aliphatic group, or an alicyclic group as described above. In another embodiment, X may contain an aromatic group having an ether bridge (as discussed for Z) or an aromatic group having a linking group and/or a -$NH_2$ group in the meta position.

A particularly preferred X group is selected group consisting of an alkyl-substituted phenyl (as described above), isopropylidenediphenyl, and hexafluoroisopropylidene.

In an embodiment in which Z is a siloxane in Formula (II), a preferred siloxane is represented by a formula:

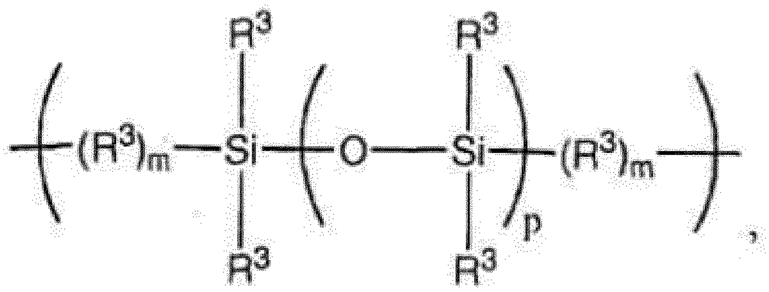
,

[in the formula, each $R^3$ is individually selected from the group consisting of hydrogen, (preferably $C_1$-$C_{10}$ and more preferably $C_1$-$C_2$) alkyl, and phenyl,

m is 1 to 6, and
p is 1 to 50, preferably 1 to 20, and more preferably 1 to 10].

In Formula (II), a preferred moiety having an ether bridge of Z is selected from the group consisting of

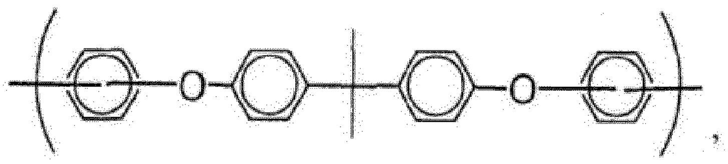
,

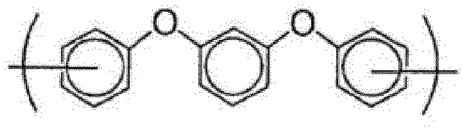
,

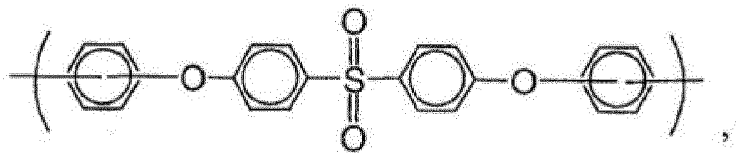
,

and

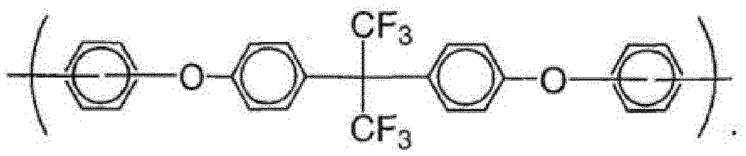
.

In an embodiment of Formula (I) or an embodiment of Formula (II), it is preferable that the polymer or oligomer further has a terminal blocking group. A preferred terminal blocking group is derived from a compound selected from the group consisting of an aromatic monoamine, an aliphatic monoamine, an alicyclic monoamine, and phthalic anhydride. A particularly preferred terminal blocking group includes a group selected from the group consisting of (preferably $C_1$-$C_{15}$, more preferably $C_1$-$C_{10}$, and still more preferably $C_1$-$C_6$) alkyl,

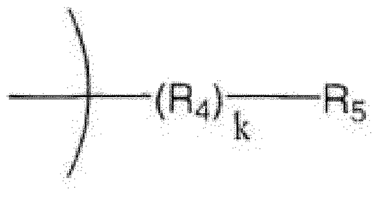,

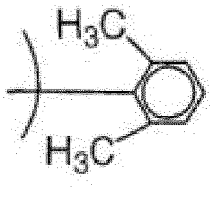, and 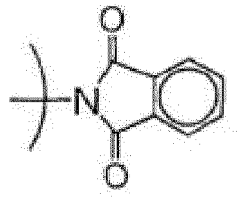,

[in the formula, $R_4$ is (preferably $C_1$-$C_{15}$, more preferably $C_1$-$C_{10}$, and still more preferably $C_1$-$C_6$) alkyl, $R^5$ is (preferably $C_3$-$C_{12}$ and more preferably $C_5$-$C_6$) alicyclic group, and
k is 0 to 20, preferably 0 to 10, and more preferably 0 to 5] .

Polymer or oligomer compounds of imide, amide-imide, and amide-imide-siloxane are thermoplastic and preferably have a weight average molecular weight from about 3,000 daltons to about 300,000 daltons, and more preferably from about 6,000 daltons to about 50,000 daltons. A preferred compound has a softening temperature of preferably at least about 150°C, more preferably at least about 200°C, and still more preferably about 200°C to about 250°C (at a melt viscosity of 3,000 Pa·S).

The adhesive composition used in the present invention may contain a solvent for the purpose of adjusting the viscosity and the like, and specific examples thereof include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, methyl isobutyl ketone (MIBK), butyl acetate, diisobutyl ketone, 2-octanone, 2-nonanone, and 5-nonanone. Such solvents can be used alone or in combination of two or more kinds thereof.

In a case where the adhesive composition used in the present invention contains a solvent, a content thereof is appropriately determined in consideration of a viscosity of a desired composition, a coating method to be employed, a thickness of a film to be produced, and the like, but is in a range of about 10 to 90 mass% with respect to the entire composition.

A viscosity of the adhesive composition used in the present invention is not particularly limited, but is usually 500 to 20,000 mPa·s and preferably 1,000 to 5,000 mPa·s at 25°C. The viscosity of the adhesive composition used in the present invention can be adjusted by changing a type and a ratio of a solvent to be used, a concentration of the film constituent components, and the like in consideration of various factors such as a coating method to be used and a desired film thickness.

As an example, the adhesive composition used in the present invention can be prepared by mixing the component (A) with the component (B) and a solvent when used.

The mixing order is not particularly limited, and examples of a method by which an adhesive composition can be easily and prepared with excellent reproducibility include, but are not limited to, a method in which the component (A) and the component (B) are dissolved in a solvent, and a method in which a part of the component (A) and the component (B) is dissolved in a solvent, the rest is dissolved in the solvent, and the resulting solution is mixed. Note that, when the adhesive composition is prepared, the adhesive composition may be appropriately heated within a range in which the components are not decomposed or altered.

In the present invention, for the purpose of removing foreign substances, a solvent, a solution, or the like to be used may be filtered using a filter or the like during the preparation of the adhesive composition or after mixing all the components.

A thickness of the adhesive layer included in the laminate of the present invention is not particularly limited, but is usually 5 to 500 μm, and is preferably 10 um or more, more preferably 20 um or more, and still more preferably 30 um or more, from the viewpoint of maintaining film strength, and is preferably 200 um or less, more preferably 150 um or less, still more preferably 120 um or less, and still more preferably 70 um or less, from the viewpoint of avoiding non-uniformity caused by a thick film.

The laminate of the present invention is preferably manufactured, for example, by the following method for

manufacturing a laminate of the present invention.

Hereinafter, an example of the laminate will be described with reference to the drawings.

Fig. 1 is a schematic cross-sectional view of an example of a laminate.

The laminate of Fig. 1 includes a semiconductor substrate 1, an adhesive layer 2, a release layer 3, and a support substrate 4 in this order.

The adhesive layer 2 and the release layer 3 are provided between the semiconductor substrate 1 and the support substrate 4. The adhesive layer 2 is in contact with the semiconductor substrate 1. The release layer 3 is in contact with the adhesive layer 2 and the support substrate 4.

<Method for Manufacturing Laminate>

The laminate of the present invention can be manufactured by a method including: a first step of applying an adhesive composition to a surface of a semiconductor substrate and, as necessary, heating the adhesive composition to form an adhesive coating layer; a second step of applying a release agent composition to a surface of a support substrate and, as necessary, heating the release agent composition to form a release agent coating layer; and a third step of bringing the adhesive coating layer of the semiconductor substrate and the release agent coating layer of the support substrate into close contact with each other by applying a load in a thickness direction of the semiconductor substrate and the support substrate while performing at least one of a heat treatment and a decompression treatment, and then performing a post-heat treatment to form a laminate.

In addition, the laminate of the present invention can be manufactured by a method including: a first step of applying a release agent composition to a surface of a semiconductor substrate and, as necessary, heating the release agent composition to form a release agent coating layer; a second step of applying an adhesive composition to a surface of a support substrate and, as necessary, heating the adhesive composition to form an adhesive coating layer; and a third step of bringing the release agent coating layer of the semiconductor substrate and the adhesive coating layer of the support substrate into close contact with each other by applying a load in a thickness direction of the semiconductor substrate and the support substrate while performing at least one of a heat treatment and a decompression treatment, and then performing a post-heat treatment to form a laminate.

Note that, as long as the effects of the present invention are not impaired, application and heating of each composition may be sequentially performed on any one of the substrates.

The coating method is not particularly limited, but is usually a spin coating method. Note that a method of separately forming a coating film by a spin coating method or the like and attaching the sheet-like coating film as an adhesive coating layer or a release agent coating layer can be employed.

A heating temperature of the applied adhesive composition varies depending on the type and amount of the adhesive component contained in the adhesive composition, whether or not a solvent is contained, a boiling point of a solvent to be used, a desired thickness of the adhesive layer, and the like, and thus cannot be generally specified, but the heating temperature is usually 80 to 150°C, and a heating time is usually 30 seconds to 5 minutes.

In a case where the adhesive composition contains a solvent, the applied adhesive composition is usually heated.

A heating temperature of the applied release agent composition varies depending on the type and amount of the acid generator, a boiling point of a solvent used, a desired thickness of the release layer, and the like, and thus cannot be generally specified, and is 80°C or higher from the viewpoint of realizing a preferred release layer with excellent reproducibility, and is 300°C or lower from the viewpoint of suppressing decomposition of the acid generator, and a heating temperature thereof is appropriately determined usually in a range of 10 seconds to 10 minutes depending on the heating temperature.

In a case where the release agent composition contains a solvent, the applied release agent composition is usually heated.

The heating can be performed using a hot plate, an oven, or the like.

A thickness of the adhesive coating layer obtained by applying the adhesive composition and heating the adhesive composition as necessary is usually about 5 to 500 μm, and finally, is appropriately determined so as to fall within the range of the thickness of the adhesive layer described above.

A thickness of the release agent coating layer obtained by applying the release agent composition and heating the release agent composition as necessary is usually about 5 nm to 100 μm, and finally, is appropriately determined so as to fall within the range of the thickness of the release layer described above.

In the present invention, the laminate of the present invention can be obtained by combining such coating layers so as to be in contact with each other, applying a load in the thickness direction of the semiconductor substrate and the support substrate to bring the two layers into close contact with each other while performing a heat treatment or a decompression treatment or both, and then performing a post-heat treatment. Note that, employment of treatment conditions of the heat treatment, decompression treatment, and combination use of both is appropriately determined in consideration of various circumstances such as the type of the adhesive composition, the specific composition of the

release agent composition, the compatibility of the films obtained using both compositions, the film thickness, and the required adhesive strength.

The heat treatment is appropriately determined from a range of usually 20 to 150°C in consideration of the viewpoint of removing a solvent in a case where the solvent is contained in the composition, from the viewpoint of softening the adhesive coating layer and realizing preferred bonding with the release agent coating layer, and the like. In particular, the heating temperature is preferably 130°C or lower and more preferably 90°C or lower from the viewpoint of suppressing or avoiding excessive curing and unnecessary alternation of the adhesive component (A), and the heating time is appropriately determined depending on the heating temperature or the type of the adhesive, but is usually 30 seconds or longer and preferably 1 minute or longer from the viewpoint of reliably exhibiting preferred adhesion, and is usually 10 minutes or shorter and preferably 5 minutes or shorter from the viewpoint of suppressing alternation of the adhesive layer or other members.

The decompression treatment may be performed by exposing the adhesive coating layer and the release agent coating layer that are in contact with each other at an atmospheric pressure of 10 to 10,000 Pa. A time for the decompression treatment is generally 1 to 30 minutes.

From the viewpoint of obtaining a laminate in which a substrate can be preferably separated with excellent reproducibility, the two layers in contact with each other are bonded to each other preferably by a decompression treatment, and more preferably by a combination of a heat treatment and a decompression treatment.

The load in the thickness direction of the semiconductor substrate and the support substrate is not particularly limited as long as the load does not adversely affect the semiconductor substrate and the support substrate and the two layers therebetween and can allow the semiconductor substrate and the support substrate to firmly adhere to each other, but is usually within a range of 10 to 1,000 N.

A post-heating temperature is preferably 120°C or higher from the viewpoint of realizing a sufficient curing rate, and is preferably 260°C or lower from the viewpoint of preventing alternation of the substrate or each layer.

A post-heating time is usually 1 minute or longer and preferably 5 minutes or longer from the viewpoint of realizing preferred bonding of the substrate and the layer constituting the laminate, and is usually 180 minutes or shorter and preferably 120 minutes or shorter from the viewpoint of suppressing or avoiding an adverse effect on each layer due to excessive heating.

The heating can be performed using a hot plate, an oven, or the like. In a case where post-heating is performed using a hot plate, heating may be performed with either the semiconductor substrate or the support substrate of the laminate facing downward, but it is preferable to perform post-heating with the semiconductor substrate facing downward from the viewpoint of realizing preferred release with excellent reproducibility.

Note that one object of the post-heat treatment is to realize an adhesive layer and a release layer that are more preferred self-supporting, and particularly to preferably realize curing by a hydrosilylation reaction.

(Method for Manufacturing Processed Semiconductor Substrate)

The method for manufacturing a processed semiconductor substrate of the present invention includes a first step, a second step, and a third step.

The first step is a step of processing the semiconductor substrate of the laminate of the present invention.

The second step is a step of separating the semiconductor substrate processed in the first step and the support substrate.

The third step is a step of cleaning the separated semiconductor substrate with a cleaning agent composition.

The processing performed on the semiconductor substrate in the first step is, for example, processing on an opposite side of a circuit surface of a wafer, and examples thereof include thinning of the wafer by polishing a rear surface of the wafer. Thereafter, a through-silicon via (TSV) or the like is formed, and then a thinned wafer is released from the support substrate to form a laminate of the wafers, and thus the wafers are three-dimensionally mounted. In addition, before and after that, a wafer rear surface electrode and the like are also formed. Heat of about 250 to 350°C is applied to thinning of the wafer and a TSV process in a state of being bonded to the support substrate. The laminate of the present invention usually includes an adhesive layer and a release layer, and thus has heat resistance to the load.

Note that processing is not particularly limited to the processing described above, and includes, for example, implementation of a mounting process of a semiconductor component in a case where the semiconductor component is temporarily bonded to a support substrate in order to support a base material for mounting the semiconductor component.

In the second step, examples of a method for separating (releasing) the semiconductor substrate and the support substrate include, but are not limited to, mechanical release with equipment having a sharp portion after irradiation of the release layer with light, and release by pulling up between the support and the wafer.

The release layer is irradiated with light from the side of the support substrate, such that the release layer is altered (for example, separation or decomposition of the release layer) as described above, and thereafter, for example,

one of the substrates is pulled up, and the semiconductor substrate and the support substrate can be easily separated.

The release layer is not necessarily irradiated with light in the entire region of the release layer. Even when the region irradiated with light and the region not irradiated with light are mixed, the semiconductor substrate and the support substrate can be separated by a slight external force such as pulling up of the support substrate, for example, as long as the releasability is sufficiently improved in the entire release layer. A ratio and a positional relationship between the region irradiated with light and the region not irradiated with light vary depending on the type and specific composition of the adhesive to be used, the thickness of the adhesive layer, the thickness of the release layer, the intensity of light to be irradiated, and the like, but those skilled in the art can appropriately set conditions without requiring an excessive test. For such circumstances, according to the method for manufacturing a processed semiconductor substrate of the present invention, for example, in a case where the support substrate of the laminate to be used has optical transparency, it is possible to shorten the light irradiation time when release is performed by light irradiation from the side of the support substrate, and as a result, not only improvement in throughput can be expected, but also physical stress and the like for release can be avoided, and the semiconductor substrate and the support substrate can be easily and efficiently separated only by light irradiation.

Usually, an irradiation dose of light for release is 50 to 3,000 $mJ/cm^2$. An irradiation time is appropriately determined according to a wavelength and an irradiation dose.

Light irradiation may be performed using laser light, or may be performed using non-laser from a light source such as an ultraviolet lamp.

In the third step, the surface of the separated semiconductor substrate is cleaned by spraying the cleaning agent composition or immersing the separated semiconductor substrate in the cleaning agent composition, and then is usually rinsed and dried using a solvent. Note that examples of the cleaning agent composition include those described above.

In the method for manufacturing a processed semiconductor substrate of the present invention, the processed semiconductor substrate manufactured through the third step is preferably cleaned by the cleaning agent composition, but further cleaning of the surface of the processed semiconductor substrate is not hindered using a removal tape or the like, and the surface may be further cleaned using a removal tape or the like as necessary.

The constituent elements and method elements related to the step of the method for manufacturing a processed semiconductor substrate of the present invention described above may be variously changed without departing from the gist of the present invention.

The method for manufacturing a processed semiconductor substrate of the present invention may include steps other than the steps described above.

In the release method of the present invention, in a case where the semiconductor substrate or the support substrate of the laminate of the present invention has optical transparency, the semiconductor substrate and the support substrate of the laminate are separated by irradiating the release layer with light from the side of the semiconductor substrate or the support substrate.

In the laminate of the present invention, the semiconductor substrate and the support substrate are temporarily bonded by the adhesive layer and the release layer so as to be preferably releasable. Therefore, for example, in a case where the support substrate has light permeability, the release layer is irradiated with light from the side of the support substrate of the laminate, such that the semiconductor substrate and the support substrate can be easily separated. Usually, release is performed after the semiconductor substrate of the laminate is processed.

## Examples

Hereinafter, the present invention will be described in more detail with reference to Examples, but the present invention is not limited to the following Examples. Note that the devices used are as follows.

[Devices]

(1) Stirrer: rotation and revolution mixer ARE-500 manufactured by Thinky Corporation
(2) Viscometer: rotary viscometer TVE-22H manufactured by Toki Sangyo Co., Ltd.
(3) Vacuum bonding device: auto bonder manufactured by SUSS MicroTec SE
(4) Optical film thickness meter (film thickness measurement): F-50 manufactured by Filmetrics Japan, Inc.
(5) Laser irradiation device: IPEX-848 manufactured by Light Machinery Co., Ltd.

[Conditions for Measuring Molecular Weight of Allyl Polymer]

The weight average molecular weight of the allyl polymer was measured using a GPC apparatus (HLC-8320GPC manufactured by Tosoh Corporation) and a GPC column (TSKgel Super-MultiporeHZ-N (two columns)) at a column temperature of 40°C, using tetrahydrofuran as an eluent (elution solvent), and using polystyrene (Shodex manufactured by Showa Denko K.K.) as a standard sample at a flow rate of 0.35 mL/min.

[Conditions for Measuring Molecular Weight of Specific Compound (Organosiloxane Polymer)]

The weight average molecular weight of the specific compound was measured using a GPC apparatus (HLC-8320GPC manufactured by Tosoh Corporation) and a GPC column (Shodex [registered trademark] KF-801, KF-802, and KF-803L manufactured by Showa Denko K.K.) at a column temperature of 40°C, using tetrahydrofuran as an eluent (elution solvent), and using polystyrene (Shodex manufactured by Showa Denko K.K.) as a standard sample at a flow rate of 1.0 mL/min.

[1] Preparation of Adhesive Composition

[Preparation Example 1]

Into a 600 mL vessel dedicated to the stirrer, 80 g of an MQ resin (manufactured by Wacker Chemie AG) containing a polysiloxane skeleton and a vinyl group, 2.52 g of a SiH group-containing linear polydimethylsiloxane (manufactured by Wacker Chemie AG) having a viscosity of 100 mPa·s, 5.89 g of a SiH group-containing linear polydimethylsiloxane (manufactured by Wacker Chemie AG) having a viscosity of 70 mPa·s, and 0.22 g of 1-ethynyl-1-cyclohexanol (manufactured by Wacker Chemie AG) were charged, and stirring was performed with the stirrer for 5 minutes, thereby obtaining a mixture (I).

0.147 g of a platinum catalyst (manufactured by Wacker Chemie AG) and 5.81 g of a vinyl group-containing linear polydimethylsiloxane (manufactured by Wacker Chemie AG) having a viscosity of 1,000 mPa·s were stirred with the stirrer for 5 minutes, thereby obtaining a mixture (II).

3.96 g of the obtained mixture (II) was added to the mixture (I), and stirring was performed with the stirrer for 5 minutes, thereby obtaining a mixture (III).

Finally, the obtained mixture (III) was filtered through a nylon filter with 300 mesh to obtain an adhesive composition.

[2] Preparation of Cleaning Agent Composition

[Preparation Example 2]

6 g of tetrabutylammonium fluoride trihydrate (manufactured by Kanto Chemical Co., Inc.) was mixed with 94 g of N,N-dimethylpropionamide, and the mixture was stirred well, thereby obtaining a cleaning agent composition.

[3] Synthesis of Allyl Polymer

[Synthesis Example 1]

Into a flask, 9.80 g of propylene glycol monomethyl ether acetate (hereinafter, abbreviated as PGMEA) was charged, 14.00 g of 4-allyloxy-2-hydroxybenzophenone, 0.70 g of 2,2'-azobis(isobutyronitrile), and 34.54 g of PGMEA were added thereto, and stirring was performed in a nitrogen atmosphere at 60°C for 18 hours, thereby obtaining a reaction mixture.

The obtained reaction mixture was cooled, and then dropped into methanol to obtain a precipitate. After methanol was removed, the precipitate was dried under reduced pressure at 60°C to obtain 0.91 g of an allyl polymer. The obtained allyl polymer corresponded to the following Formula (B-1), and a weight average molecular weight thereof was 860.

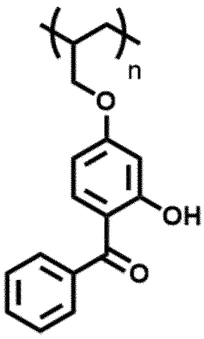

Formula (B-1)

[4] Synthesis of Organosiloxane Polymer

[Example A]

20.93 g of 2-hydroxy-4-(3-triethoxysilylpropoxy)diphenyl ketone (manufactured by Gelest Inc.) and 28.69 g of acetone were charged into a flask to prepare a raw material mixture, 2.70 g of 0.01 mol/L hydrochloric acid and 2.70 g of acetone were added dropwise to the raw material mixture while stirring the raw material mixture. After the dropwise addition, the obtained mixture was stirred at room temperature for 30 minutes and then stirred at 85°C for 4 hours. After the mixture was cooled to room temperature, 90.0 g of propylene glycol monomethyl ether (hereinafter, abbreviated as PGME) was added to the obtained reaction mixture, and acetone and water were distilled off under reduced pressure, thereby obtaining a solution containing an organosiloxane polymer. The organosiloxane polymer corresponded to the following Formula (A-1), and a weight average molecular weight thereof was 1,690.

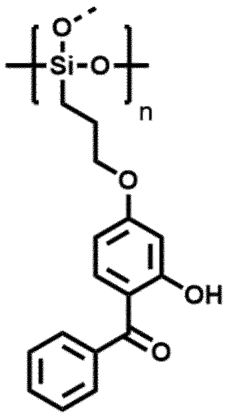

Formula (A-1)

[Example B]

18.84 g of 2-hydroxy-4-(3-triethoxysilylpropoxy)diphenyl ketone (manufactured by Gelest Inc.), 3.13 g of tetraethoxysilane, and 29.43 g of acetone were charged into a flask to prepare a raw material mixture, 3.51 g of 0.01 mol/L hydrochloric acid and 3.51 g of acetone were added dropwise to the raw material mixture while stirring the raw material mixture. After the dropwise addition, the obtained mixture was stirred at room temperature for 30 minutes and then stirred at 85°C for 4 hours. After the mixture was cooled to room temperature, 90.0 g of PGME was added to the obtained reaction mixture, and acetone and water were distilled off under reduced pressure, thereby obtaining a solution containing an organosiloxane polymer. The obtained organosiloxane polymer corresponded to the following Formula (A-2), and a weight average molecular weight thereof was 1,570.

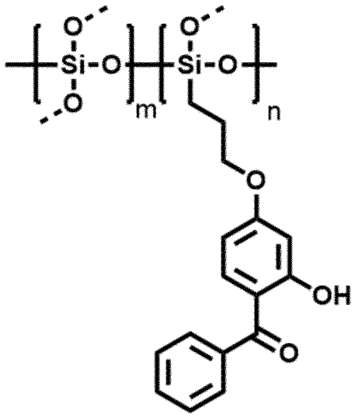

Formula (A-2)

[Example C]

12.56 g of 2-hydroxy-4-(3-triethoxysilylpropoxy)diphenyl ketone (manufactured by Gelest Inc.), 5.95 g of phenyltrimethoxysilane, and 24.51 g of acetone were charged into a flask to prepare a raw material mixture, 3.24 g of 0.01 mol/L hydrochloric acid and 3.24 g of acetone were added dropwise to the raw material mixture while stirring the raw material mixture. After the dropwise addition, the obtained mixture was stirred at room temperature for 30 minutes and then stirred at 85°C for 4 hours. After the mixture was cooled to room temperature, 90.0 g of PGME was added to the obtained reaction mixture, and acetone and water were distilled off under reduced pressure, thereby obtaining a solution containing an organosiloxane polymer. The obtained organosiloxane polymer corresponded to the following Formula (A-3), and a weight average molecular weight thereof was 1,150.

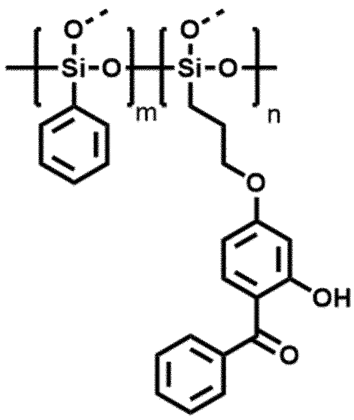

Formula (A-3)

[5] Preparation of release Agent Composition

[Comparative Example 1-1]

0.28 g of the allyl polymer obtained in Synthesis Example 1, 0.06 g of 1,3,4,6-tetrakis(methoxymethyl)glycoluril as a crosslinking agent, 0.14 g of a 5% mass% PGME solution of pyridinium trifluoromethanesulfonate as a crosslinking catalyst, 0.10 g of PGME, and 4.42 g of PGMEA were added in a screw tube, and the obtained solution was filtered using a polyethylene microfilter having a pore size of 0.2 um, thereby obtaining a release agent composition.

[Example 1-1]

10.24 g of a solution containing an organosiloxane polymer corresponding to Formula (A-1) obtained in Example A (polymer concentration: 25.15 mass%), 2.57 g of a 1 mass% PGME solution of triphenylsulfonium nitrate as a crosslinking catalyst, and 7.19 g of PGME were added to a screw tube and mixed, and the obtained solution was filtered using a polyethylene microfilter with a pore size of 0.2 um, thereby obtaining a release agent composition.

[Example 1-2]

7.97 g of a solution containing an organosiloxane polymer corresponding to Formula (A-2) obtained in Example B (polymer concentration: 32.28 mass%), 2.57 g of a 1 mass% PGME solution of triphenylsulfonium nitrate as a crosslinking catalyst, and 9.45 g of PGME were added to a screw tube and mixed, and the obtained solution was filtered using a polyethylene microfilter with a pore size of 0.2 um, thereby obtaining a release agent composition.

[Example 1-3]

9.44 g of a solution containing an organosiloxane polymer corresponding to Formula (A-3) obtained in Example C (polymer concentration: 27.26 mass%), 2.57 g of a 1 mass% PGME solution of triphenylsulfonium nitrate as a crosslinking catalyst, and 7.98 g of PGME were added to a screw tube and mixed, and the obtained solution was filtered using a polyethylene microfilter with a pore size of 0.2 um, thereby obtaining a release agent composition.

[6] Confirmation of Film Removability (Film Reduction Rate)

[Examples 2-1 to 2-3]

The release agent composition obtained in each of Examples 1-1 to 1-3 was spin-coated on a silicon wafer cut into a 4 cm square with a final film thickness of 500 nm, and heating was performed at 190°C for 1 minute, thereby forming a film on the wafer. The wafers on which the films were formed were prepared as many as necessary.

[Comparative Example 2-1]

The release agent composition obtained in Comparative Example 1-1 was spin-coated on a silicon wafer cut into a 4 cm square with a final film thickness of 500 nm, and heating was performed at 250°C for 5 minutes, thereby forming a film on the wafer. The wafers on which the films were formed were prepared as many as necessary.

The film thickness of the film obtained in each of Examples 2-1 to 2-3 and Comparative Example 2-1 was measured (film thickness before immersion). Then, each film was immersed together with the substrate (wafer) in 7 mL of the cleaning agent composition obtained in Preparation Example 2 for 5 minutes, drying was performed with an air gun, and then the film thickness of each film was measured again (film thickness after immersion).

In addition, the film thickness was measured in the same manner as above, except that OK73 thinner (the components were 70% of propylene glycol monomethyl ether and 30% of propylene glycol monomethyl ether acetate) (manufactured by TOKYO OHKA KOGYO CO., LTD.) and N-methyl-2 pyrrolidone (NMP) were used instead of the cleaning agent composition.

The film reduction rate (%) by immersion was calculated by the following formula.

$$\text{Film reduction rate (\%)} = [1 - [\text{film thickness (nm) after immersion/film thickness (nm) before immersion}]] \times 100$$

The results are shown in Table 1.

[Table 1]

| | Example 2-1 | Example 2-2 | Example 2-3 | Comparative Example 2-1 |
|---|---|---|---|---|
| Release agent composition | Example 1-1 | Example 1-2 | Example 1-3 | Comparative Example 1-1 |
| Cleaning agent composition | 100% | 100% | 100% | < 5% |
| OK73 thinner | < 5% | < 5% | < 5% | < 5% |
| NMP | < 5% | < 5% | < 5% | < 5% |

As shown in Table 1, the film obtained in Comparative Example 2-1 had a film reduction rate of less than 5% in any of the case of being immersed in the cleaning agent composition, the case of being immersed in OK73 thinner,

and the case of being immersed in NMP. This means that the film obtained in Comparative Example 2-1 was not dissolved well in any of the cleaning agent composition, OK73 thinner, and NMP. The film reduction rate of the film obtained in each of Examples 2-1 to 2-3 when immersed in various solvents was 5% or less, but the film reduction rate thereof when immersed in the cleaning agent composition was 100%. That is, the films obtained in Examples 2-1 to 2-3 could not be preferably removed by various solvents, but could be preferably removed by the cleaning agent composition.

[7] Manufacture of Laminate and Confirmation of Releasability by Light Irradiation

[Example 3-1]

The release agent composition obtained in Example 1-1 was spin-coated on a 100 mm glass wafer (EAGLE-XG, manufactured by Corning Inc., thickness: 700 um) as a substrate on the carrier side so that the film thickness in the finally obtained laminate was 500 nm to form a release agent coating layer on the glass wafer as a support substrate.

On the other hand, the adhesive composition obtained in Preparation Example 1 was spin-coated on a 100 mm silicon wafer (thickness: 775 um) as a substrate on the device side so that the film thickness in the finally obtained laminate was 65 um to form an adhesive coating layer on the silicon wafer as a semiconductor substrate.

Then, the glass wafer and the silicon wafer were bonded to each other so as to interpose the release agent coating layer and the adhesive coating layer therebetween using a bonding device, and then a post-heat treatment was performed at 200°C for 10 minutes, thereby preparing a laminate. Note that bonding was performed at a temperature of 23°C and a degree of reduced pressure of 1,000 Pa with no load.

The release layer was irradiated with a laser having a wavelength of 308 nm from the glass wafer side of the fixed laminate using a laser irradiation device, and the lowest irradiation dose at which release occurred was defined as an optimum irradiation dose. Then, the entire surface of the release layer was irradiated with a laser having a wavelength of 308 nm at an optimum irradiation dose from the glass wafer side of the fixed laminate, and the support substrate was manually lifted to confirm whether or not the release layer was released. In a case where the silicon wafer was released without being damaged, the silicon wafer was determined to be releasable. The results were shown in Table 2. Note that the numerical value in parentheses is the optimum irradiation dose.

[Examples 3-2 and 3-3]

A laminate was manufactured in the same manner as that of Example 3-1, except that the release agent composition obtained in each of Examples 1-2 to 1-3 was used instead of the release agent composition obtained in Example 1-1, and whether or not release was possible was examined.

[Comparative Example 3-1]

A laminate was manufactured in the same manner as that of Example 3-1, except that the release agent composition obtained in Comparative Example 1-1 was used instead of the release agent composition obtained in Example 1-1, and whether or not release was possible was examined.

[Table 2]

| | Example 3-1 | Example 3-2 | Example 3-3 | Comparative Example 3-1 |
|---|---|---|---|---|
| Release agent composition | Example 1-1 | Example 1-2 | Example 1-3 | Comparative Example 1-1 |
| Releasability with laser | Releasable (250 $mJ/cm^2$) | Releasable (250 $mJ/cm^2$) | Releasable (250 $mJ/cm^2$) | Releasable (300 $mJ/cm^2$) |

As shown in Table 2, even in a case where the semiconductor substrate and the support substrate of the laminate including the film obtained using the release agent composition containing the specific compound as the release layer were separated by irradiating the release layer with light, excellent releasability was confirmed as in the case of using the release agent composition containing an allyl polymer.

Industrial Applicability

According to the present invention, the laminate of the present invention can implement easy separation when

the support substrate and the semiconductor substrate are separated, and can implement dissolution of the release layer after light irradiation by the cleaning agent composition when the semiconductor substrate is cleaned, such that the laminate of the present invention is useful for manufacturing a processed semiconductor substrate.

Reference Signs List

1 Semiconductor substrate
2 Adhesive layer
3 Release layer
4 Support substrate

## Claims

**1.** A laminate comprising:

a semiconductor substrate;
a light-transmissive support substrate; and
an adhesive layer and a release layer that are provided between the semiconductor substrate and the support substrate,
wherein the release layer absorbs light emitted from a side of the support substrate and then is used for release the semiconductor substrate and the support substrate,
the release layer is a layer formed of a release agent composition, and
the release agent composition contains a compound having: a first structure that is a structure for absorbing the light, contributes to easy release of the semiconductor substrate and the support substrate by absorbing the light, and has two or more aromatic rings constituting a π-electron conjugated system; and a siloxane structure as a second structure.

**2.** The laminate according to claim 1, wherein the first structure has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure.

**3.** The laminate according to claim 1 or 2, wherein the first structure is a structure represented by any one of the following Formulas (1) to (7):

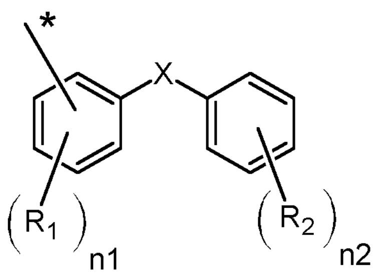

(1)

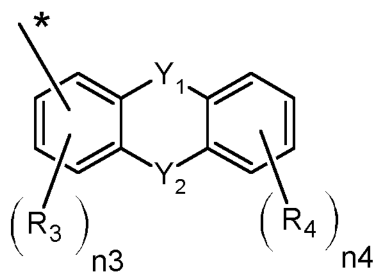

(2)

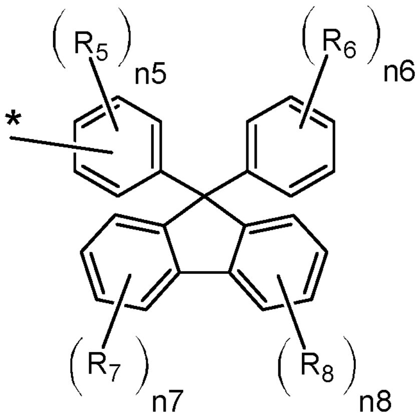

(3)

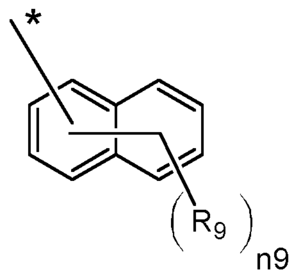

(4)

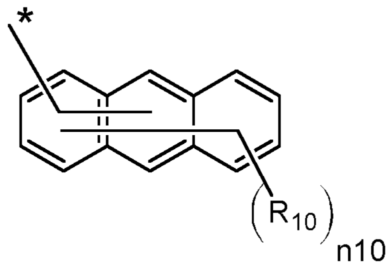

(5)

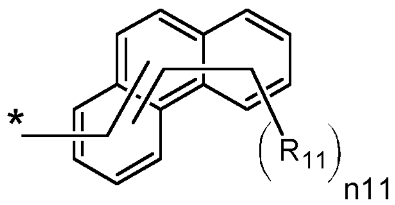

(6)

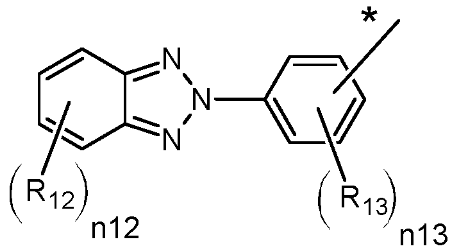

(7)

(in Formulas (1) to (7), $R_1$ to $R_{13}$ each independently represent a halogen atom or a monovalent group,
X represents a single bond, -O-, -CO-, $-NR_{31}-$ ($R_{31}$ represents a hydrogen atom, an alkyl group which may be substituted, or an aryl group which may be substituted), - SO-, $-SO_2-$, or -N=N-,
$Y_1$ represents a single bond or -CO-, when $Y_1$ is a single bond, $Y_2$ represents -O-, -CO-, or $-NR_{32}-$ ($R_{32}$ represents a hydrogen atom, an alkyl group which may be substituted, or an aryl group which may be substituted), and when $Y_1$ is -CO-, $Y_2$ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,

n13 is an integer of 0 to 4,
* represents a bond, and
when there are a plurality of $R_1$s to $R_{13}$s, the plurality of $R_1$s to $R_{13}$s may be the same as or different from each other) .

**4.** The laminate according to any one of claims 1 to 3, wherein the first structure contains at least one hydroxy group.

**5.** The laminate according to any one of claims 1 to 4, wherein the second structure contains at least one selected from the group consisting of a siloxane unit (Q unit) represented by $SiO_2$, a siloxane unit (M unit) represented by $R_{101}R_{102}R_{103}SiO_{1/2}$, a siloxane unit (D unit) represented by $R_{104}R_{105}SiO_{2/2}$, and a siloxane unit (T unit) represented by $R_{106}SiO_{3/2}$ ($R_{101}$ to $R_{106}$ each independently represent a hydrogen atom or monovalent group bonded to Si, or a single bond or linking group that binds Si and the first structure).

**6.** The laminate according to claim 5, wherein the first structure is bonded to Si of any one of the M unit, the D unit, and the T unit via a single bond or a linking group.

**7.** The laminate according to claim 6, wherein the first structure is bonded to Si of any one of the M unit, the D unit, and the T unit via a linking group, and
the linking group is selected from the group consisting of an alkylene group having 1 to 10 carbon atoms, an ester bond, an ether bond, an amide bond, a urethane bond, a urea bond, and a combination of two or more thereof.

**8.** The laminate according to any one of claims 1 to 7, wherein the adhesive layer is a layer formed of an adhesive composition containing a compound having a siloxane structure.

**9.** The laminate according to claim 8, wherein the adhesive composition contains a component (A) which is cured.

**10.** The laminate according to claim 9, wherein the component (A) is a component which is cured by a hydrosilylation reaction.

**11.** The laminate according to claim 9 or 10, wherein the component (A) contains:

a polyorganosiloxane (a1) containing an alkenyl group having 2 to 40 carbon atoms bonded to silicon atoms;
a polyorganosiloxane (a2) containing a Si-H group; and
a platinum group metal-based catalyst (A2).

**12.** A release agent composition for forming a release layer of a laminate including a semiconductor substrate, a support substrate, and an adhesive layer and a release layer that are provided between the semiconductor substrate and the support substrate, the release agent composition being used for release the semiconductor substrate and the support substrate after the release layer absorbs light emitted from a side of the support substrate,
the release agent composition comprising a compound having: a first structure that is a structure that absorbs the light, contributes to easy release of the semiconductor substrate and the support substrate by absorbing the light, and has two or more aromatic rings constituting a $\pi$-electron conjugated system; and a siloxane structure as a second structure.

**13.** The release agent composition according to claim 12, wherein the first structure has a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure.

**14.** A release agent composition comprising a compound having: a first structure including a structure selected from the group consisting of a benzophenone structure, a diphenylamine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenylbenzotriazole structure; and a siloxane structure as a second structure.

**15.** The release agent composition according to any one of claims 12 to 14, wherein the first structure is a structure

represented by any one of the following Formulas (1) to (7) :

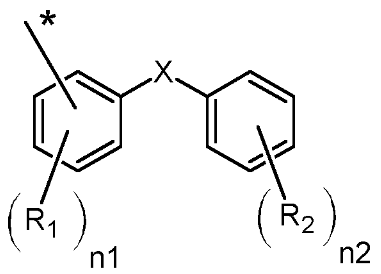

(1)

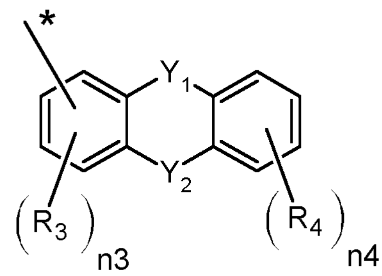

(2)

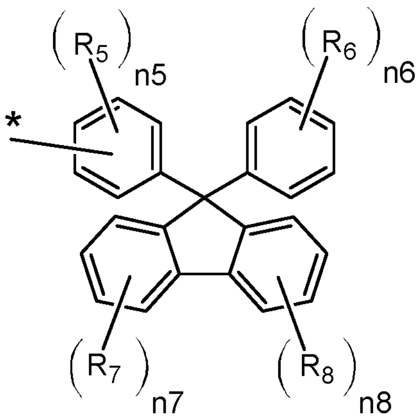

(3)

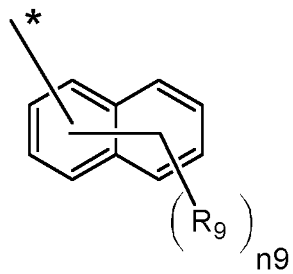

(4)

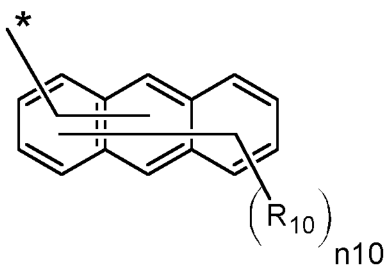

(5)

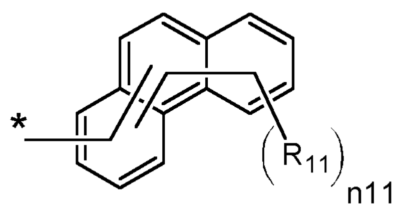

(6)

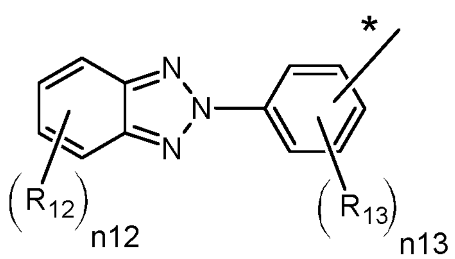

(7)

(in Formulas (1) to (7), $R_1$ to $R_{13}$ each independently represent a halogen atom or a monovalent group,
X represents a single bond, -O-, -CO-, $-NR_{31}-$ ($R_{31}$ represents a hydrogen atom, an alkyl group which may be substituted, or an aryl group which may be substituted), - SO-, $-SO_2-$, or -N=N-,

$Y_1$ represents a single bond or -CO-, when $Y_1$ is a single bond, $Y_2$ represents -O-, -CO-, or $-NR_{32}-$ ($R_{32}$ represents a hydrogen atom, an alkyl group which may be substituted, or an aryl group which may be substituted), and when $Y_1$ is -CO-, $Y_2$ represents -CO-,
n1 is an integer of 0 to 4,
n2 is an integer of 0 to 5,
n3 is an integer of 0 to 3,
n4 is an integer of 0 to 4,
n5 is an integer of 0 to 4,
n6 is an integer of 0 to 5,
n7 is an integer of 0 to 4,
n8 is an integer of 0 to 4,
n9 is an integer of 0 to 7,
n10 is an integer of 0 to 9,
n11 is an integer of 0 to 9,
n12 is an integer of 0 to 4,
n13 is an integer of 0 to 4,
* represents a bond, and
when there are a plurality of $R_1$s to $R_{13}$s, the plurality of $R_1$s to $R_{13}$s may be the same as or different from each other) .

**16.** The release agent composition according to any one of claims 12 to 15, wherein the first structure contains at least one hydroxy group.

**17.** The release agent composition according to any one of claims 12 to 16, wherein the second structure contains at least one selected from the group consisting of a siloxane unit (Q unit) represented by $SiO_2$, a siloxane unit (M unit) represented by $R_{101}R_{102}R_{103}SiO_{1/2}$, a siloxane unit (D unit) represented by $R_{104}R_{105}SiO_{2/2}$, and a siloxane unit (T unit) represented by $R_{106}SiO_{3/2}$ ($R_{101}$ to $R_{106}$ each independently represent a hydrogen atom or monovalent group bonded to Si, or a single bond or linking group that binds Si and the first structure).

**18.** The release agent composition according to claim 17, wherein the second structure is bonded to Si of any one of the M unit, the D unit, and the T unit via a single bond or a linking group.

**19.** The release agent composition according to claim 18, wherein the second structure is bonded to Si of any one of the M unit, the D unit, and the T unit via a linking group, and
the linking group is selected from the group consisting of an alkylene group having 1 to 10 carbon atoms, an ester bond, an ether bond, an amide bond, a urethane bond, a urea bond, and a combination of two or more thereof.

**20.** A method for manufacturing a processed semiconductor substrate, the method comprising:

a first step of processing the semiconductor substrate of the laminate according to any one of claims 1 to 11;
a second step of separating the semiconductor substrate processed in the first step and the support substrate; and
a third step of cleaning the separated semiconductor substrate with a cleaning agent composition.

**21.** The method for manufacturing a processed semiconductor substrate according to claim 20, wherein the second step includes a step of irradiating the release layer with light.

**22.** The method for manufacturing a processed semiconductor substrate according to claim 20 or 21, wherein the cleaning agent composition is a cleaning agent composition containing a quaternary ammonium salt and a solvent.

**23.** The method for manufacturing a processed semiconductor substrate according to claim 22, wherein the quaternary ammonium salt is a halogen-containing quaternary ammonium salt.

**24.** The method for manufacturing a processed semiconductor substrate according to claim 23, wherein the halogen-containing quaternary ammonium salt is a fluorinecontaining quaternary ammonium salt.

Fig. 1

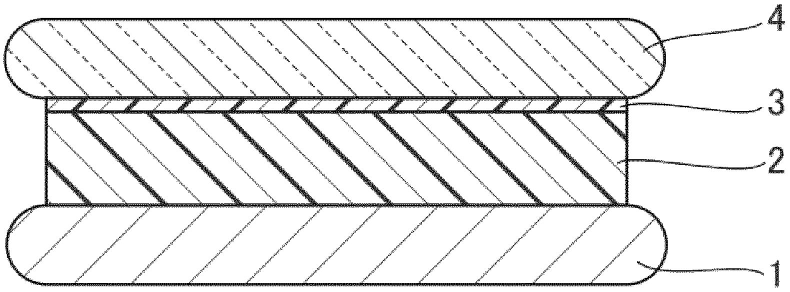

**INTERNATIONAL SEARCH REPORT**

International application No.
**PCT/JP2022/013867**

**A. CLASSIFICATION OF SUBJECT MATTER**

***C09K 3/00***(2006.01)i; ***H01L 21/02***(2006.01)i; ***H01L 21/304***(2006.01)i; ***C09J 7/35***(2018.01)i; ***B32B 7/06***(2019.01)i
FI: H01L21/304 622J; H01L21/304 622W; H01L21/02 B; B32B7/06; C09K3/00 R; C09J7/35

According to International Patent Classification (IPC) or to both national classification and IPC

**B. FIELDS SEARCHED**

Minimum documentation searched (classification system followed by classification symbols)

C09K3/00; H01L21/02; H01L21/304; C09J7/35; B32B7/06

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2014/092200 A1 (LINTEC CORPORATION) 19 June 2014 (2014-06-19)<br>paragraphs [0098]-[0099] | 1-24 |
| A | WO 2009/122984 A1 (HITACHI KASEI POLYMER CO., LTD.) 08 October 2009 (2009-10-08)<br>paragraphs [0042]-[0046], [0090] | 1-24 |
| A | WO 2014/157426 A1 (LINTEC CORPORATION) 02 October 2014 (2014-10-02)<br>paragraphs [0059], [0063] | 1-24 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 June 2022** | **21 June 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/013867**

**Box No. III Observations where unity of invention is lacking (Continuation of item 3 of first sheet)**

This International Searching Authority found multiple inventions in this international application, as follows:

Document 1: WO 2014/092200 A1 (LINTEC CORPORATION) 19 June 2014 (2014-06-19) paragraph [0098] & CN 104837942 A & KR 10-2015-0097483 A

The claims are classified into the following two inventions.

(Invention 1) Claims 1-13 and 20-24 and claims 15-19 referring to any of claims 12-13

Claims 1-13 and 20-24 and claims 15-19 referring to any of claims 12-13 have the special technical feature of a peeling agent composition used for a peeling layer of a laminate obtained by laminating a semiconductor substrate, an adhesive layer, the peeling layer, and a support substrate, the peeling agent composition containing a compound that has a first structure, which contributes to easy peeling of the semiconductor substrate and the support substrate by absorbing light and has at least two aromatic rings constituting a π-electron conjugated system, and a siloxane structure as a second structure, and are thus classified as invention 1.

(Invention 2) Claim 14 and claims 15-19 referring to claim 14

Claim 14 and claims 15-19 referring to claim 14 share, with claim 1 classified as invention 1, the common technical feature of a peeling agent composition containing a compound that has a first structure, which has at least two aromatic rings constituting a π-electron conjugated system, and a siloxane structure as a second structure.

However, said technical feature does not make a contribution over the prior art in light of the disclosure of document 1 and thus cannot be said to be a special technical feature. Moreover, there are no other same or corresponding special technical features between these inventions.

Further, claim 14 and claims 15-19 referring to claim 14 are not dependent on claim 1. Furthermore, claim 14 and claims 15-19 referring to claim 14 are not substantially identical to or similarly closely related to any of the claims classified as invention 1.

Accordingly, claim 14 and claims 15-19 referring to claim 14 cannot be classified as invention 1. In addition, claim 14 and claims 15-19 referring to claim 14 have the special technical feature in which the compound has a structure selected from the group consisting of a benzophenone structure, a diphenyl amine structure, a diphenyl sulfoxide structure, a diphenyl sulfone structure, an azobenzene structure, a dibenzofuran structure, a fluorenone structure, a carbazole structure, an anthraquinone structure, a 9,9-diphenyl-9H-fluorene structure, a naphthalene structure, an anthracene structure, a phenanthrene structure, an acridine structure, a pyrene structure, and a phenyl benzotriazole structure, and are thus classified as invention 2.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (January 2015)

**INTERNATIONAL SEARCH REPORT**
**Information on patent family members**

International application No.
**PCT/JP2022/013867**

| Patent document cited in search report | Publication date (day/month/year) | Patent family member(s) | Publication date (day/month/year) |
|---|---|---|---|
| WO 2014/092200 A1 | 19 June 2014 | CN 104837942 A<br>KR 10-2015-0097483 A | |
| WO 2009/122984 A1 | 08 October 2009 | EP 2280047 A1<br>paragraphs [0042]-[0046], [0090]<br>CN 101952380 A<br>KR 10-2010-0130604 A | |
| WO 2014/157426 A1 | 02 October 2014 | US 2016/0046840 A1<br>paragraphs [0115], [0119]<br>EP 2980835 A1<br>CN 105074878 A<br>KR 10-2015-0119899 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004064040 A
- JP 2012106486 A
- JP 2014150239 A
- WO 9710193 A
- WO 0031183 A
- WO 9811149 A
- WO 9109081 A
- EP 755957 A
- US 5115082 A
- US 5155175 A
- US 5179188 A
- US 5874516 A
- US 6093636 A
- US 6008298 A
- US 5191026 A
- US 4812588 A
- US 5136069 A
- US 5138081 A
- WO 9425903 A
- JP 6528747 B
- JP 5788173 B